# EUROPEAN PATENT SPECIFICATION

(11) **EP 3 042 944 B1**
(45) Date of publication and mention of the grant of the patent: **10.05.2017**
(21) Application number: 16150047.5
(22) Date of filing: 04.01.2016
(51) Int. Cl.: C09K 11/06, H01L 51/50, H01L 51/00

(54) **COMPOUND FOR ORGANIC ELECTROLUMINESCENT DEVICE**
VERBINDUNG FÜR ORGANISCHE ELEKTROLUMINESZENZVORRICHTUNG
COMPOSÉ POUR DISPOSITIF ÉLECTROLUMINESCENT ORGANIQUE

(30) Priority: 07.01.2015 US 201514591006
(43) Date of publication of application: 13.07.2016
(73) Proprietor: Luminescence Technology Corp., Hsin-Chu City 30076 (TW)
(72) Inventor: Yen, Feng-Wen, 114 Taipei City (TW); Chang, Cheng-Hao, 358 Miaoli County (TW)
(74) Representative: dompatent von Kreisler Selting Werner - Partnerschaft von Patent- und Rechtsanwälten mbB

(56) References cited:
- US-A1- 2014 166 988
- US-A1- 2014 175 383
- US-A1- 2014 231 754

## Description

### FIELD OF INVENTION

The present invention generally relates to a compound and organic electroluminescent(herein referred to as organic EL) device using the compound. More specifically, the present invention relates to the compound having general formula(I) or formula(II), an organic EL device employing the compound as phosphorescent emitting host, hole blocking layer(HBL) or hole blocking electron transport layer(HBETL).

### BACKGROUND OF THE INVENTION

Organic electroluminescent(organic EL) is a light-emitting diode (LED) in which the emissive layer is a film made by organic compounds which emits light in response to an electric current. The emissive layer of organic compound is sandwiched between two electrodes. Organic EL is applied in flat panel displays due to their high illumination, low weight, ultra-thin profile, self-illumination without back light, low power consumption, wide viewing angle, high contrast, simple fabrication methods and rapid response time.

The first observation of electroluminescence in organic materials were in the early 1950s by Andre Bernanose and co-workers at the Nancy-University in France. Martin Pope and his co-workers at New York University first observed direct current(DC) electroluminescence on a single pure crystal of anthracene doped with tetracene under vacuum in 1963.

The first diode device was reported by Ching W. Tang and Steven Van Slyke at Eastman Kodak in 1987. The device used a two-layer structure with separate hole transporting and electron transporting layers resulted in reduction in operating voltage and improvement of the efficiency, that led to the current era of organic EL research and device production.

Typically organic EL device is composed of layers of organic materials situated between two electrodes, which include a hole transporting layer(HTL), an emitting layer(EML), an electron transporting layer(ETL). The basic mechanism of organic EL involves the injection of the carrier, transport, recombination of carriers and exciton formed to emit light. When an external voltage is applied to an organic EL device, electrons and holes are injected from a cathode and an anode, respectively, electrons will be injected from a cathode into a LUMO(lowest unoccupied molecular orbital) and holes will be injected from an anode into a HOMO(highest occupied molecular orbital). When the electrons recombine with holes in the emitting layer, excitons are formed and then emit light. When luminescent molecules absorb energy to achieve an excited state, an exciton may either be in a singlet state or a triplet state depending on how the spins of the electron and hole have been combined. 75% of the excitons form by recombination of electrons and holes to achieve a triplet excited state. Decay from triplet states is spin forbidden, Thus, a fluorescence electroluminescent device has only 25% internal quantum efficiency. In contrast to fluorescence electroluminescent device, phosphorescent organic EL device make use of spin-orbit interactions to facilitate intersystem crossing between singlet and triplet states, thus obtaining emission from both singlet and triplet states and the internal quantum efficiency of electroluminescent devices from 25% to 100%.

Recently, a new type of fluorescent organic EL device incorporating mechanism of thermally activated delayed fluorescence(TADF) has been developed by Adachi and coworkers is a promising way to obtain a high efficiency of exciton formation by converting spin-forbidden triplet excitons up to the siglet level by the mechanism of reverse intersystem crossing (RISC).

The organic EL utilizes both triplet and singlet excitons. Cause of longer lifetime and the diffusion length of triplet excitons compared to those of singlet excitons, the phosphorescent organic EL generally need an additional hole blocking layer(HBL) between the emitting layer(EML) and the electron transporting layer(ETL) or the electron transporting layer with hole blocking ability instead of typical ETL. The purpose of the use of HBL or HBETL is to confine the recombination of injected holes and electrons and the relaxation of created excitons within the EML, hence the device's efficiency can be improved. To meet such roles, the hole blocking materials must have HOMO(highest occupied molecular orbital)and LUMO(lowest unoccupied molecular orbital) energy levels suitable to block hole transport from the EML to the ETL and to pass electrons from the ETL to the EML, in addition, the good thermal and electrochemical stability of the phosphorescent emitting host material are also needed.

There continues to be a need for organic EL materials which is able to efficiently transport electrons or holes and block holes, with good thermal stability and more efficient EML material for high emitting efficiency. According to the reasons described above, the present invention has the objective of resolving such problems of the prior-art and offering a light emitting device which is excellent in its thermal stability, high luminance efficiency, high luminance and long half-life time. The present invention disclose a material having general formula(I) or formula(II), used as phosphorescent emitting host, hole blocking layer(HBL) or hole blocking electron transport layer(HBETL) have good charge carrier mobility and excellent operational durability can lower driving voltage and power consumption, increasing efficiency and half-life time of organic EL device . US2014166988 recites Organic EL materials having a structure similar to those of the present invention.

### SUMMARY OF THE INVENTION

Provided a compound can use as phosphorescent emitting host, hole blocking layer or hole blocking electron transport layer for organic EL device. The compound can overcome the drawbacks of the conventional materials like as lower efficiency, half-lifetime and higher power consumption.

An object of the present invention is to provide the compound which can be used as phosphorescent emitting host, hole blocking layer or hole blocking electron transport layer for organic EL device.

The present invention has the economic advantages for industrial practice. Accordingly the present invention, the compound which can be used for organic EL device is disclosed. The mentioned the compound is represented by the following formula(I) or formula(II) 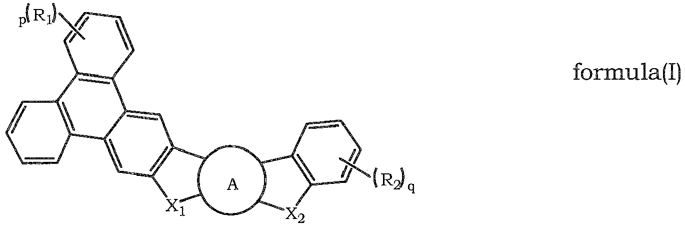 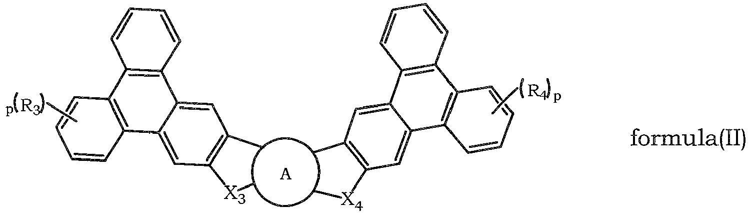 Wherein A represent a substituted or unsubstituted phenyl group, a substituted or unsubstituted naphthyl group. X₁ to X₄ independently represent a divalent bridge selected from the atom or group consisting from O, S, C(R₅)(R₆), N(Ar), Si(R₇)(R₈). p represent an integer of 0 to 10. q represent an integer of 0 to 4. R₁ to R₈, and Ar independently selected from the group consisting of a hydrogen atom, a substituted or unsubstituted alkyl group having 1 to 30 carbon atoms, a substituted or unsubstituted aryl group having 6 to 50 carbon atoms, a substituted or unsubstituted aralkyl group having 6 to 50 carbon atoms, a substituted or unsubstituted heteroaryl group having 3 to 50 carbon atoms.

### BRIEF DESCRIPTION OF THE DRAWINGS

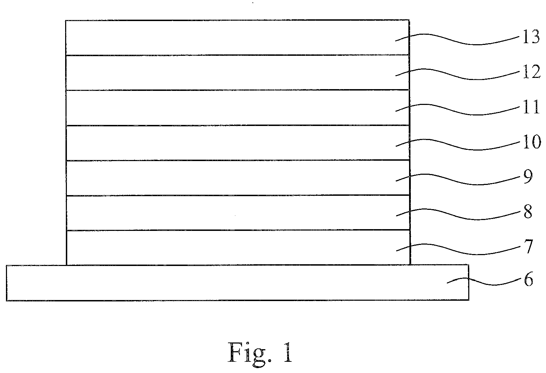

Fig.1 show one example of organic EL device in the present invention. 6 is transparent electrode, 13 is metal electrode, 7 is hole injection layer which is deposited onto 6, 8 is hole transport layer which is deposited onto 7, 9 is fluorescent or phosphorescent emitting layer which is deposited onto 8, 10 is hole blocking layer which is deposited onto 9, 11 is electron transport layer which is deposited onto 10, 12 is electron injection layer which is deposited on to 11.

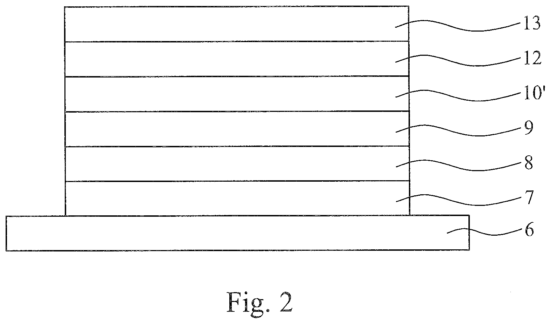

Fig.2 shows another example of organic EL device in the present invention. 6 is transparent electrode, 13 is metal electrode, 7 is hole injection layer which is deposited onto 6, 8 is hole transport layer which is deposited onto 7, 9 is fluorescent or phosphorescent emitting layer which is deposited onto 8, 10' is hole blocking electron transport layer which is deposited onto 9, 12 is electron injection layer which is deposited on to 10'.

### DESCRIPTION OF THE PREFERRED EMBODIMENTS

What probed into the invention is the compound and organic EL device using the compound. Detailed descriptions of the production, structure and elements will be provided in the following to make the invention thoroughly understood. Obviously, the application of the invention is not confined to specific details familiar to those who are skilled in the art. On the other hand, the common elements and procedures that are known to everyone are not described in details to avoid unnecessary limits of the invention. Some preferred embodiments of the present invention will now be described in greater detail in the following. However, it should be recognized that the present invention can be practiced in a wide range of other embodiments besides those explicitly described, that is, this invention can also be applied extensively to other embodiments, and the scope of the present invention is expressly not limited except as specified in the accompanying claims.

In a first embodiment of the present invention, the compound which can be used as phosphorescent emitting host, hole blocking layer or hole blocking electron transport layer for organic EL device are disclosed. The mentioned material are represented by the following formula(I) or formula(II) : 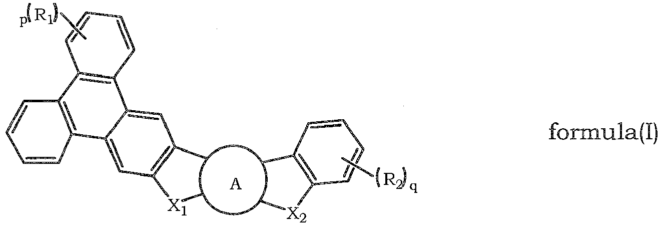 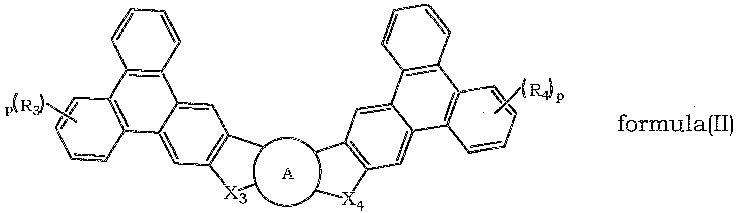 Wherein A represent a substituted or unsubstituted phenyl, a substituted or a unsubstituted naphthyl group. X₁ to X₄ independently represent a divalent bridge selected from the atom or group consisting from O, S, C(R₅)(R₆), N(Ar), Si(R₇)(R₈).p represent an integer of 0 to 10. q represent an integer of 0 to 4. R₁ to R₈, and Ar independently selected from the group consisting of a hydrogen atom, a substituted or unsubstituted alkyl group having 1 to 30 carbon atoms, a substituted or unsubstituted aryl group having 6 to 50 carbon atoms, a substituted or unsubstituted aralkyl group having 6 to 50 carbon atoms, a substituted or unsubstituted heteroaryl group having 3 to 50 carbon atoms.

The compound according to the above-mentioned formula(I) or formula(II), wherein the compound is represented the following formula(I-1) to formula(I-4) or formula(II-1) to formula(II-4) : 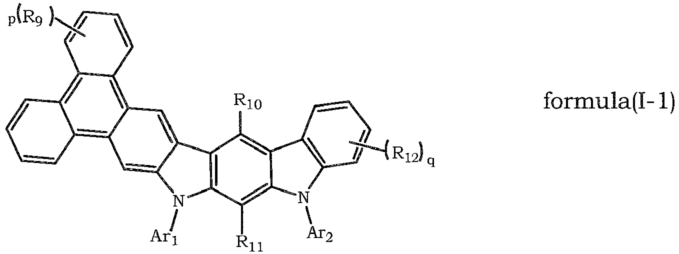 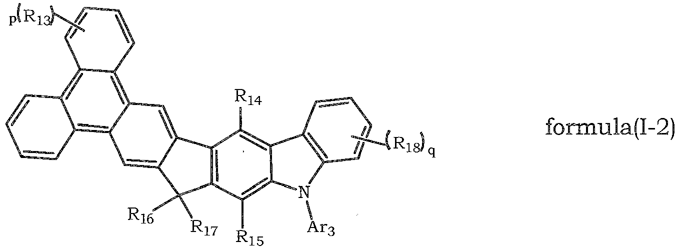 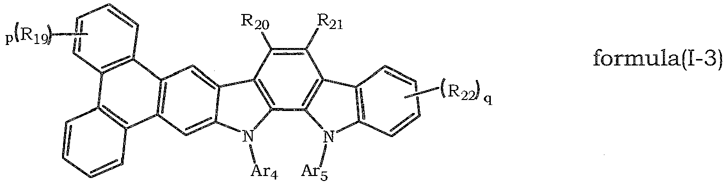 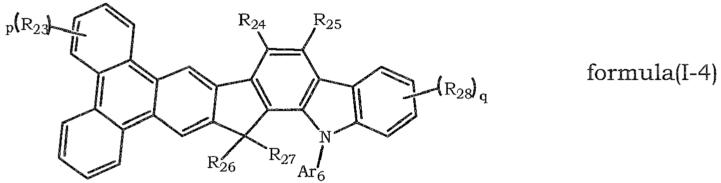 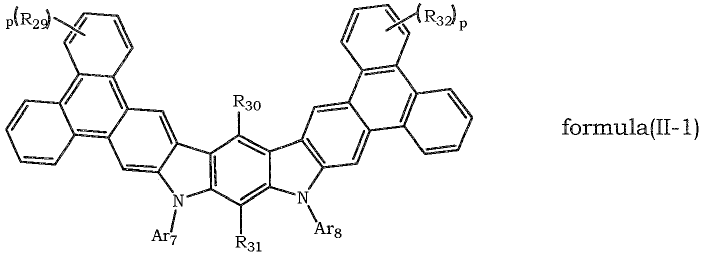 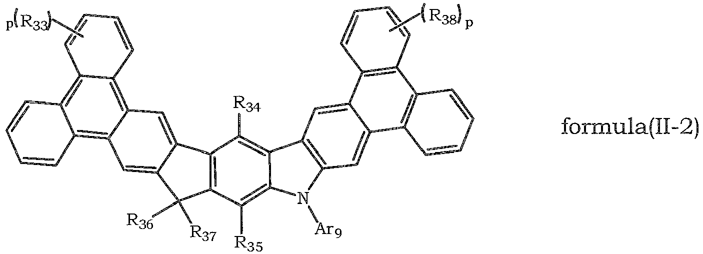 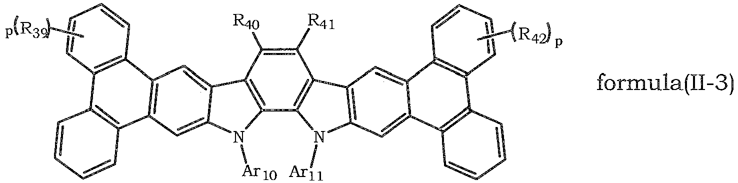 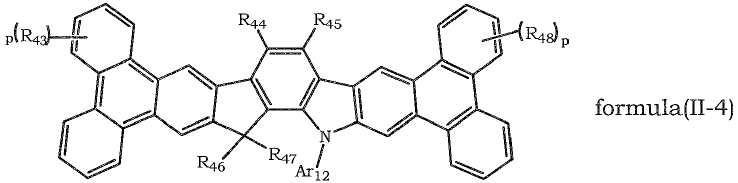 wherein R₉ to R₄₈ are the same definition as R₁, and p, q are same definition as described the above-mentioned formula(I) and formula(II), Ar₁ to Ar₁₂ is represented by the following formula(III) : 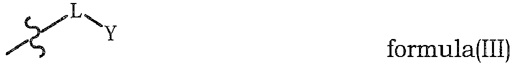 wherein L represent a single bond, a substituted or unsubstituted arylene group having 6 to 30 ring carbon atoms, or a substituted or unsubstituted heteroarylene group having 3 to 30 ring carbon atoms. Y represent a substituted or unsubstituted phenyl group, a substituted or unsubstituted naphthyl group, a substituted or unsubstituted biphenyl group, a substituted or unsubstituted carbazolyl group, a substituted or unsubstituted biscarbazolyl group, a substituted or unsubstituted dibenzofuranyl group, a substituted or unsubstituted dibenzothiophenyl group, a substituted or unsubstituted triazinyl group, a substituted or unsubstituted diazinyl group, a substituted or unsubstituted phenanthroline group, a substituted or unsubstituted dihydroacridine group, a substituted or unsubstituted phenothiazine group, a substituted or unsubstituted phenoxazine group, a substituted or unsubstituted dihydrophenazine group

According to the above-mentioned formula(III) for L are consisting of group represent as following :

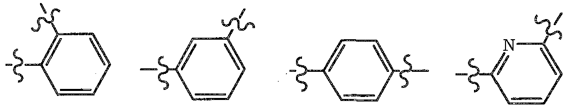

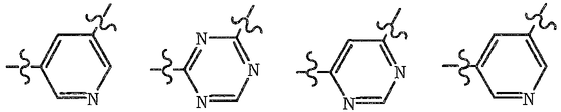

According to the above-mentioned formula(III) for Y are consisting of group represent as following :

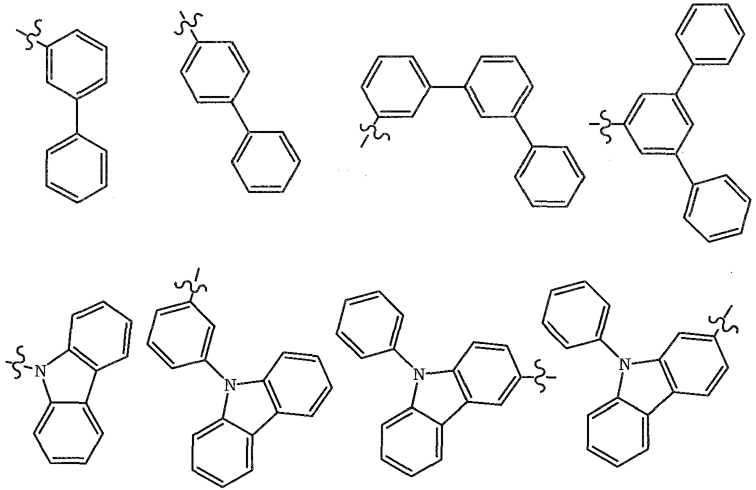

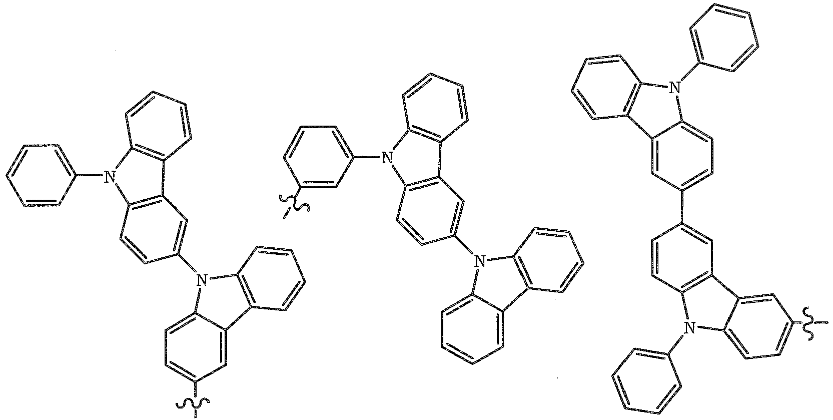

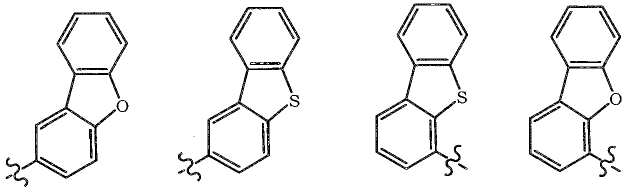

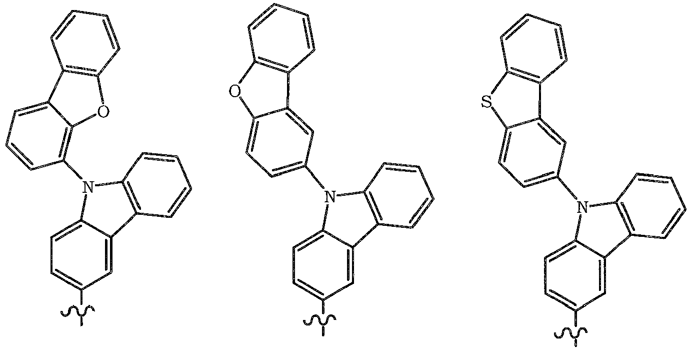

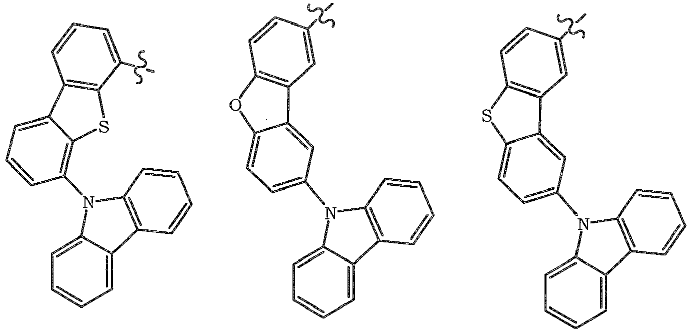

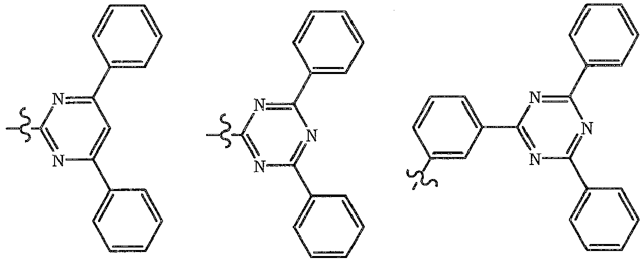

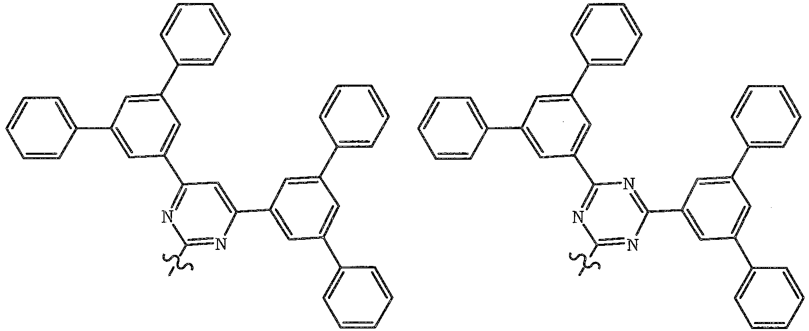

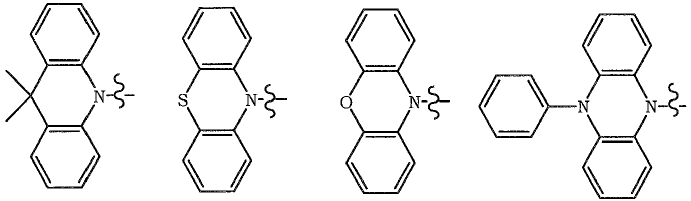

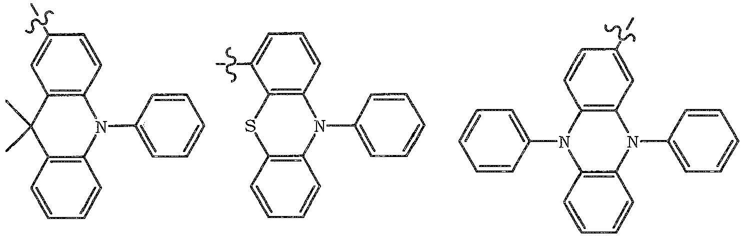

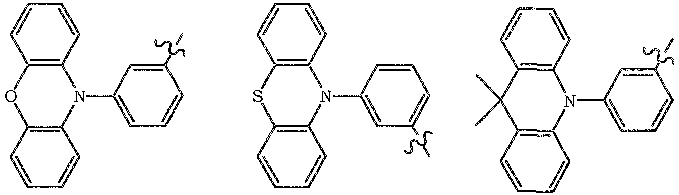

In this embodiment, some materials are shown below :

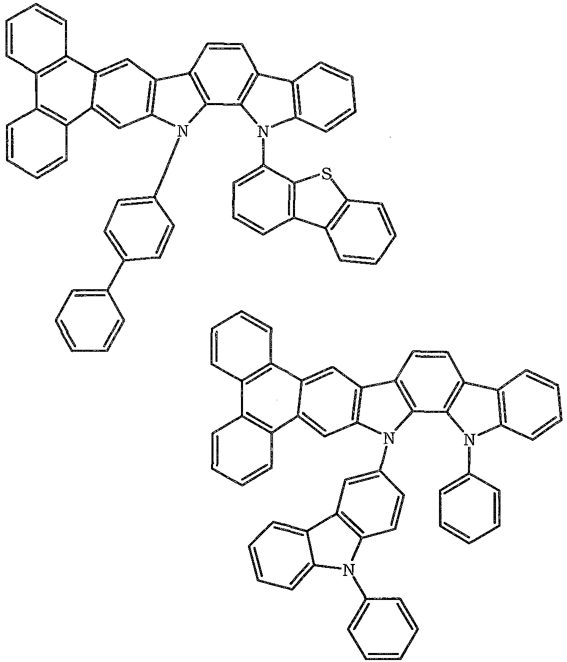

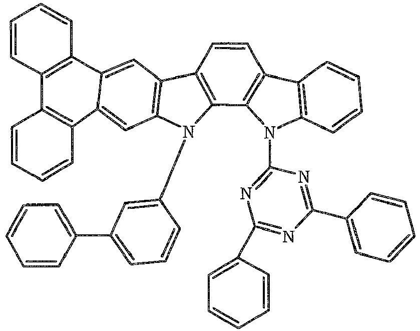

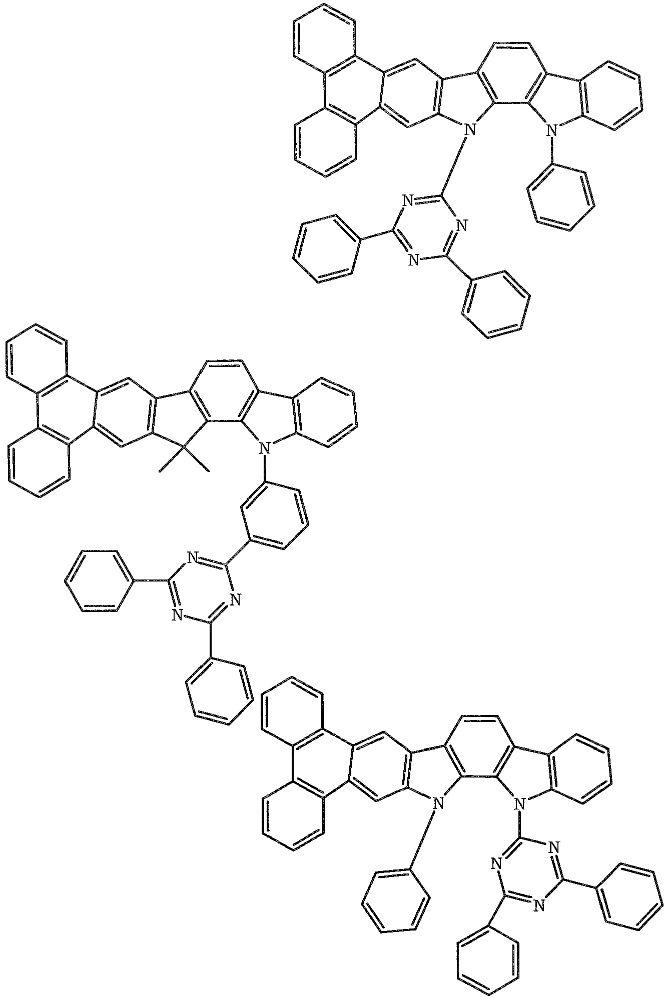

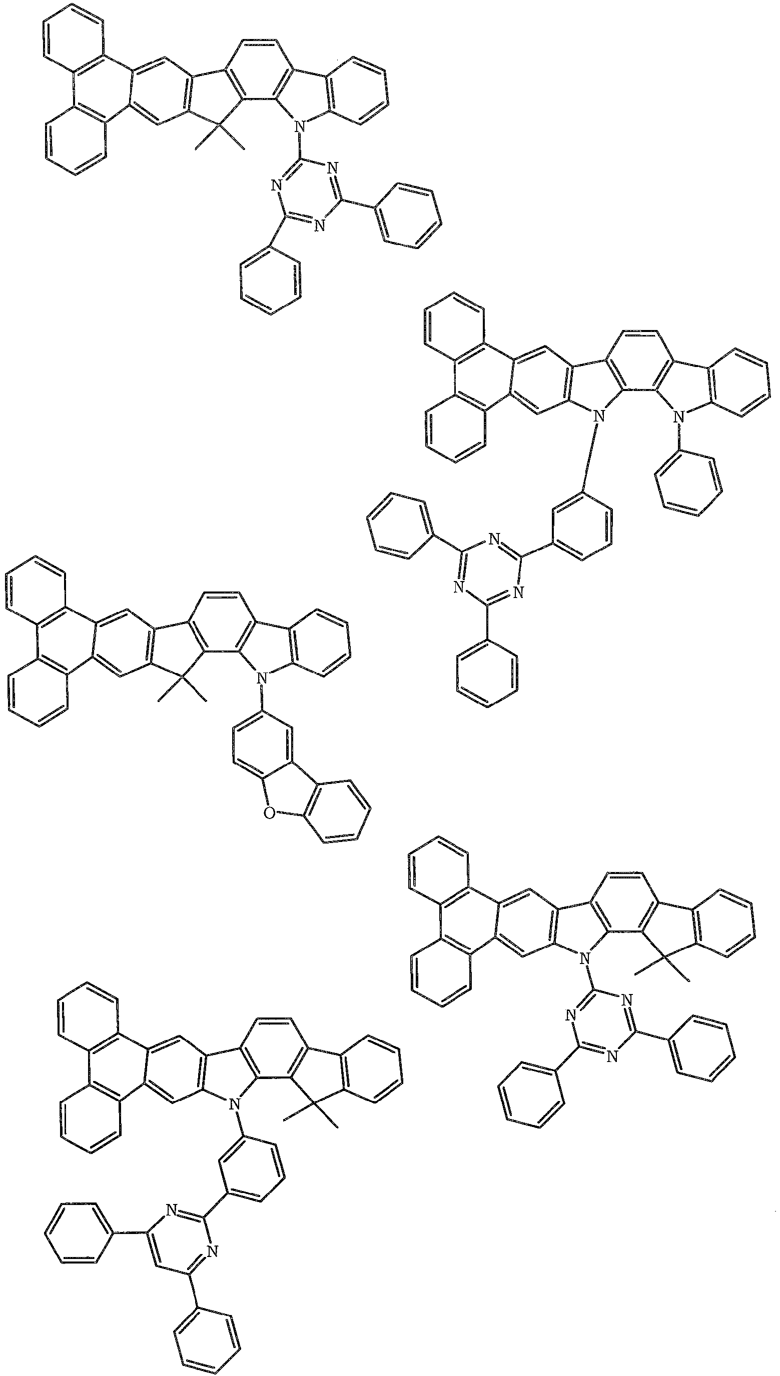

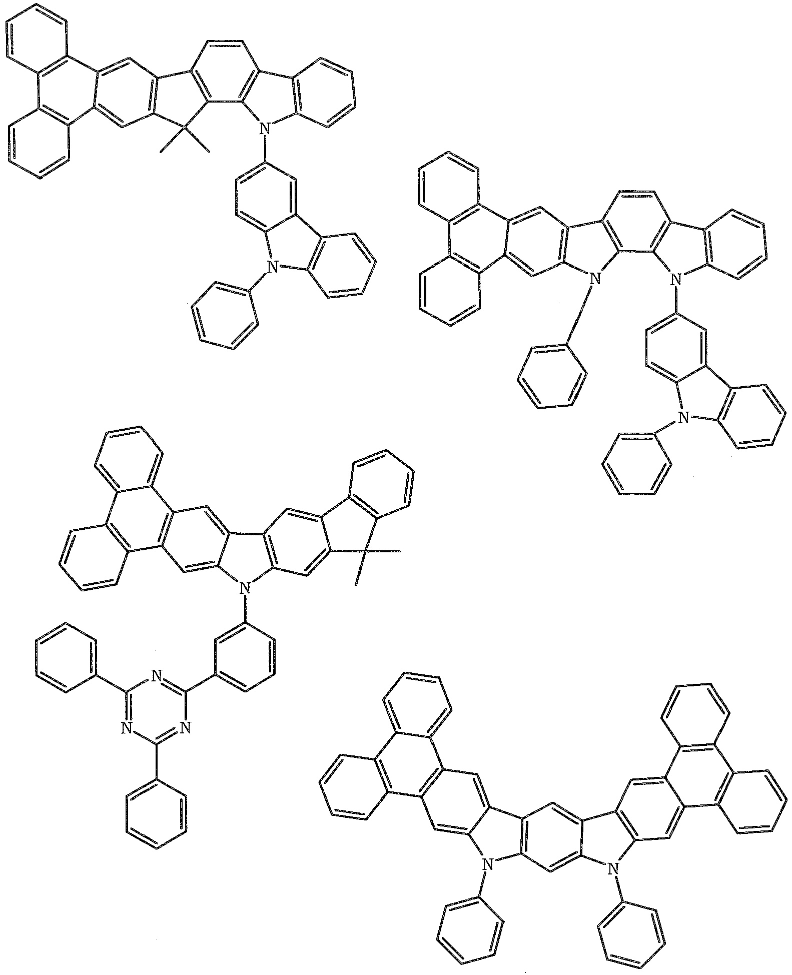

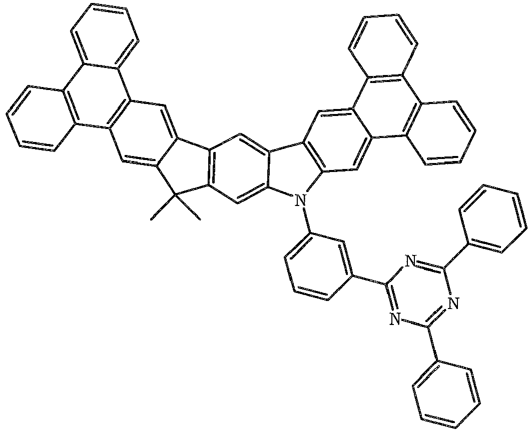

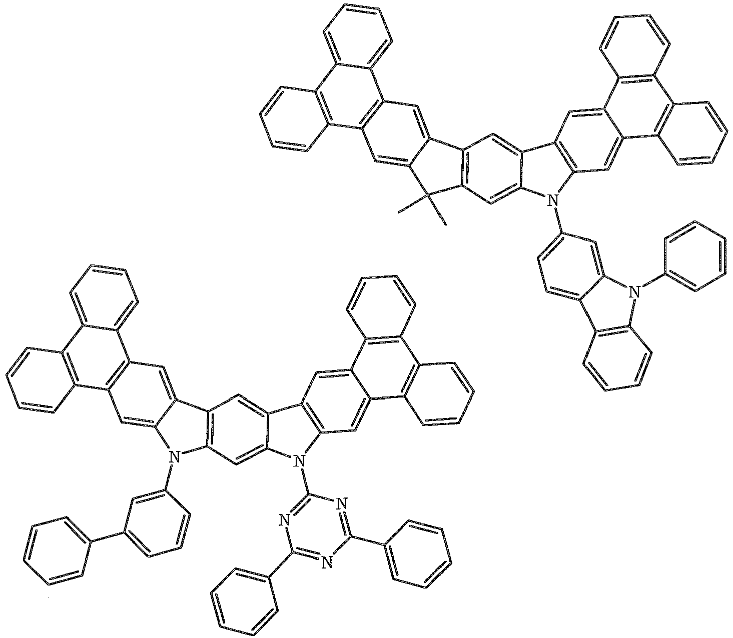

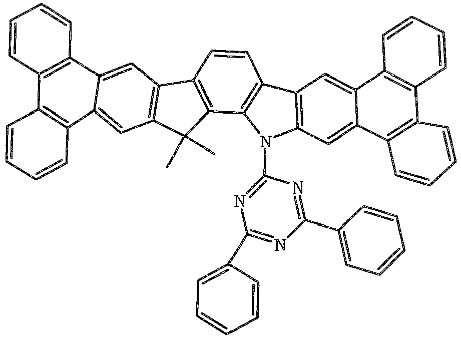

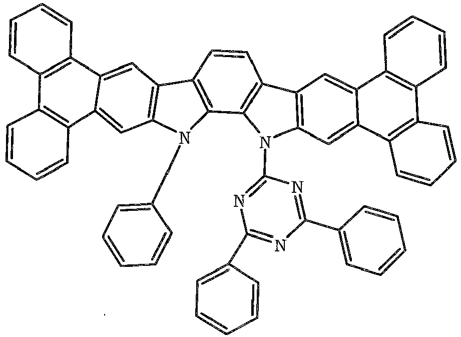

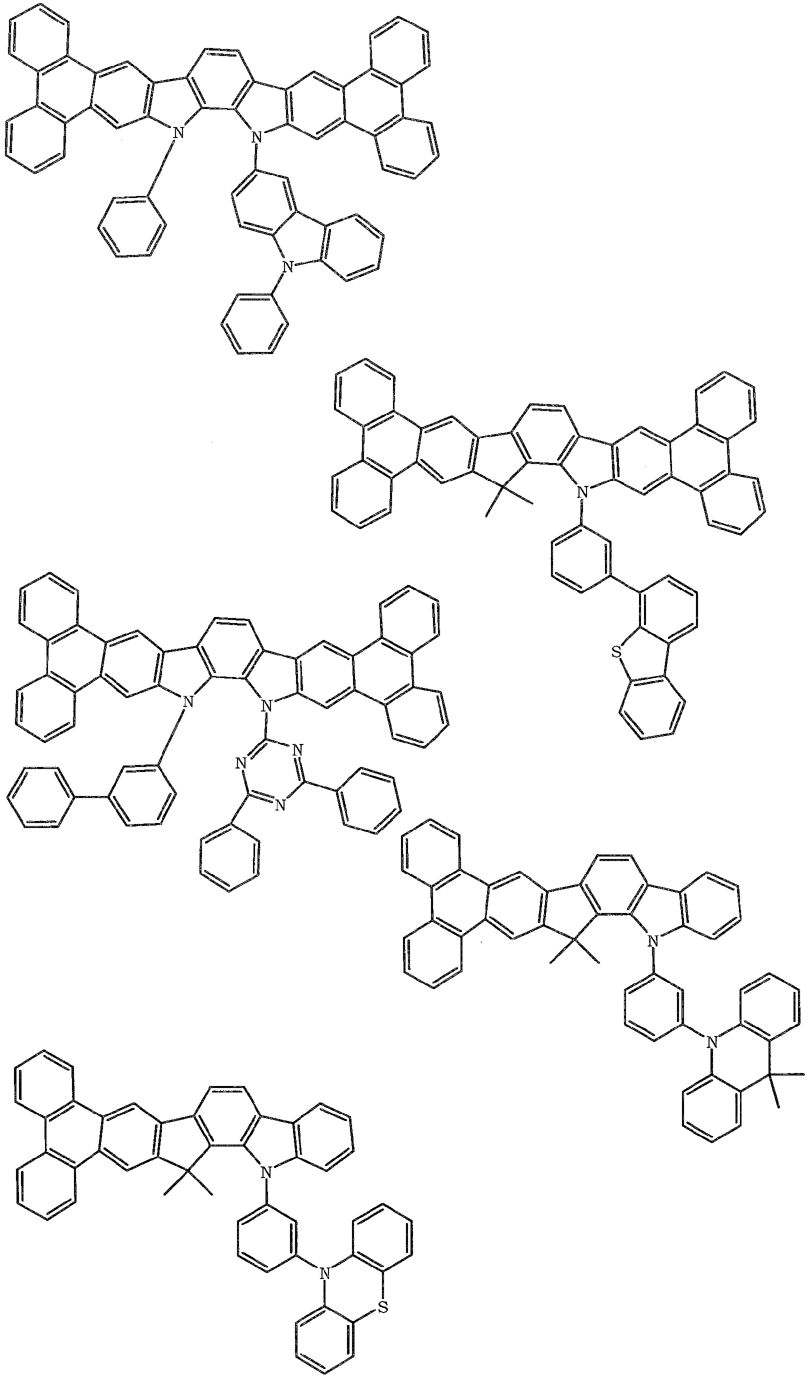

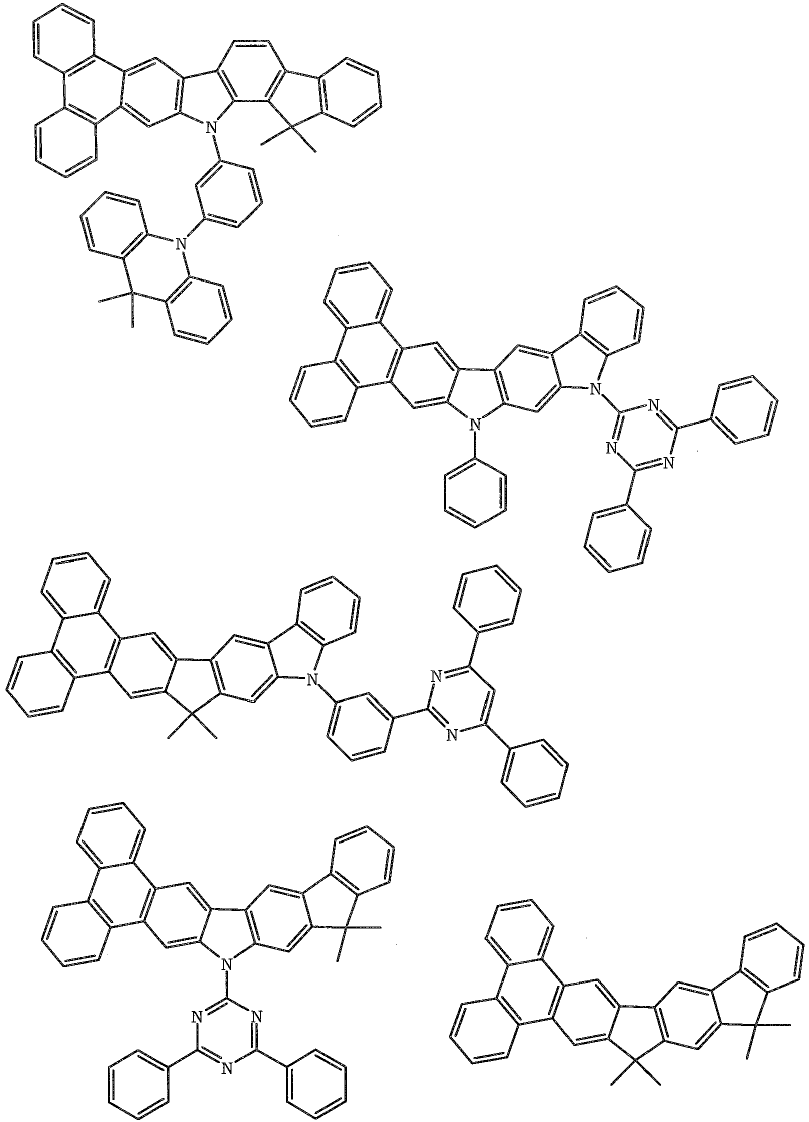

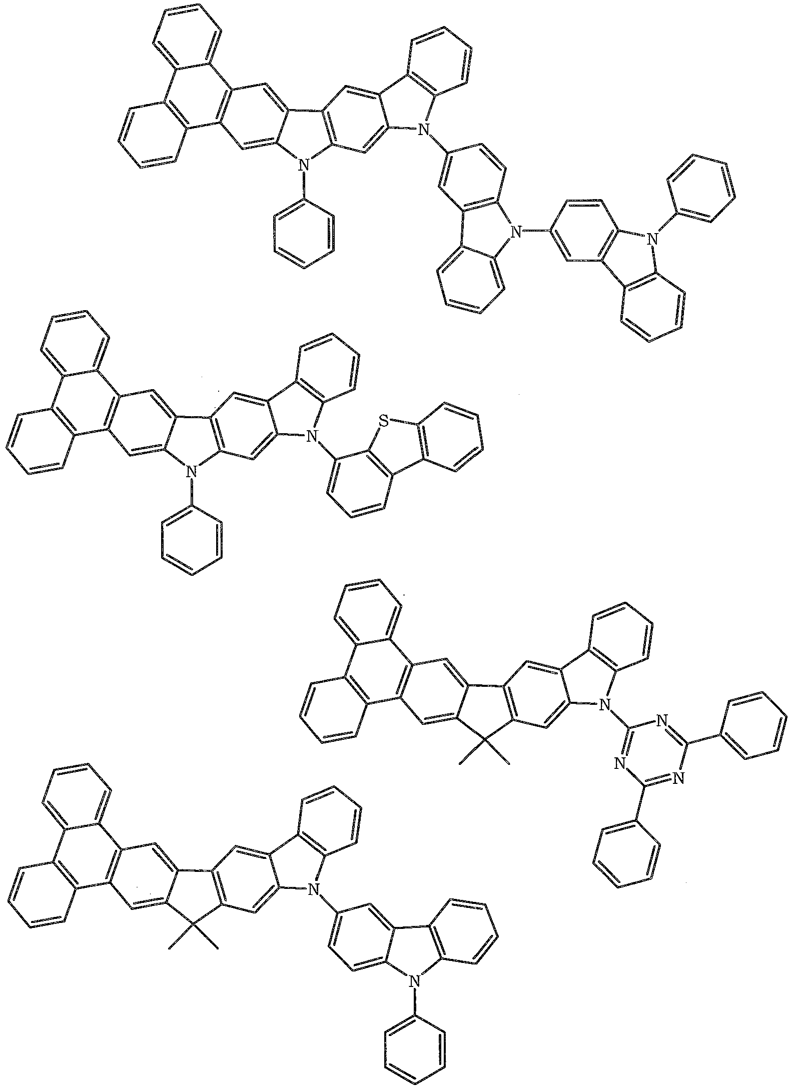

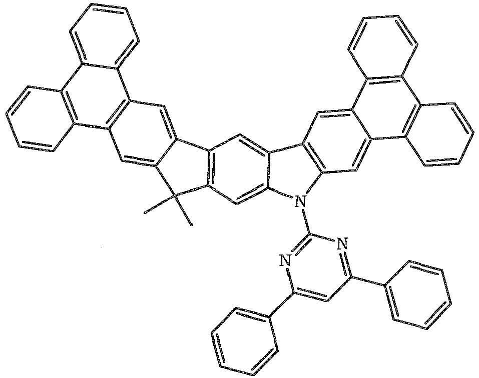

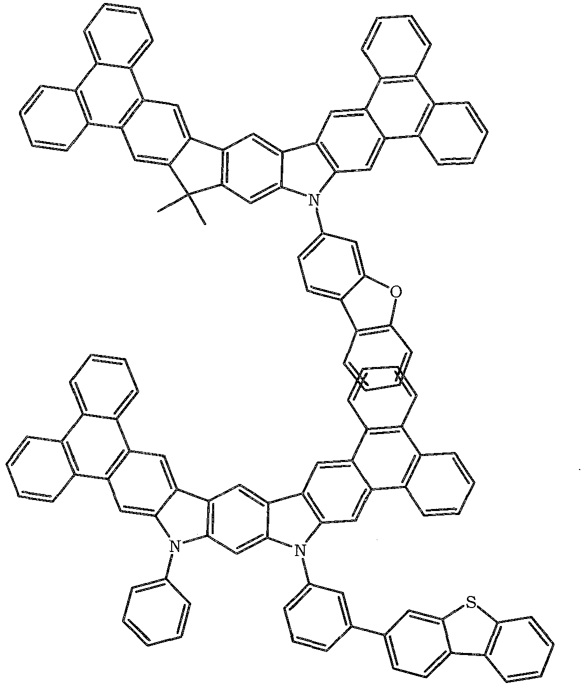

Detailed preparation for the compound in the present invention could be clarified by exemplary embodiments, but the present invention is not limited to exemplary embodiments. EXAMPLE 1∼5 show the preparation for some EXAMPLES of the compound in the present invention. EXAMPLE 6∼7 show the fabrication of organic EL device and I-V-B, half-life time of organic EL device testing report.

### EXAMPLE 1

### Synthesis of 2-(biphenyl-2-yl)-7-bromo-9,9-dimethyl-9H-fluorene

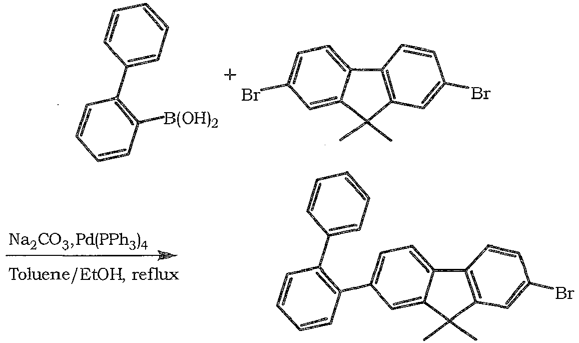

A mixture of 35.2g(100mmol) of 2,7-dibromo-9,9-dimethyl-9H-fluorene, 21.8g(110mmol) of biphenyl-2-ylboronic acid, 2.31g(2mmol) of Pd(PPh₃)₄, 75ml of 2M Na₂CO₃, 150ml of EtOH and 300ml toluene was degassed and placed under nitrogen, and then heated at 100°C for 12h. After finishing the reaction, the mixture was allowed to cool to room temperature. The organic layer was extracted with ethyl acetate and water, dried with anhydrous magnesium sulfate, the solvent was removed and the residue was purified by column chromatography on silica to give product (26.8g, 63.0 mmol, 63%) as a white solid.

### Synthesis of 12-bromo-10,10-dimethyl-10H-indeno[2,1-b] triphenylene

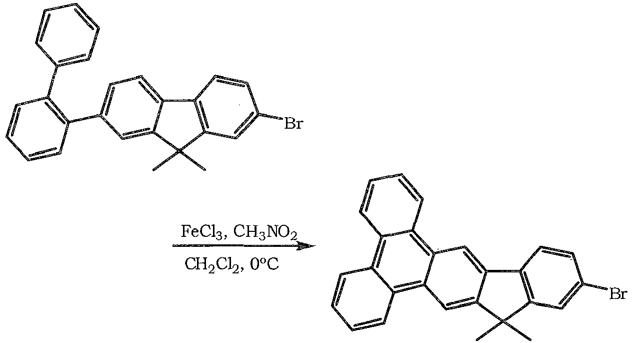

In a 3000ml three-necked flask that had been degassed and filled with nitrogen, 26.8g(60mmol) of 2-(biphenyl-2-yl)-7-bromo-9,9-dimethyl-9H-fluorene was dissolved in anhydrous dichloromethane(1500ml), 97.5g(600mmol)Iron(III)chloride was then added, and the mixture was stirred one hour. Methanol 500ml were added to the mixture and the organic layer was separated and the solvent removed in vacuo. The residue was purified by column chromatography on silica(hexane-dichloromethane) afforded a white solid (10.7g, 25.3mmol, 40%).¹H NMR(CDCl3, 400 MHz): chemical shift(ppm) 8.95(s, 1H), 8.79∼8.74(m, 2H), 8.69∼8.68(m, 3H), 7.84(d, J=8.0 Hz, 1H), 7.72∼7.65(m, 5H), 7.57(d, J=8.0 Hz, 1H), 1.66(s, 6H).

### Synthesis of 2-(10,10-dimethyl-10H-indeno[2,1-b] triphenylen -12-yl)-4,4,5,5-tetramethyl-1,3,2-dioxaborolane

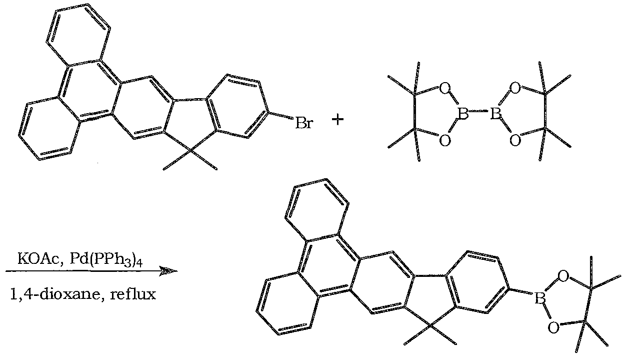

A mixture of 10.7g(25.3mmol) of 12-bromo-10,10-dimethyl-10H-indeno-[1,2-b]triphenylene, 7.7g(30.3mmol) of bis(pinacolato)diboron, 0.3g(0.26mmol) of Pd(PPh₃)₄, 7.4g(75.4mmol) of potassium acetate, and 300 ml 1,4-dioxane was degassed and placed under nitrogen, and then heated at 90°C for 16h. After finishing the reaction, the mixture was allowed to cool to room temperature. The organic phase separated and washed with ethyl acetate and water. After drying over magnesium sulfate, the solvent was removed in vacuo. The residue was purified by column chromatography on silica (hexane-dichloromethane) to give product (9.5g, 20.2mmol, 80%) as a light-yellow solid; ¹H NMR (CDCl3, 400 MHz): chemical shift(ppm) 9.03(s, 1H), 8.81(d, J=7.84 Hz, 1H), 8.77(d, J=7.88 Hz, 1H), 8.70∼8.67(m, 3H), 8.02∼7.93 (m, 3H), 7.71∼7.67(m, 4H), 1.69(s, 6H), 1.42(s, 12H)

### Synthesis of 10,10-dimethyl-12-(2-nitrophenyl)-10H-indeno [2,1-b]triphenylene

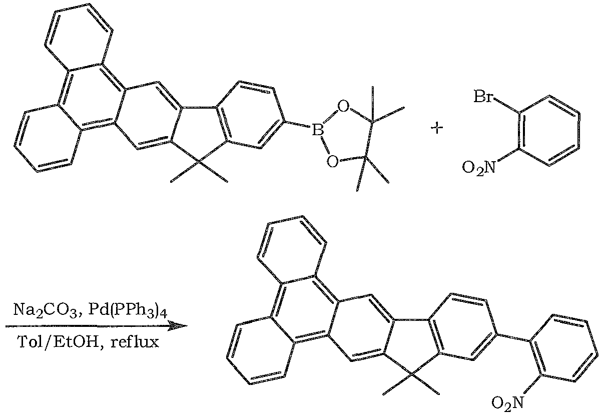

A mixture of 9.5g(20.2mmol) of 2-(10,10-dimethyl-10H-indeno [2,1-b]triphenylen-12-yl)-4,4,5,5-tetramethyl-1,3,2-dioxaborolane, 4.3g (21mmol) of 1-bromo-2-nitrobenzene, 0.44g(0.4mmol) of tetrakis(triphenyl phosphine)palladium, 30ml of 2M Na₂CO₃, 40ml of EtOH and 80ml toluene was degassed and placed under nitrogen, and then heated at 90°C overnight. After finishing the reaction, the mixture was allowed to cool to room temperature. The solution was extracted with 250ml of ethyl acetate and 1000ml of water. The organic layer was dried with anhydrous magnesium sulfate and the solvent was evaporated under reduced pressure. The residue was purified by column chromatography on silica(Hx-EA) to give product 5.5g(58%).

### Synthesis of intermediate I

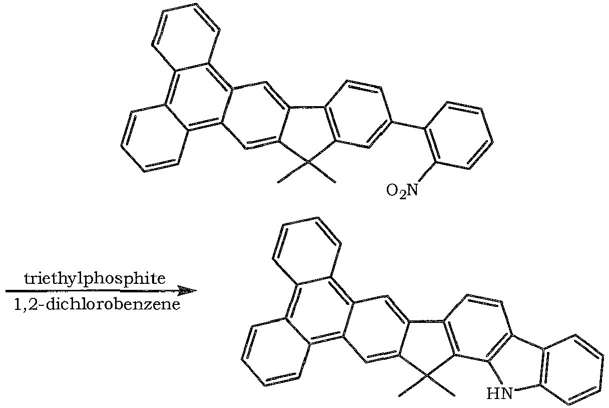

A mixture of 5.5g(11.8mmol) of 10,10-dimethyl-12-(2-nitro phenyl)-10H-indeno[2,1-b]triphenylene, 30ml of triethylphosphite, 15ml of 1,2-dichlorobenzene, was placed under nitrogen, and then heated at 160°C overnight. After finishing the reaction, the mixture was allowed to cool to room temperature. Than 200ml of MeOH was added, while stirring and the precipitated product was filtered off with suction. To give 1.9g(yield37%) of yellow product which was purified by column chromatography on silica (Hx-CH₂Cl₂).

### Synthesis of example 1

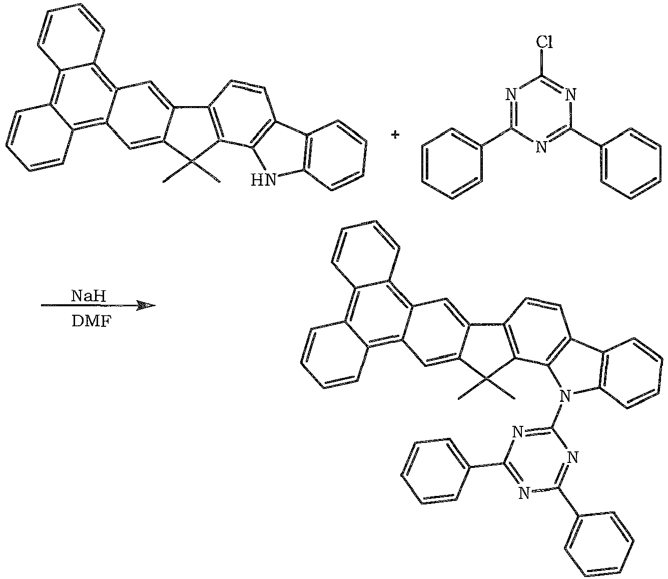

Under N₂ condition, 1.9g(4.4mmol) of intermediate I and 50ml of DMF were mixed, and 0.85g(35.2mmol) of NaH was slowly added to the mixture. The mixture was stirred at room temperature for 30 minutes. Than 3.5g(13.2mmol) of 2-chloro-4,6-diphenyl-1,3,5-triazine was slowly added to the mixture. The mixture was stirred at room temperature for 24 hours. After completion of the reaction, 200ml of iced water was added, while stirring and the precipitated product was filtered off with suction. To give 1.4g(yield48%) of yellow product which was recrystallized from ethyl acetate. MS(m/z ,FAB⁺)
:664.5; ¹H NMR(CDCl₃, 400 MHz): chemical shift(ppm) 9.02(s, 1H), 8.83∼ 8.75(m, 5H), 8.54∼8.48(m, 4H), 8.42∼8.23(m, 2H), 8.07∼7.98(m, 6H), 7.87∼7.81(m, 2H), 7.76∼7.51(m, 5H), 7.38∼7.28(d, J = 8.0 Hz, 1H), 1.83(s, 6H).

### EXAMPLE 2

### Synthesis of intermediate II

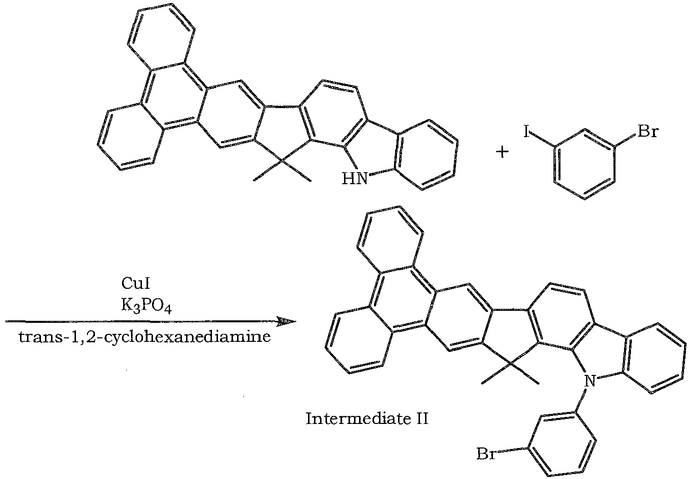

A mixture of 15.7g(36.2mmole) intermediate I, 10.2g(36.2mmole) of 1-bromo-3-iodobenzene, 17.1g(90mmole)of copper(I) iodide, 19.1g (90mmole) of potassium phosphate, 10.3g(90mmole) of trans-1,2-cyclohexane diamine and 1,4-dioxane 700ml were refluxed under nitrogen for about overnight. Then, the solution was filtered at 110°C. To receive the filtrate, And the 1,4-dioxane was removed under reduced pressure from the filtrate. The filtrate was extracted with 500ml dichloromethane and 2000 ml water, the organic layer was dried with anhydrous magnesium sulfate, the solvent was removed and the residue was purified by column chromatography on silica (hexane-ethyl acetate) to give product 12.1g(57%).

### Synthesis of intermediate III

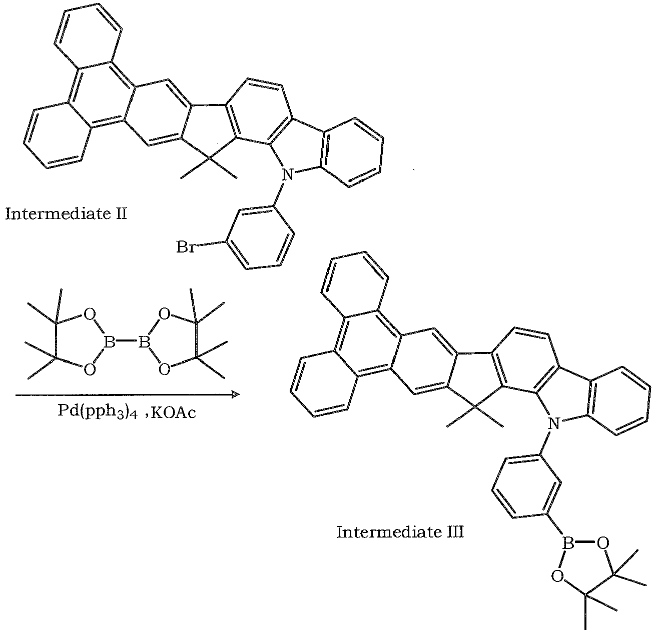

A mixture of 12.1g(20.6mmol) of intermediate II, 7.8g(31mmol) of bis(pinacolato)diboron, 0.48(0.4mmol) of tetrakis(triphenylphosphine) palladium, 4.1g(41.2mmol) of potassium acetate, and 200ml of 1,4-dioxane was degassed and placed under nitrogen, and then heated at 90 or for 24h. After finishing the reaction, the mixture was allowed to cool to room temperature. The organic layer was extracted with ethyl acetate and water, dried with anhydrous magnesium sulfate, the solvent was removed and the product was purified by column using a mixture of hexanes and ethyl acetate as eluent to get 8.2g of light yellow product (yield63%).

### Synthesis of example 2

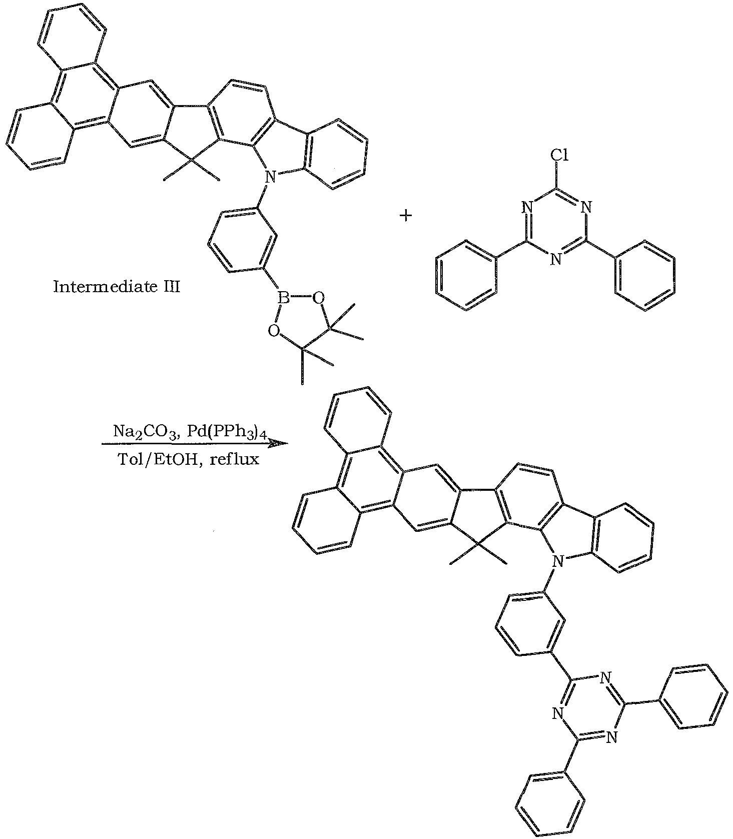

A mixture of 6.4g(10.1mmol) of intermediate III, 5.4g(20mmol) of 2-chloro-4,6-diphenyl-1,3,5-triazine, 0.22g(0.2mmol) of tetrakis (triphenyl phosphine)palladium, 15ml of 2M Na₂CO₃, 20ml of EtOH and 40ml toluene was degassed and placed under nitrogen, and then heated at 90°C overnight. After finishing the reaction, the mixture was allowed to cool to room temperature. Than 100ml of MeOH was added, while stirring and the precipitated product was filtered off with suction. To give 4g (yield53%) of yellow product which was recrystallized from toluene. MS(m/z ,FAB⁺):740.4 NMR(CDCl₃, 400 MHz): chemical shift(ppm) 9.02(s, 1H), 8.81∼8.72(m, 6H), 8.52∼8.43(m, 8H), 8.42∼8.23(m, 2H), 8.07∼7.98(m, 6H), 7.87∼7.83(m, 2H), 7.66∼7.51(m, 5H), 1.79(s, 6H).

### EXAMPLE 3

### Synthesis of 3-(biphenyl-2-yl)-6-bromo-9-phenyl-9H-carbazole

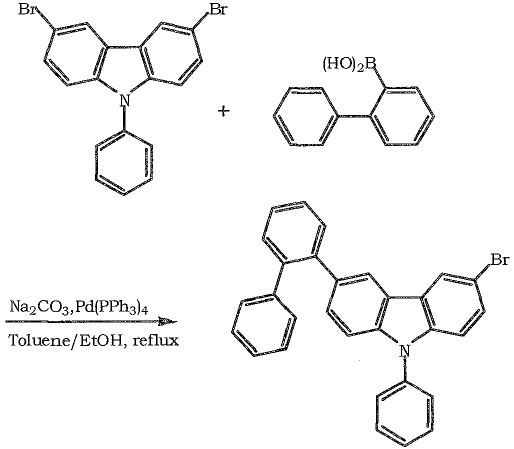

A mixture of 40.1g(100mmol) of 3,6-dibromo-9-phenyl-9H- carbazole, 21.8g(110mmol) of biphenyl-2-ylboronic acid, 2.31g(2mmol) of Pd(PPh₃)₄, 75ml of 2M Na₂CO₃, 150ml of EtOH and 300ml toluene was degassed and placed under nitrogen, and then heated at 100°C for 12h. After finishing the reaction, the mixture was allowed to cool to room temperature. The organic layer was extracted with ethyl acetate and water, dried with anhydrous magnesium sulfate, the solvent was removed and the residue was purified by column chromatography on silica to give product (19.9g, 42.0mmol, 42%) as a white solid.

### Synthesis of 13-bromo-10-phenyl-10H-phenanthro[9,10-b] carbazole

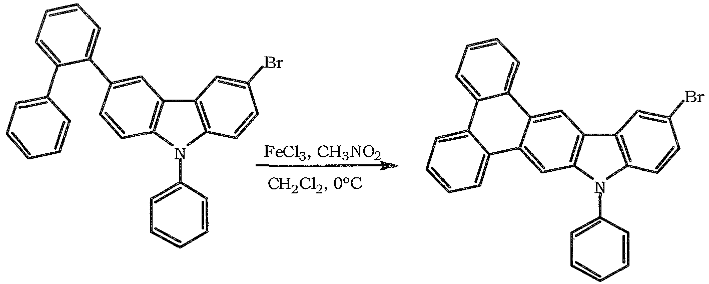

In a 3000ml three-necked flask that had been degassed and filled with nitrogen, 19.9g(42mmol) of 3-(biphenyl-2-yl)-6-bromo-9-phenyl- 9H-carbazole was dissolved in anhydrous dichloromethane(1000ml), 68.2g(420mmol) Iron(III) chloride was then added, and the mixture was stirred 10 minutes. Methanol 300ml were added to the mixture and the organic layer was separated and the solvent removed in vacuo. The residue was purified by column chromatography on silica(hexane-dichloromethane) afforded a white solid (14.5g, 30.7mmol, 73%).

### Synthesis of 10-phenyl-13-(4,4,5,5-tetramethyl-1,3,2-dioxaborolan-2-yl)- 10H-phenanthro[9,10-b]carbazole

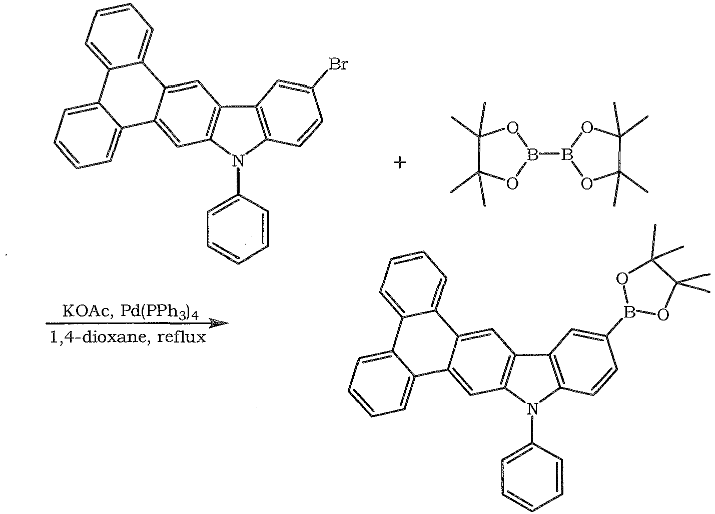

A mixture of 14.5g(30.7mmol) of 13-bromo-10-phenyl-10H-phenanthro[9,10-b]carbazole, 11.8g(46mmol) of bis(pinacolato)diboron, 0.46g (0.4mmol) of Pd(PPh₃)₄, 11.3g(115.4mmol) of potassium acetate, and 300ml 1,4-dioxane was degassed and placed under nitrogen, and then heated at 120°C for 16h. After finishing the reaction, the mixture was allowed to cool to room temperature. The organic phase separated and washed with ethyl acetate and water. After drying over magnesium sulfate, the solvent was removed in vacuo. The residue was purified by column chromatography on silica (hexane-ethyl acetate) to give product (11.5g, 22.1mmol, 72%) as a light-yellow solid.

### Synthesis of 13-(2-nitrophenyl)-10-phenyl-10H-phenanthro [9,10-b]carbazole

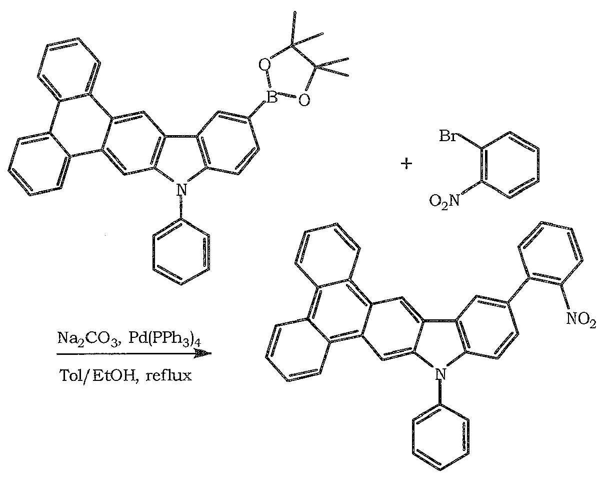

A mixture of 11.5g(22.1mmol) of 10-phenyl-13-(4,4,5,5-tetra methyl-1,3,2-dioxaborolan-2-yl)-10H-phenanthro[9,10-b]carbazole, 5.4g (26.5mmol) of 1-bromo-2-nitrobenzene, 0.44g(0.4mmol) of tetrakis (triphenylphosphine)palladium, 30ml of 2M Na₂CO₃, 40ml of EtOH and 80ml toluene was degassed and placed under nitrogen, and then heated at 90°C overnight. After finishing the reaction, the mixture was allowed to cool to room temperature. The solution was extracted with 250ml of ethyl acetate and 500ml of water. The organic layer was dried with anhydrous magnesium sulfate and the solvent was evaporated under reduced pressure. The residue was purified by column chromatography on silica(Hx-EA) to give product 7.8g(69%).

### Synthesis of intermediate A

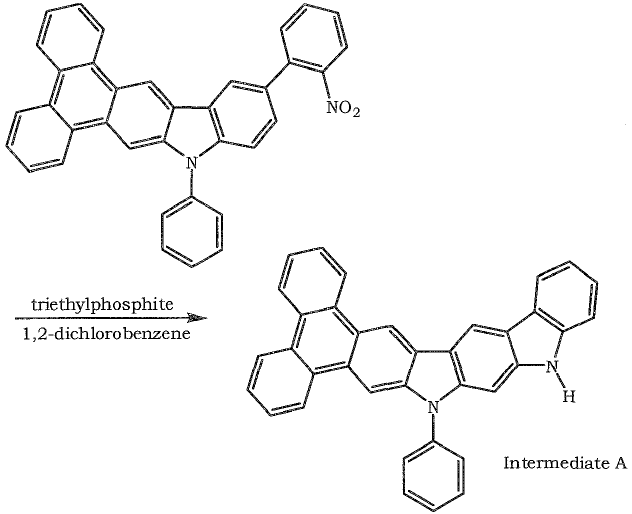

A mixture of 7.8g(15.2mmol) of 12-(2-nitrophenyl)-10-phenyl -10H-phenanthro[9,10-b]carbazole, 50ml of triethylphosphite, 20ml of 1,2-dichlorobenzene, was placed under nitrogen, and then heated at 160°C overnight. After finishing the reaction, the mixture was allowed to cool to room temperature. Than 200ml of MeOH was added, while stirring and the precipitated product was filtered off with suction. To give 4.3g (yield59%) of yellow product which was purified by column chromatography on silica(Hx-CH₂Cl₂).

### Synthesis of example 3

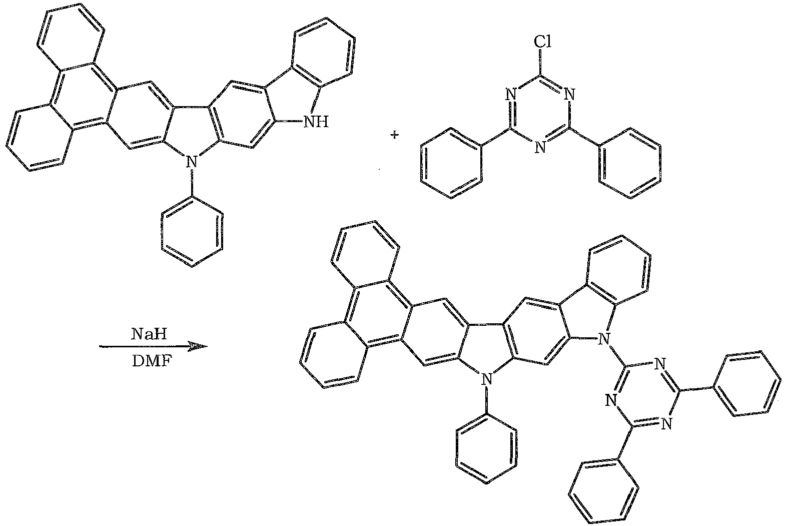

Under N₂ condition, 4.3g(8.9mmol) of intermediate A and 50ml of DMF were mixed, and 0.86g(35.6mmol) of NaH was slowly added to the mixture. The mixture was stirred at room temperature for 30 minutes. Than 3.5g(13.2mmol) of 2-chloro-4,6-diphenyl-1,3,5-triazine was slowly added to the mixture. The mixture was stirred at room temperature for 24 hours. After completion of the reaction, 200ml of iced water was added, while stirring and the precipitated product was filtered off with suction. To give 2.7g(yield43%) of yellow product which was recrystallized from ethyl acetate. MS(m/z ,FAB⁺):713.6; ¹H NMR(CDCl₃, 400 MHz): chemical shift(ppm) 9.12(s, 1H), 8.89∼8.83(m, 2H), 8.76(d, J = 8.00Hz, 2H), 8.61∼8.56 (m, 4H), 8.45(d, J = 9.20Hz, 2H), 8.03 ∼7.92(m, 6H), 7.89∼7.83(m, 2H), 7.78∼7.64(m, 6H), 7.50∼7.44(m, 4H), 7.36∼7.29(m, 2H)

### EXAMPLE 4

### Synthesis of 3,8-dibromo-11,12-dihydroindolo[2,3-a]carbazole

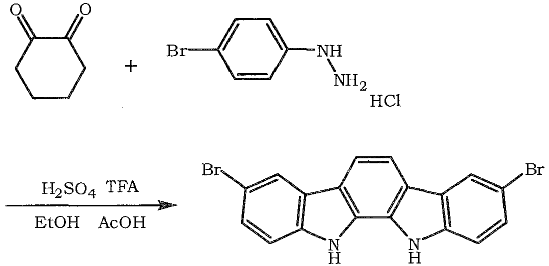

In a 1000ml three-necked flask that had been degassed and filled with nitrogen, 44.7g(200mmole) 4-Bromophenylhydrazine hydrochloride, 11.2g(100mmole) of cyclohexane-1,2-dione, were dissolved in 500ml EtOH, 5ml of H₂SO₄ was added dropwise to the solution at room temperature, and then heated at 80 °C for 4h. After finishing the reaction, the mixture was allowed to cool to room temperature. The resulting solid was filtered off, washed with ethanol to give 38g of red powder. The 38g of red powder was dissolved in 380ml of glacial acetic acid, 38g of trifluoroacetic acid was then added, , and then heated at 100°C for 24h. After finishing the reaction, the mixture was allowed to cool to room temperature. The resulting solid was filtered off, washed with hexane and ethanol to give product 15.3g(37%).

### Synthesis of 3,8-di(biphenyl-2-yl)-11,12-dihydroindolo[2,3-a] carbazole

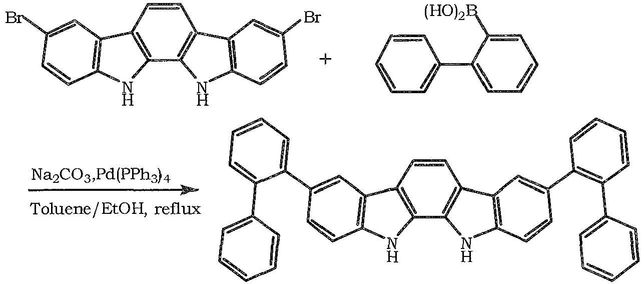

A mixture of 15.3g(37mmol) of 3,8-dibromo-11,12-dihydroindolo [2,3-a]carbazole, 18.3g(92.4mmol) of biphenyl-2-ylboronic acid, 0.86g (0.8mmol) of Pd(PPh₃)₄, 55ml of 2M Na₂CO₃, 100ml of EtOH and 200ml toluene was degassed and placed under nitrogen, and then heated at 100°C for 24h. After finishing the reaction, the mixture was allowed to cool to room temperature. The organic layer was extracted with ethyl acetate and water, dried with anhydrous magnesium sulfate, the solvent was removed and the residue was purified by column chromatography on silica to give product (12.2g, 21.8mmol, 59%).

### Synthesis of intermediate B

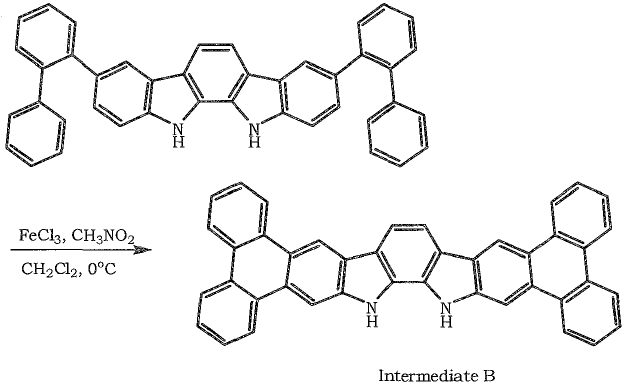

In a 2000ml three-necked flask that had been degassed and filled with nitrogen, 12.2g(21.8mmol) of 3,8-di(biphenyl-2-yl)-11, 12-dihydroindolo[2,3-a]carbazole was dissolved in anhydrous dichloromethane (500ml), 34.1g(210mmol) Iron(III) chloride was then added, and the mixture was stirred 10 minutes. Methanol 100ml were added to the mixture and the organic layer was separated and the solvent removed in vacuo. The residue was purified by column chromatography on silica (hexane-dichloromethane) afforded a yellow solid (4.3g, 36%).

### Synthesis of intermediate C

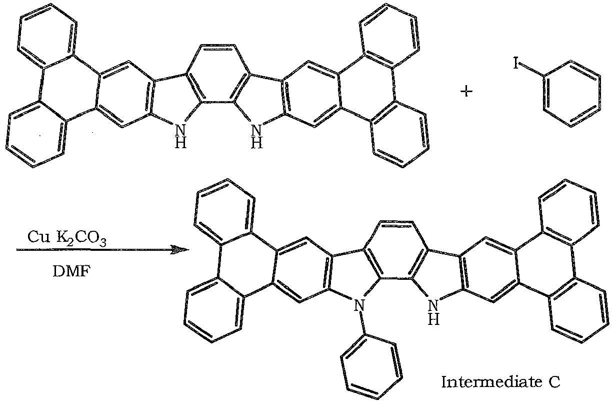

Under nitrogen, 4.3g(7.7mmol) of intermediate B was added to a flask together with 1.73g(8.5mmol) of iodobenzene, potassium carbonate (8.5g, 62mmol), copper (3.9g, 62mmol) and 50ml of DMF. The reaction was heated to 160°C for 48h. The mixture was cooled to room temperature and diluted with 300ml of CH₂Cl₂, 300ml of water are added to the mixture. The organic phase was dried over sodium sulfate and concentrated. The resulting crude product was purified by chromatography to obtained 1.8g of product. Yield 37%.

### Synthesis of example 4

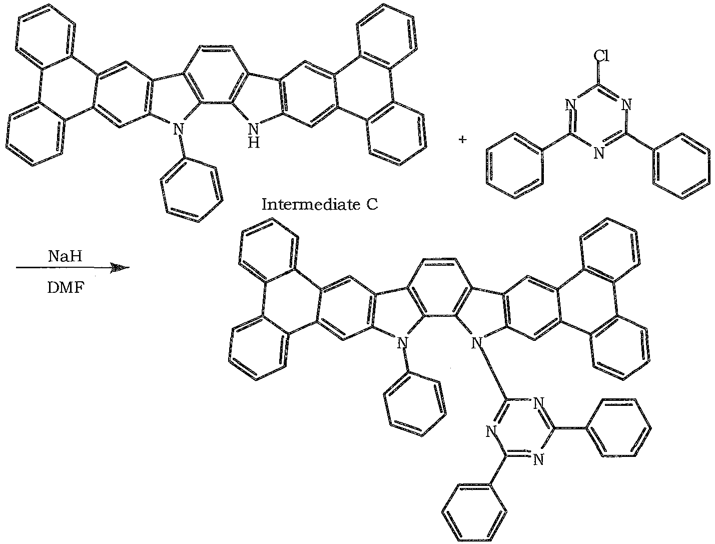

Under N₂ condition, 1.8g(2.9mmol) of intermediate C and 30ml of DMF were mixed, and 0.56g(23.2mmol) of NaH was slowly added to the mixture. The mixture was stirred at room temperature for 30 minutes. Than 2.4g(8.7mmol) of 2-chloro-4,6-diphenyl-1,3,5-triazine was slowly added to the mixture. The mixture was stirred at room temperature for 24 hours. After completion of the reaction, 200ml of iced water was added, while stirring and the precipitated product was filtered off with suction. To give 1.3g(yield51%) of yellow product which was recrystallized from ethyl acetate. MS(m/z ,FAB⁺):864.2; ¹H NMR (CDCl₃, 400 MHz): chemical shift(ppm) 9.09(s, 2H), 8.97∼8.93(m, 4H), 8.57∼8.41(m, 7H), 8.23(d, J=8.0Hz, 2H), 8.13 ∼7.92(m, 8H), 7.89∼7.83(m, 2H), 7.78∼7.64 (m, 6H), 7.45∼7.39(m, 4H), 7.36∼7.29(m, 2H)

### EXAMPLE 5

### Synthesis of example 5

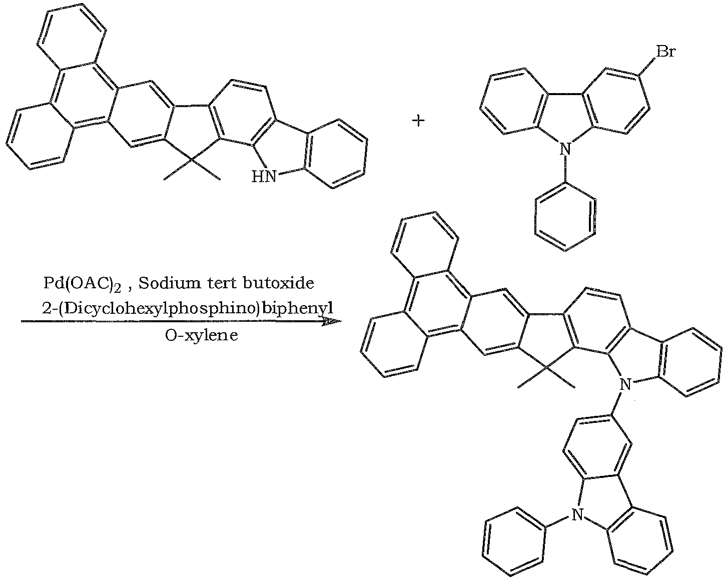

A mixture of 4.3g(10mmol) intermediate I, 4.8g(15mmol) of 3-bromo-9-phenyl-9H-carbazole, 0.05g(0.2mmol) of palladium(II) acetate, 0.15g(0.4mmol) of 2-(dicyclohexylphosphino)biphenyl, 2g(20mmol)of sodium tert-butoxide and 100ml of o-xylene was refluxed under nitrogen overnight. After finishing the reaction, the solution was filtered at 100 °C, To receive the filtrate, and the filtrate was added to 1L MeOH, while stirring and the precipitated product was filtered off with suction. To give 3.2g (yield48%) of yellow product which was recrystallized from toluene. MS(m/z, FAB⁺):674.5; ¹H NMR(CDCl₃, 400 MHz): chemical shift(ppm) 9.11(s, 1H), 8.76∼8.71(m, 6H), 8.51∼8.46(m, 8H), 8.21∼8.14(m, 6H), 7.87∼7.83(m, 2H), 7.64∼7.54(m, 5H), 1.73(s, 6H).

### GENERAL METHOD OF PRODUCING ORGANIC EL DEVICE

ITO-coated glasses with 9∼12 ohm/square in resistance and 120∼160nm in thickness are provided(hereinafter ITO substrate) and cleaned in a number of cleaning steps in an ultrasonic bath(e.g. detergent, deionized water). Before vapor deposition of the organic layers, cleaned ITO substrates are further treated by UV and ozone. All pre-treatment processes for ITO substrate are under clean room(class 100).

These organic layers are applied onto the ITO substrate in order by vapor deposition in a high-vacuum unit(10⁻⁷ Torr), such as: resistively heated quartz boats. The thickness of the respective layer and the vapor deposition rate (0.1∼0.3 nm/sec) are precisely monitored or set with the aid of a quartz-crystal monitor. It is also possible, as described above, for individual layers to consist of more than one compound, i.e. in general a host material doped with a dopant material. This is achieved by co-vaporization from two or more sources.

Dipyrazino[2,3-f:2,3-]quinoxaline-2,3,6,7,10,11-hexacarbonitrile (HAT-CN) is used as hole injection layer in this organic EL device. N,N-Bis(naphthalene-1-yl)-N,N-bis(phenyl)-benzidine(NPB) is most widely used as the hole transporting layer. 10,10-Dimethyl-12-(4-(pyren-1-yl)phenyl) -10H-indeno[1,2-b]triphenylene(PT-312,US20140175384) is used as blue emitting host and N1,N1,N6,N6-tetram-tolylpyrene-1,6-diamine(D1) is used as blue guest.2-(10,10-dimethyl-10H-indeno[2,l-b]triphenylen-13-yl)-9-phenyl-1,10-phenanthroline is used as electron transporting material(ET1) to co-deposit with 5% Li,2-(10,10-dimethyl-10H-indeno[2,1-b]triphenylen-12-yl) -4,6-diphenyl-1,3,5-triazine is used as electron transporting material(ET2) to co-deposit with 8-hydroxyquinolato-lithium(LiQ) in organic EL device. Bis(2-methyl-8-quinolinolate)-4-(phenylphenolato)aluminium(BAlq) is used as hole blocking material(HBM) and phosphorescent host for phosphorescent system, Bis(2-phenylpyridinato)(2,4-diphenylpyridinato)iridium(III)(D1) is used as phosphorescent dopant. 4-(10,10-dimethyl-10H-indeno[2,1-b] triphenylen-13-yl)dibenzo[b,d]thiophene(H1) is used as phosphorescent emitting host to co-deposit with the present invention EXAMPLE 1 to 4. The prior art of OLED materials for producing standard organic EL device control and comparable material in this invention shown its chemical structure as following:

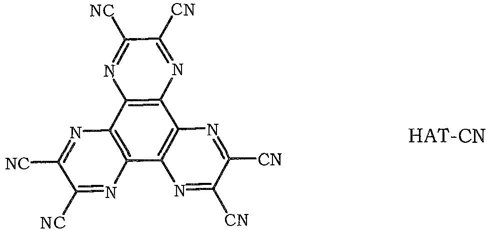

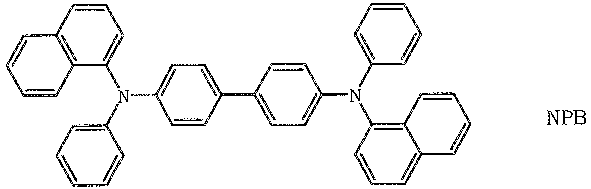

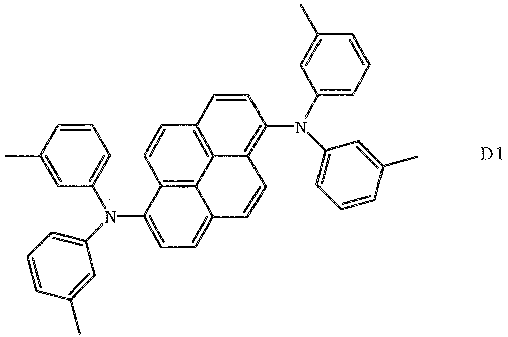

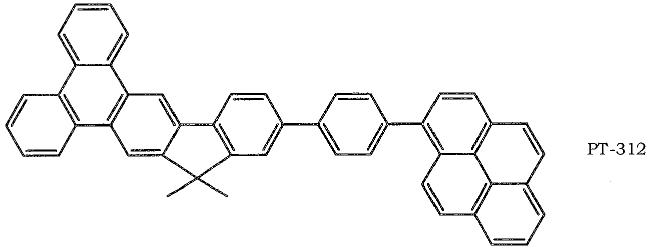

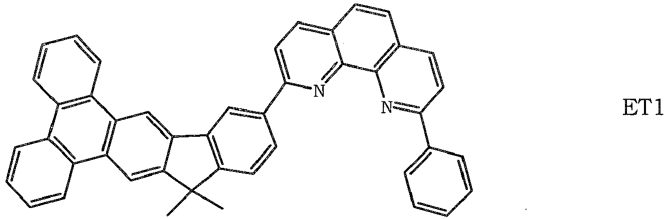

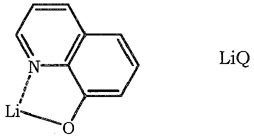

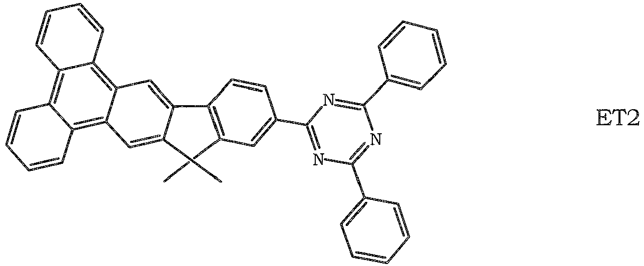

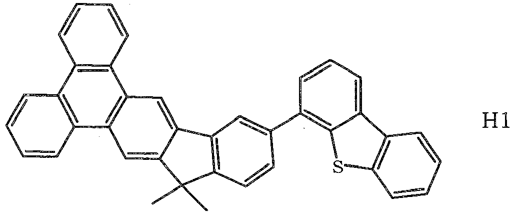

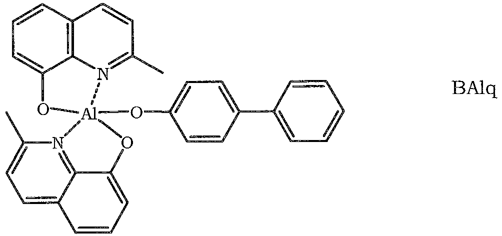

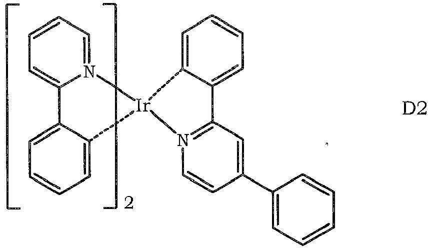

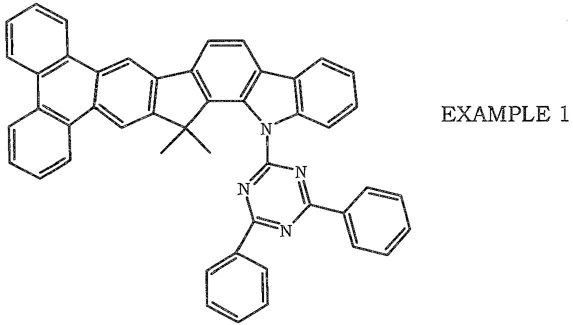

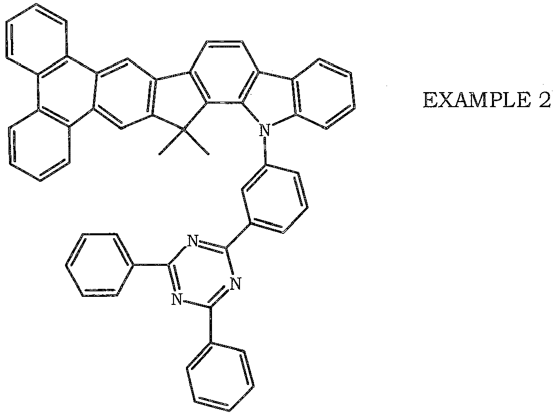

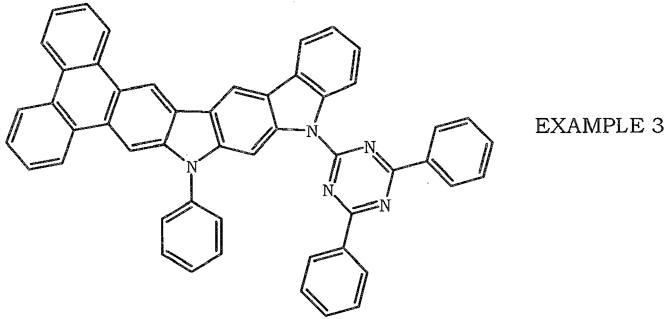

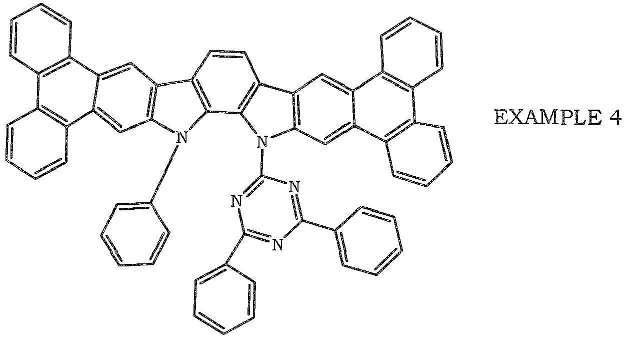

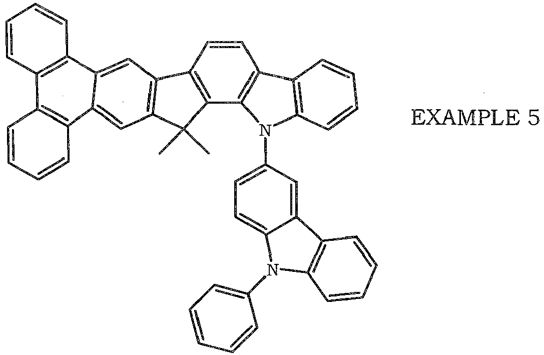

A typical organic EL device consists of low work function metals, such as Al, Mg, Ca, Li and K, as the cathode by thermal evaporation, and the low work function metals can help electrons injecting the electron transporting layer from cathode. In addition, for reducing the electron injection barrier and improving the organic EL device performance, a thin-film electron injecting layer is introduced between the cathode and the electron transporting layer. Conventional materials of electron injecting layer are metal halide or metal oxide with low work function, such as: LiF, LiQ, MgO, or Li₂O. On the other hand, after the organic EL device fabrication, EL spectra and CIE coordination are measured by using a PR650 spectra scan spectrometer. Furthermore, the current/voltage, luminescence/voltage and yield/voltage characteristics are taken with a Keithley 2400 programmable voltage-current source. The above-mentioned apparatuses are operated at room temperature(about 25 °C) and under atmospheric pressure.

### EXAMPLE 6

Using a procedure analogous to the above mentioned general method, fluorescent blue-emitting organic EL device having the following device structure was produced(See Fig.1) : ITO/HAT-CN(20nm)/NPB(130nm) /PT-312 doped 5% D1(30nm)/HBM(hole blocking material(5nm)/ET1 co-deposit 5% Li/Al(160nm). The I-V-B(at 1000nits) and half-life time of fluorescent blue-emitting organic EL device testing report as Table 1, The half-life time is defined that the initial luminance of 1000cd/m² has dropped to half.

**Table 1**

| HBM | Voltage (V) | Efficiency (cd/A) | CIE(y) | Half-life time (hour) |
|---|---|---|---|---|
| BAlq | 5.5 | 5.0 | 0.172 | 195 |
| Ex.1 | 4.5 | 5.6 | 0.181 | 310 |
| Ex.2 | 4.8 | 5.8 | 0.179 | 300 |
| Ex.3 | 4.3 | 6.2 | 0.168 | 350 |
| Ex.4 | 4.5 | 5.6 | 0.169 | 380 |
| Ex.5 | 5.2 | 5.2 | 0.180 | 260 |

### EXAMPLE 7

Using a procedure analogous to the above mentioned general method, phosphorescent emitting organic EL device having the following device structures are produced(See Fig1.) : ITO/HAT-CN(20nm)/NPB(130nm) /phosphorescent host(PHhost) +15% D2(30nm)/HBM(15nm)/ET2 co-deposit LiQ( ET2 : LiQ , ratio=1:1)(40nm)/LiQ(1nm)/Al(160nm).The I-V-B (at1000nits) and half-life time of phosphorescent emitting organic EL device testing report as Table 1. The half-life time is defined that the initial luminance of 3000cd/m² has dropped to half.

**Table 2**

| PHhost(H1+Ex.) H1:Ex.=1:1 | HBM | Voltage (V) | Efficiency (cd/A) | CIE (x,y) | Half-life time (hour) |
|---|---|---|---|---|---|
| Balq | Balq | 5.8 | 25 | 0.43,0.56 | 350 |
| H1+Ex.1 | -- | 4.0 | 38 | 0.42,0.57 | 560 |
| H1+Ex.1 | Ex.1 | 4.2 | 42 | 0.43,0.57 | 650 |
| H1+Ex.2 | -- | 4.2 | 46 | 0.42,0.58 | 540 |
| H1+Ex.3 | Ex.3 | 4.0 | 39 | 0.44,0.56 | 760 |
| H1+Ex.3 | -- | 3.8 | 32 | 0.45,0.58 | 580 |
| H1+Ex.4 | Ex.4 | 4.0 | 35 | 0.46,0.55 | 650 |
| H1+Ex.4 | Ex.3 | 3.8 | 32 | 0.46,0.54 | 580 |
| H1+Ex.5 | Ex.5 | 4.5 | 25 | 0.43,0.58 | 600 |
| H1+Ex.5 | Ex.3 | 4.5 | 22 | 0.43,0.57 | 650 |
| Ex.5+Ex.2 | Ex.3 | 3.5 | 48 | 0.43,0.56 | 720 |
| Ex.5+Ex.2 | -- | 3.6 | 42 | 0.42,0.56 | 750 |

In the above preferred embodiments for organic EL device test report(see Table 1 and Table 2), we show that the with a general formula(I) and formula(II) in the present invention display good performance than the prior art of OLED materials

To sum up, the present invention discloses a compound which can be used for organic EL device is disclosed. More specifically, an organic EL device employing the compound as phosphorescent emitting host, hole blocking layer, or hole blocking electron transport layer. The mentioned compound are represented by the following formula(I) or formula(II) : 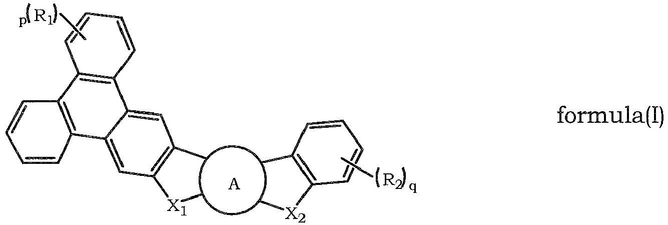 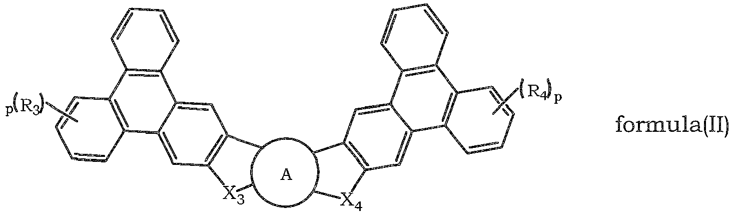 Wherein A represent a substituted or unsubstituted phenyl group, a substituted or unsubstituted naphthyl group. X₁ to X₄ independently represent a divalent bridge selected from the atom or group consisting from O, S, C(R₅)(R₆), N(Ar), Si(R₇)(R₈). p represent an integer of 0 to 10. q represent an integer of 0 to 4. R₁ to R₈, and Ar independently selected from the group consisting of a hydrogen atom, a substituted or unsubstituted alkyl group having 1 to 30 carbon atoms, a substituted or unsubstituted aryl group having 6 to 50 carbon atoms, a substituted or unsubstituted aralkyl group having 6 to 50 carbon atoms, a substituted or unsubstituted heteroaryl group having 3 to 50 carbon atoms.

## Claims

1. A compound with a general formula(I) or formula(II) as following: 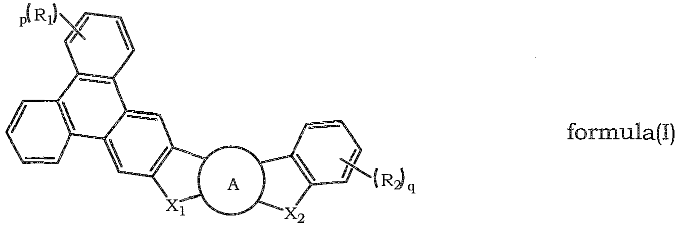 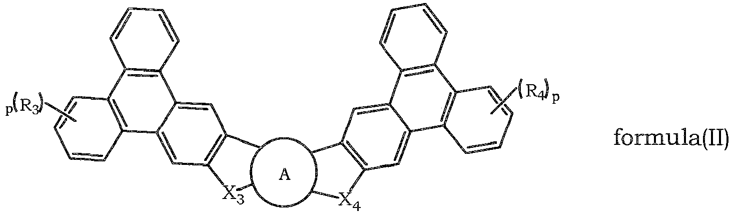 Wherein A represent a substituted or unsubstituted phenyl group, a substituted or unsubstituted naphthyl group. X₁ to X₄ independently represent a divalent bridge selected from the atom or group consisting from O, S, C(R₅)(R₆), N(Ar), Si(R₇)(R₈). p represent an integer of 0 to 10. q represent an integer of 0 to 4. R₁ to R₈, and Ar independently selected from the group consisting of a hydrogen atom, a substituted or unsubstituted alkyl group having 1 to 30 carbon atoms, a substituted or unsubstituted aryl group having 6 to 50 carbon atoms, a substituted or unsubstituted aralkyl group having 6 to 50 carbon atoms, a substituted or unsubstituted heteroaryl group having 3 to 50 carbon atoms.

2. The compound according to claim 1, wherein the compound is represented the following formula(I-1) to formula(I-4) or formula(II-1) to formula(II-4) : 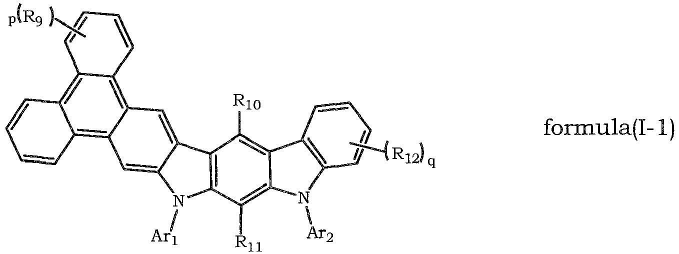 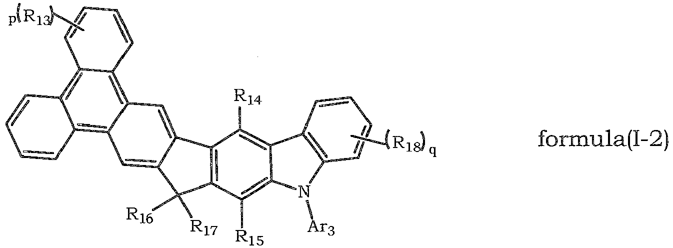 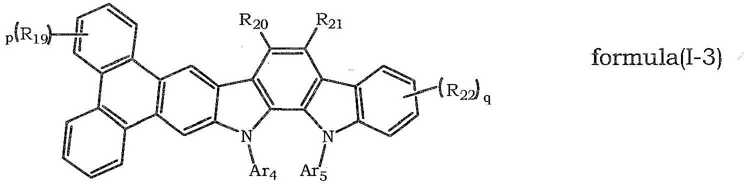 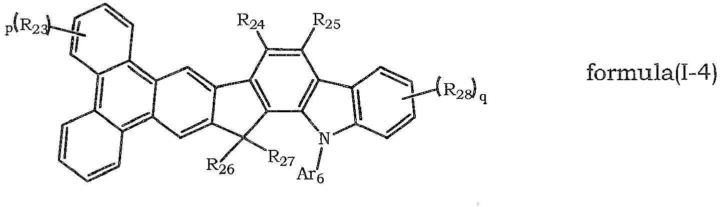 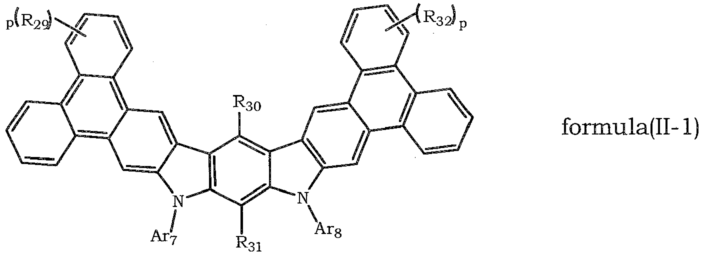 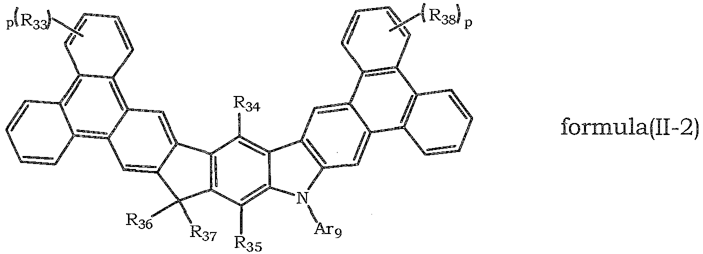 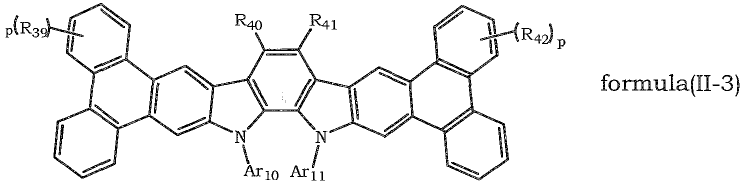 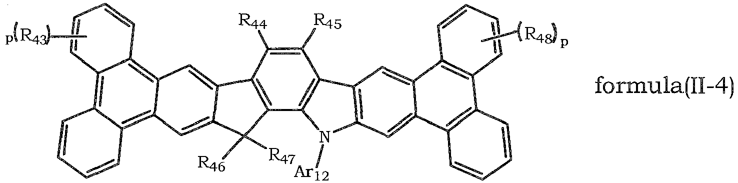 wherein R₉ to R₄₈ are the same definition as R₁, and p, q are same definition as described the above-mentioned formula(I) and formula(II), Ar₁ to Ar₁₂ is represented by the following formula(III) : 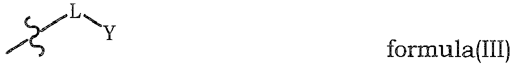 wherein L represent a single bond, a substituted or unsubstituted arylene group having 6 to 30 ring carbon atoms, or a substituted or unsubstituted heteroarylene group having 3 to 30 ring carbon atoms. Y represent a substituted or unsubstituted phenyl group, a substituted or unsubstituted naphthyl group, a substituted or unsubstituted biphenyl group, a substituted or unsubstituted carbazolyl group, a substituted or unsubstituted biscarbazolyl group, a substituted or unsubstituted dibenzofuranyl group, a substituted or unsubstituted dibenzothiophenyl group, a substituted or unsubstituted triazinyl group, a substituted or unsubstituted diazinyl group, a substituted or unsubstituted phenanthroline group, a substituted or unsubstituted dihydroacridine group, a substituted or unsubstituted phenothiazine group, a substituted or unsubstituted phenoxazine group, a substituted or unsubstituted dihydrophenazine group

3. The compound according to claim 2, the formula(III) for L are consisting of group represent as following :

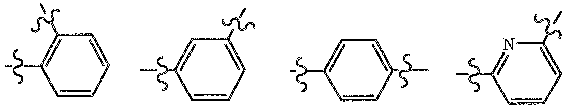

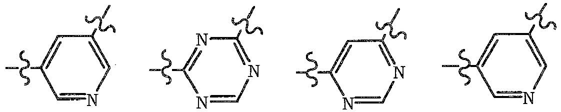

4. The compound according to claim 2, the formula(III) for Y are consisting of group represent as following :

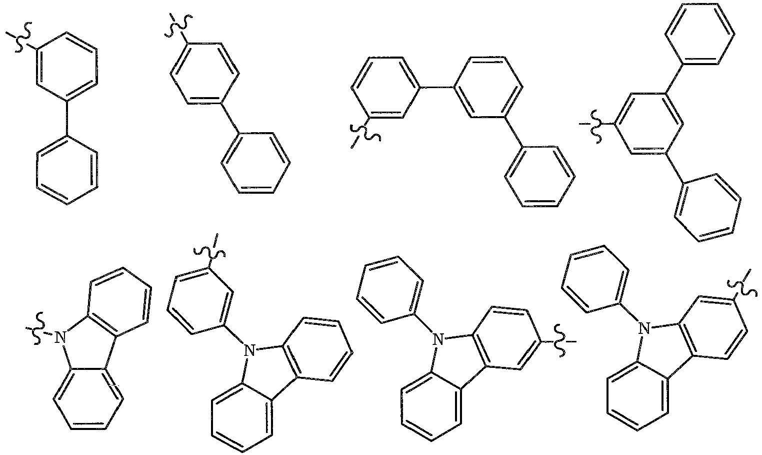

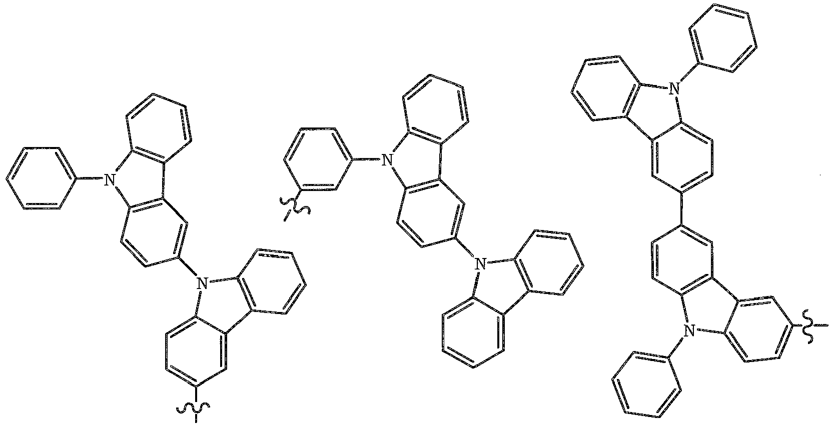

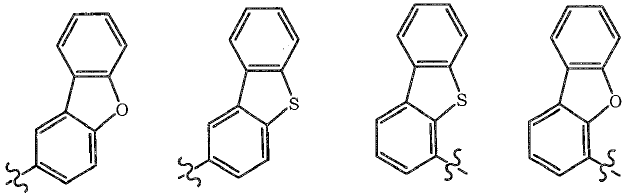

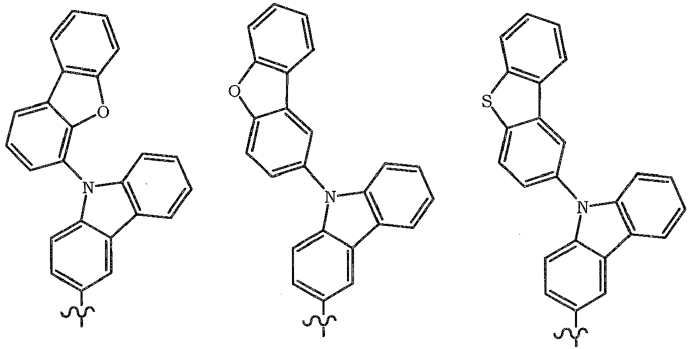

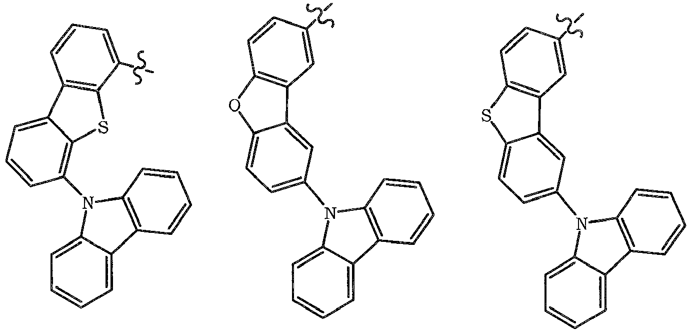

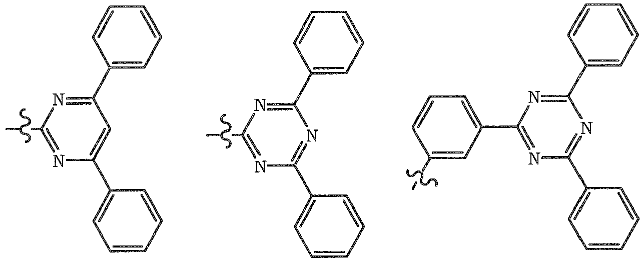

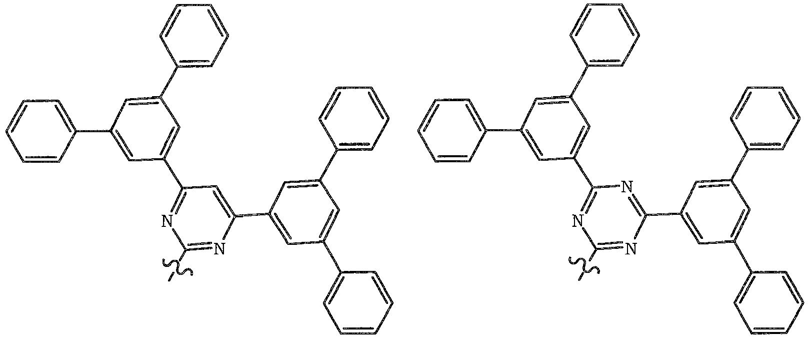

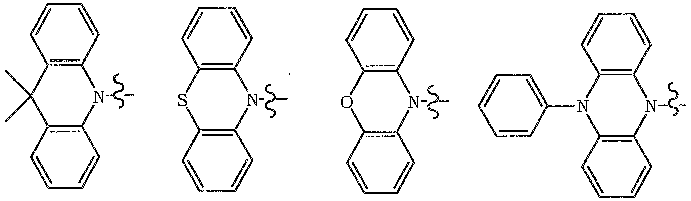

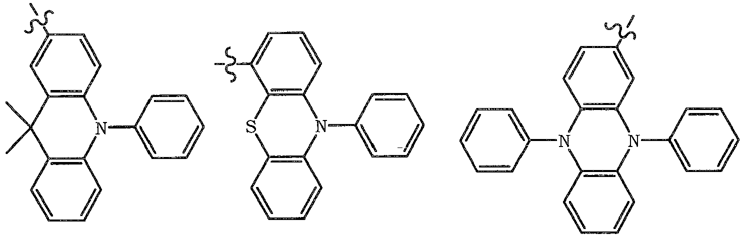

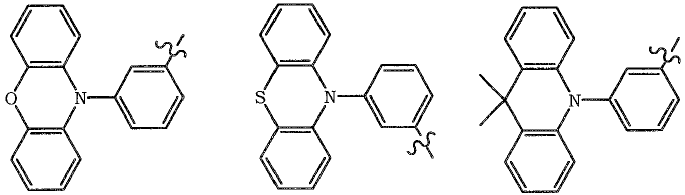

5. The compound according to claim 1, the compound with a general formula(I) or formula(II) are

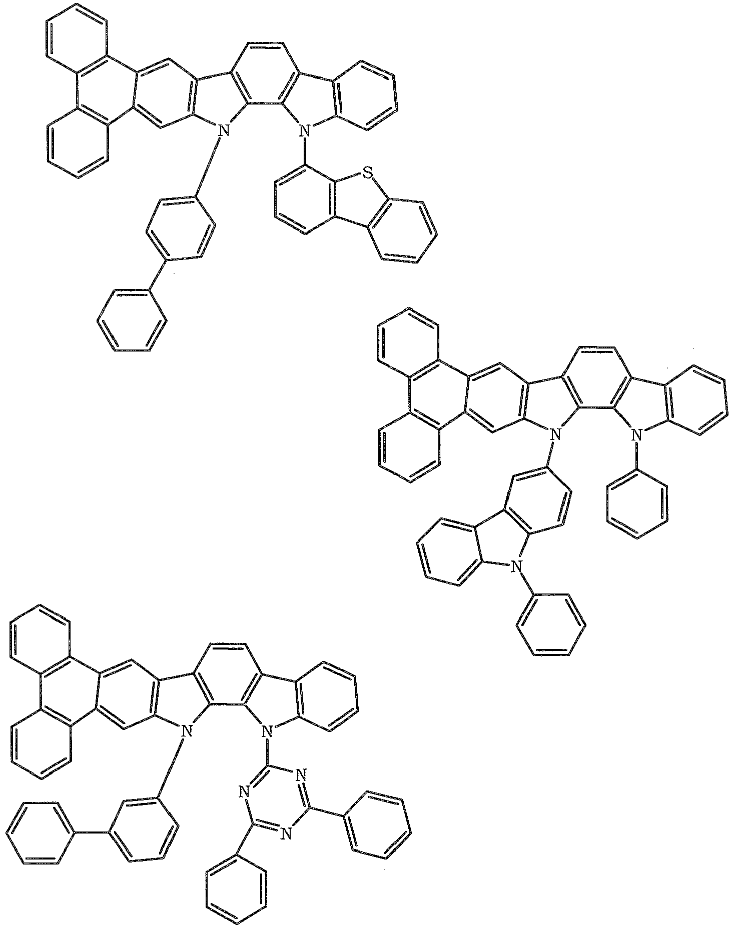

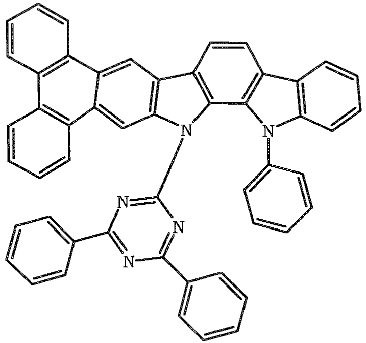

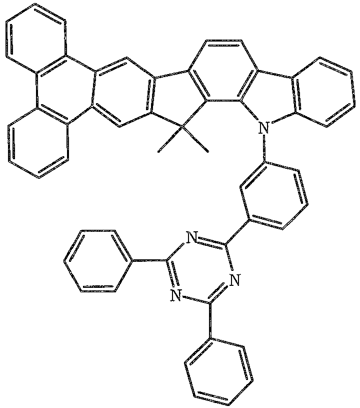

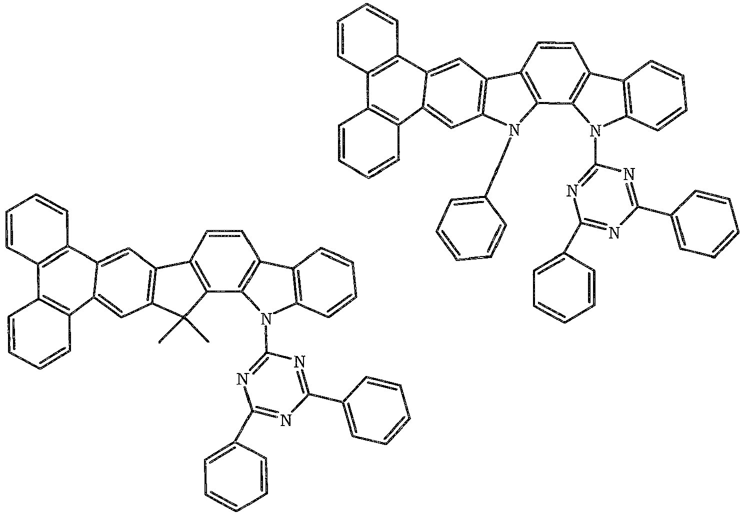

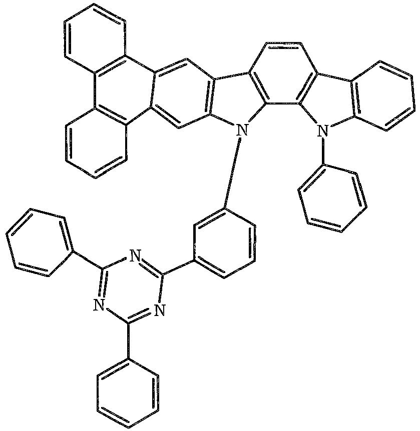

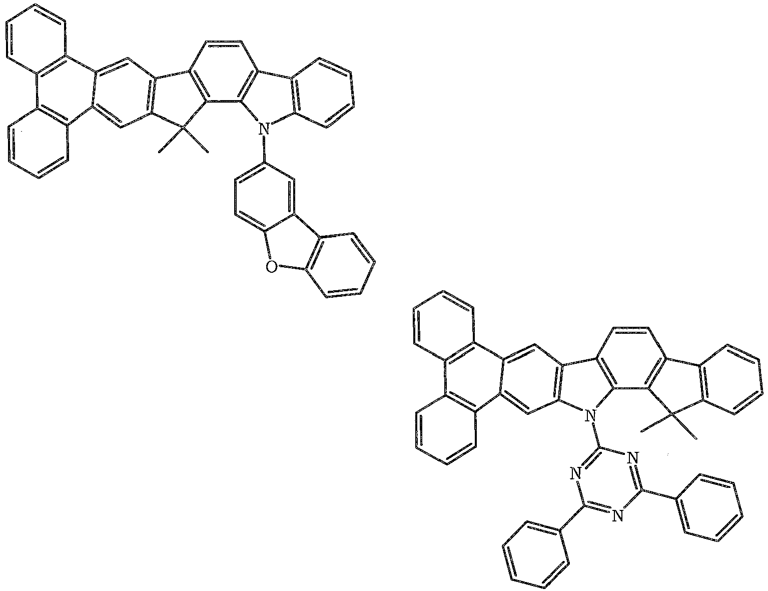

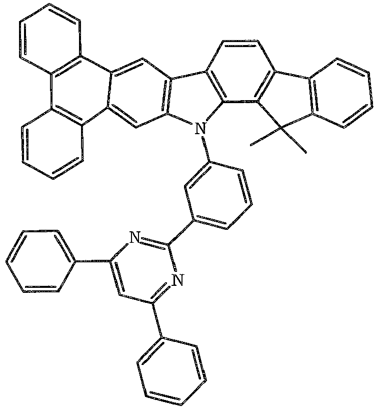

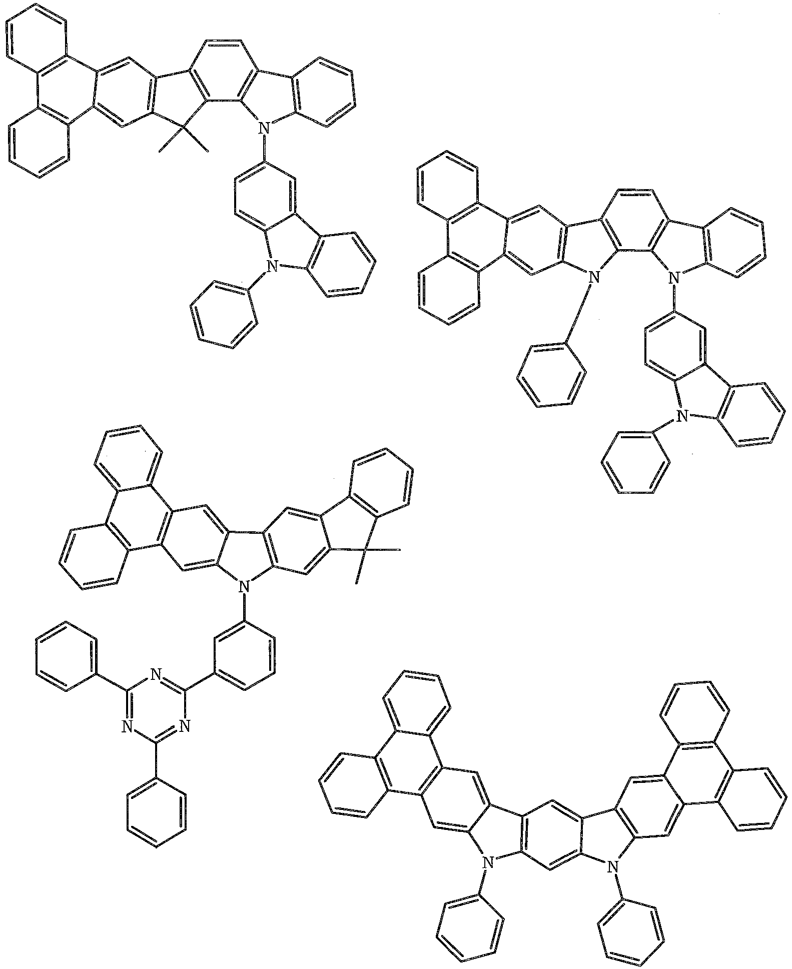

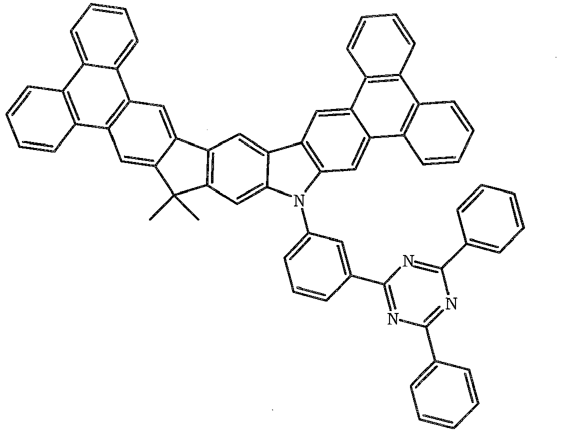

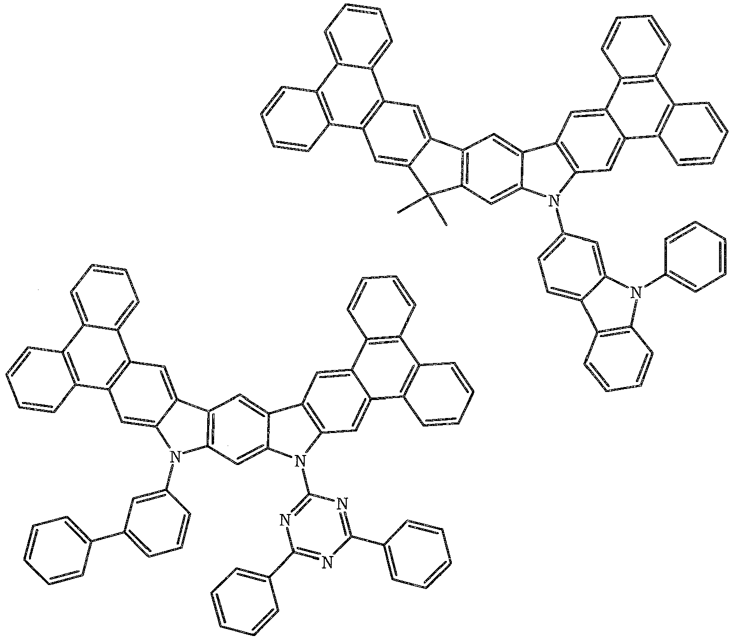

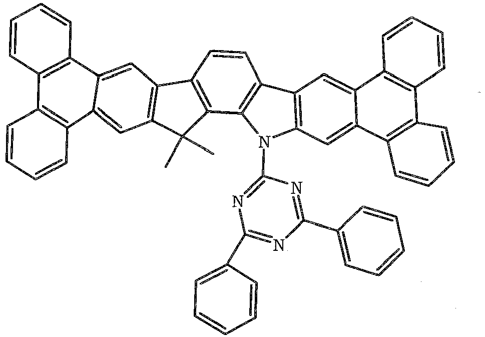

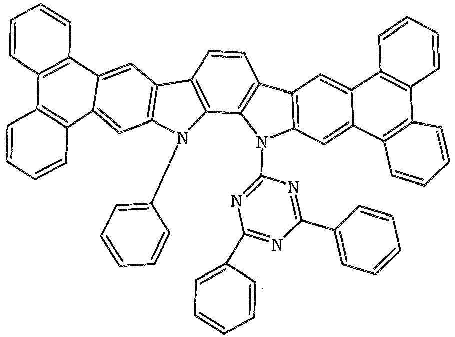

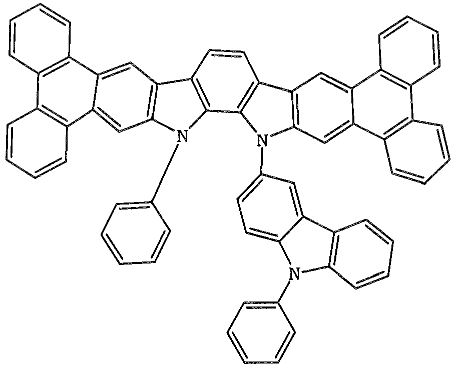

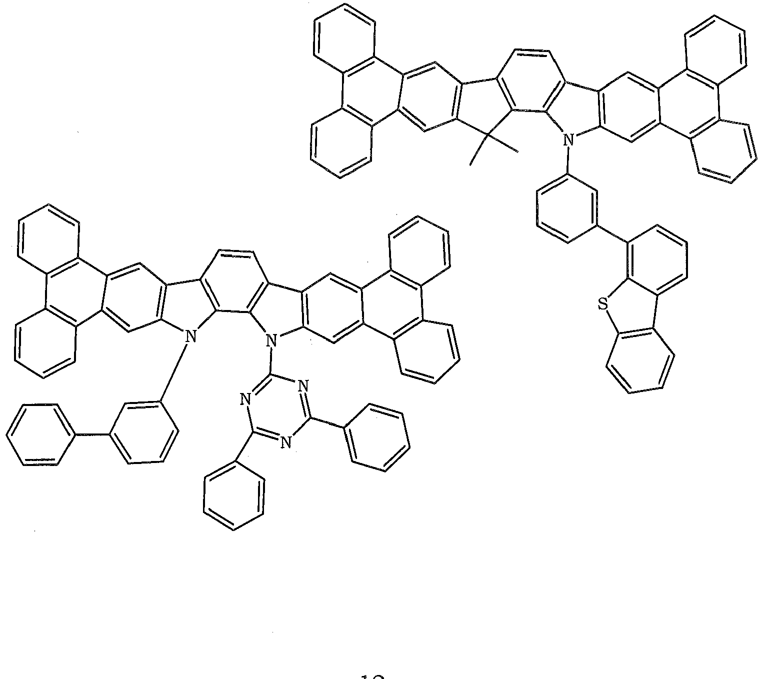

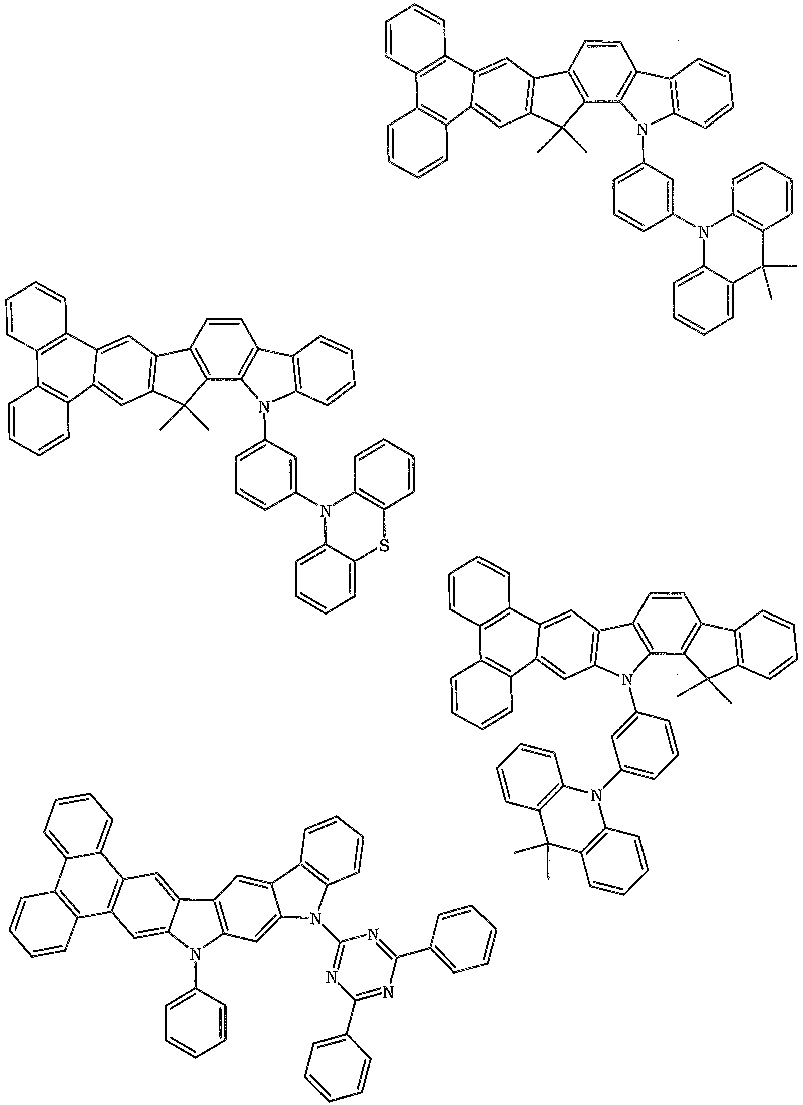

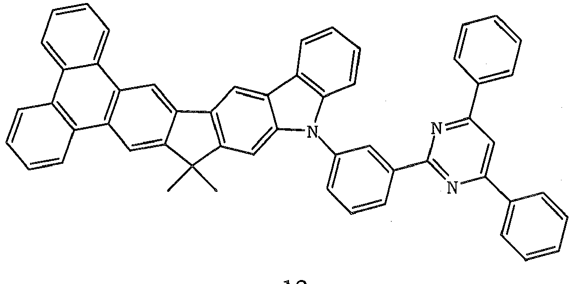

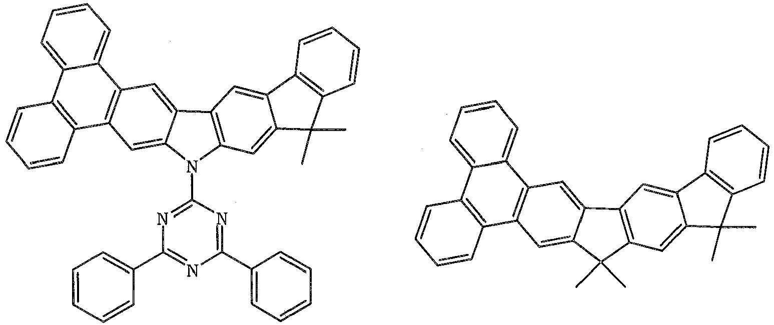

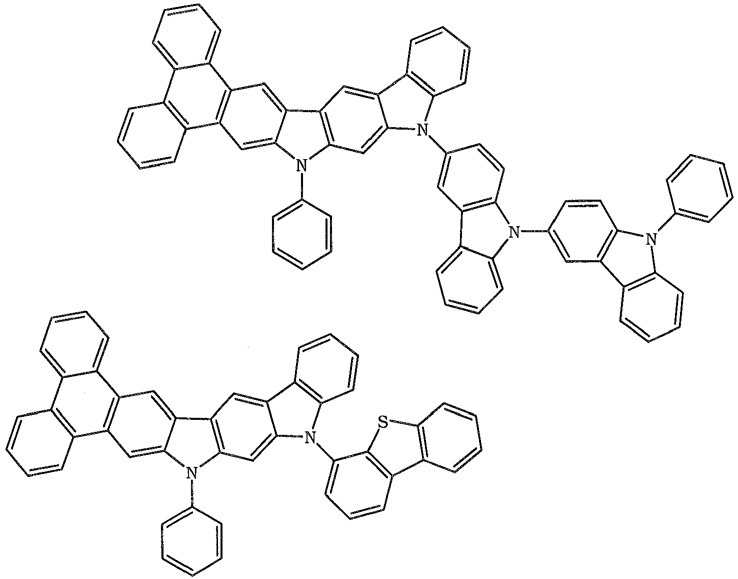

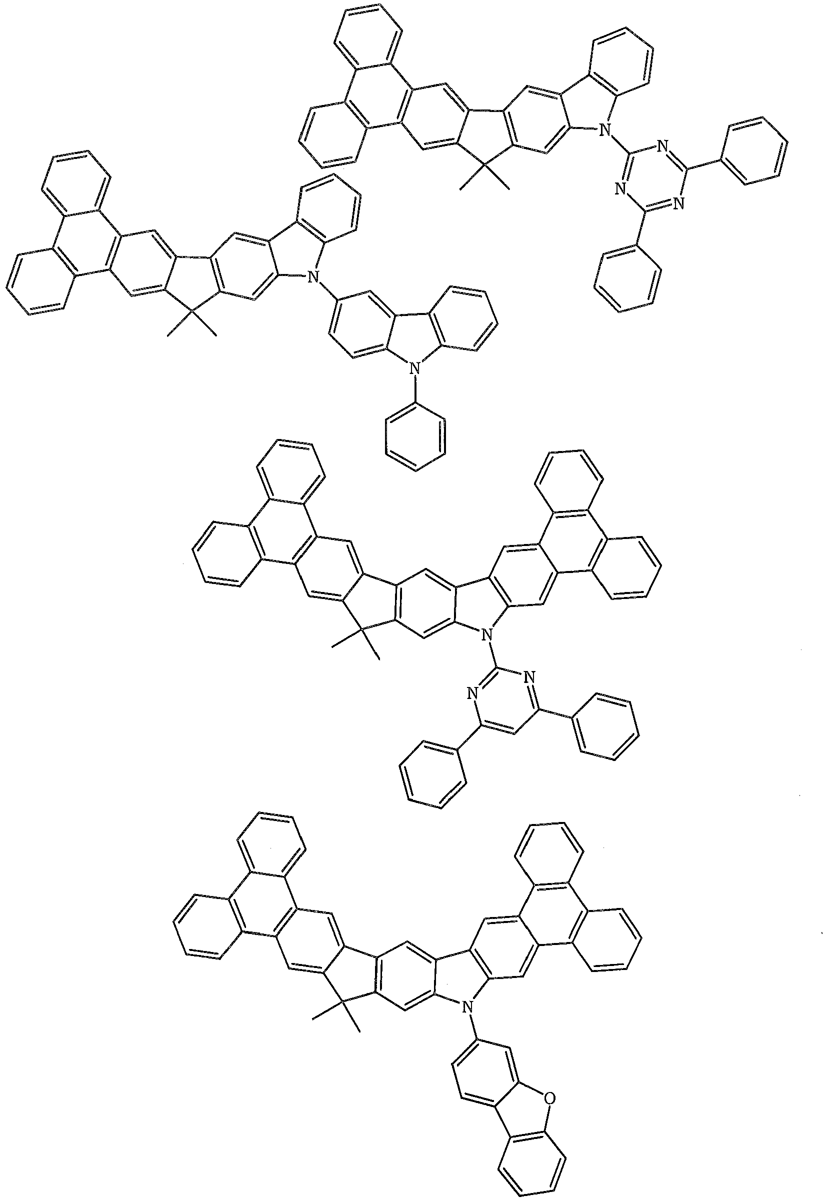

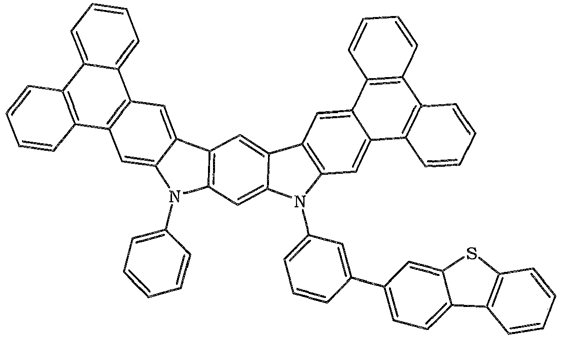

6. A organic electroluminescent device comprising a pair of electrodes (6/13) consisting of a cathode and an anode and between the pairs of electrodes comprising at least a layer of the compound with a general formula(I) or formula(II) according to claim 1.

7. The organic electroluminescent device according to claim 6, wherein the layer is an emitting layer (9) comprising the compound with a general formula(I) or formula(II).

8. The organic electroluminescent device according to claim 7, wherein the emitting layer (9) comprising the compound with a general formula(I) or formula(II) is a phosphorescent host material, or a thermally activated delayed fluorescence host material.

9. The organic electroluminescent device according to claim 7, wherein the emitting layer (9) comprising phosphorescent dopant or thermally activated delayed fluorescence dopant.

10. The organic electroluminescent device according to claim 9, wherein the phosphorescent dopant are iridium(Ir) complexes.

11. The organic electroluminescent device according to claim 6, wherein the layer is a hole blocking layer (10) comprising the compound with a general formula(I) or formula(II).

12. The organic electroluminescent device according to claim 6, wherein the layer is a hole blocking electron transport layer (10') comprising the compound with a general formula(I) or formula(II).

13. The organic electroluminescent device according to claim 6, wherein the layer is an emitting layer (9) comprising compound as the following:

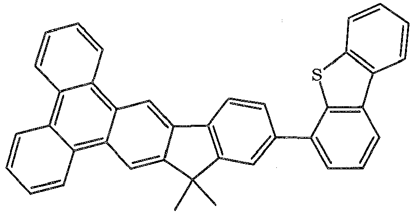

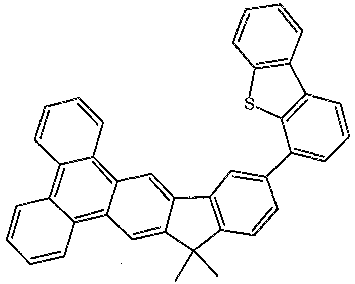

14. The organic electroluminescent device according to claim 6, wherein the layer is an electron transport layer (11) comprising compounds as the following:

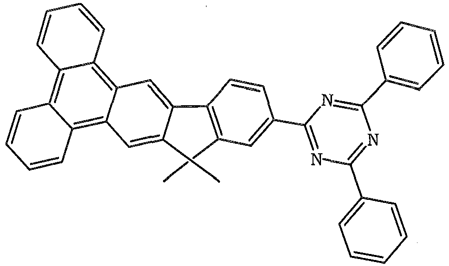

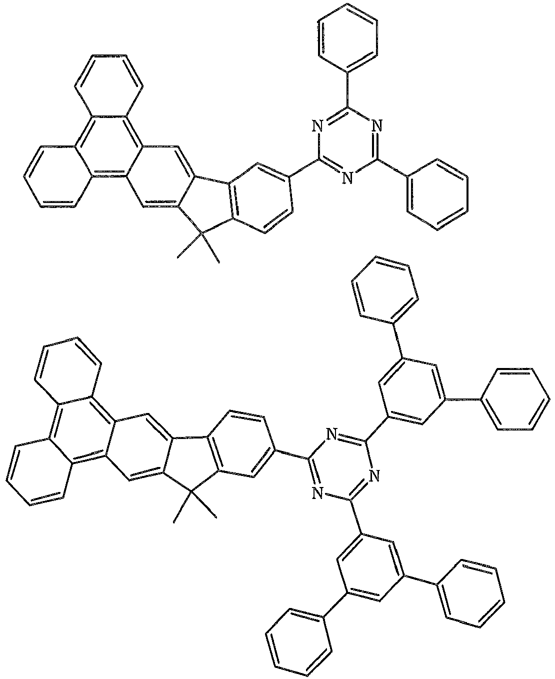

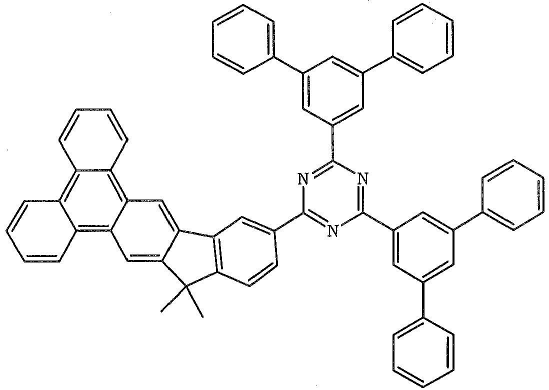

15. The organic electroluminescent device according to claim 14, wherein the electron transport layer (11) comprising lithium or 8-hydroxyquinolato-lithium.

## Patentansprüche

1. Verbindung mit einer allgemeinen Formel (I) oder Formel (II) wie folgt: 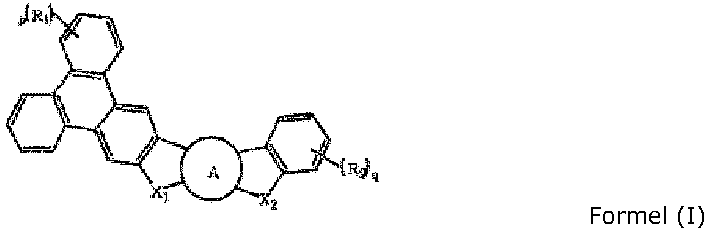 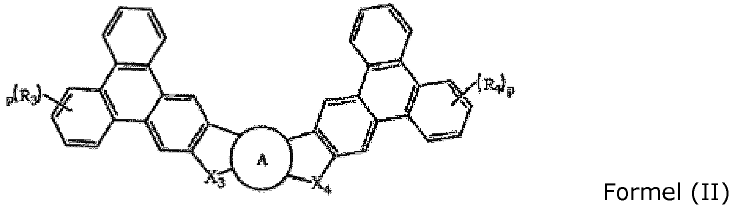 wobei A für eine substituierte oder unsubstituierte Phenylgruppe, eine substituierte oder unsubstituierte Naphthylgruppe steht, X₁ bis X₄ unabhängig für eine zweiwertige Brücke stehen, die aus dem Atom oder der Gruppe ausgewählt ist, die aus O, S, C(R₅)(R₆), N(Ar), Si(R₇)(R₈) bestehen, p für eine ganze Zahl von 0 bis 10 steht, q für eine ganze Zahl von 0 bis 4 steht, R₁ bis R₈ und Ar unabhängig aus der Gruppe ausgewählt sind, die aus einem Wasserstoffatom, einer substituierten oder unsubstituierten Alkylgruppe mit 1 bis 30 Kohlenstoffatomen, einer substituierten oder unsubstituierten Arylgruppe mit 6 bis 50 Kohlenstoffatomen, einer substituierten oder unsubstituierten Aralkylgruppe mit 6 bis 50 Kohlenstoffatomen, einer substituierten oder unsubstituierten Heteroarylgruppe mit 3 bis 50 Kohlenstoffatomen besteht.

2. Verbindung gemäß Anspruch 1, wobei die Verbindung durch die folgenden Formel (I-1) bis Formel (I-4) oder Formel (II-1) bis Formel (II-4) dargestellt wird: 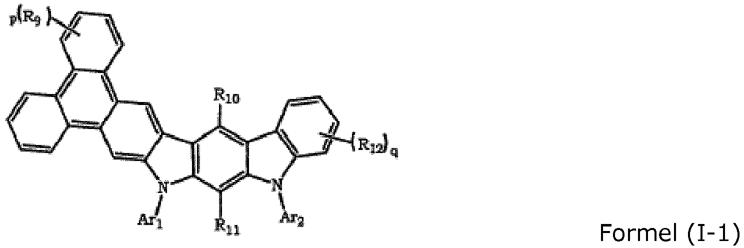 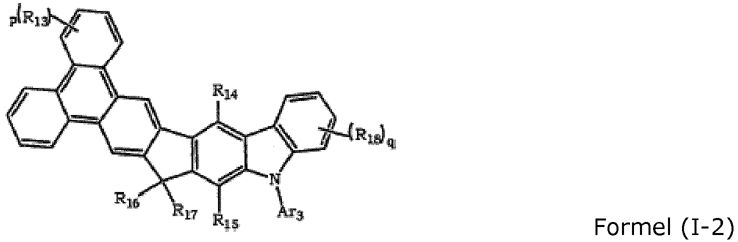 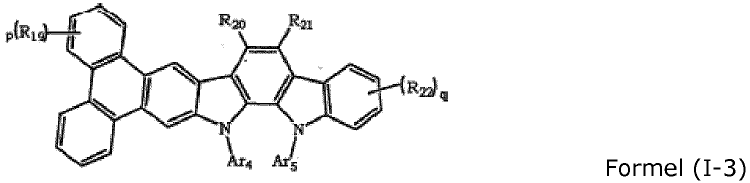 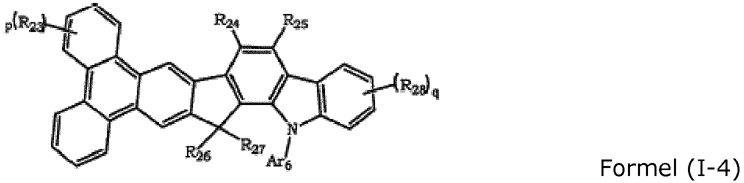 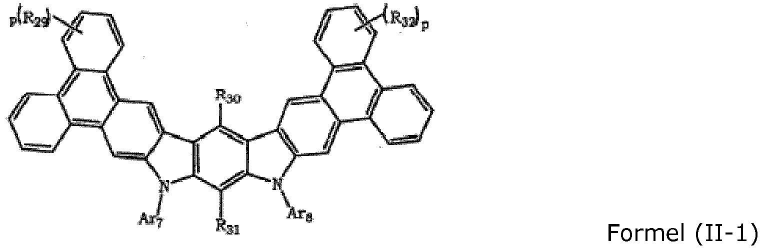 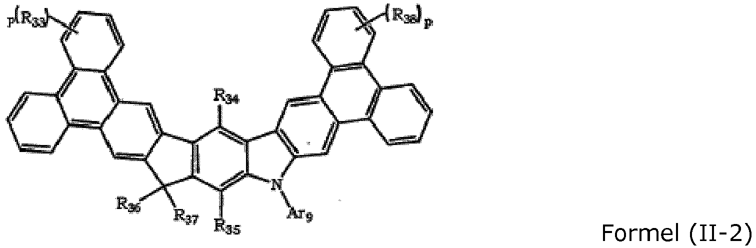 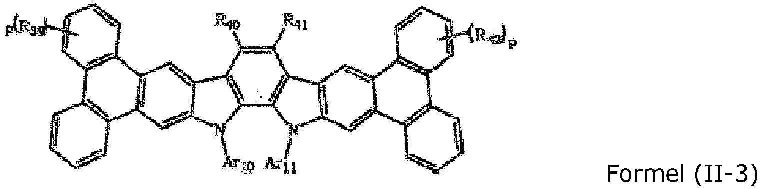 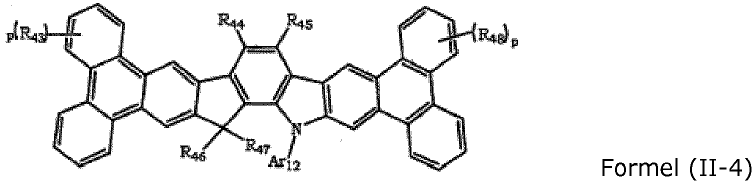 wobei R₉ bis R₄₈ wie R₁ definiert sind und p und q so definiert sind, wie es für die oben beschriebene Formel (I) und Formel (II) beschrieben ist, Ar₁ bis Ar₁₂ durch die folgenden Formel (III) dargestellt werden: 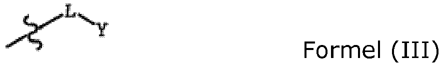 wobei L für eine Einfachbindung, eine substituierte oder unsubstituierte Arylengruppe mit 6 bis 30 Ringkohlenstoffatomen oder eine substituierte oder unsubstituierte Heteroarylengruppe mit 3 bis 30 Ringkohlenstoffatomen steht, Y für eine substituierte oder unsubstituierte Phenylgruppe, eine substituierte oder unsubstituierte Naphthylgruppe, eine substituierte oder unsubstituierte Biphenylgruppe, eine substituierte oder unsubstituierte Carbazolylgruppe, eine substituierte oder unsubstituierte Biscarbazolylgruppe, eine substituierte oder unsubstituierte Dibenzofuranylgruppe, eine substituierte oder unsubstituierte Dibenzothiophenylgruppe, eine substituierte oder unsubstituierte Triazinylgruppe, eine substituierte oder unsubstituierte Diazinylgruppe, eine substituierte oder unsubstituierte Phenanthrolingruppe, eine substituierte oder unsubstituierte Dihydroacridingruppe, eine substituierte oder unsubstituierte Phenothiazingruppe, eine substituierte oder unsubstituierte Phenoxazingruppe, eine substituierte oder unsubstituierte Dihydrophenazingruppe steht.

3. Verbindung gemäß Anspruch 2, wobei L in Formel (III) aus der Gruppe ausgewählt ist, die aus Folgenden besteht:

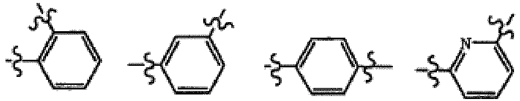

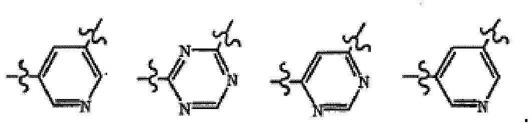

4. Verbindung gemäß Anspruch 2, wobei Y in Formel (III) aus der Gruppe ausgewählt ist, die aus Folgenden besteht:

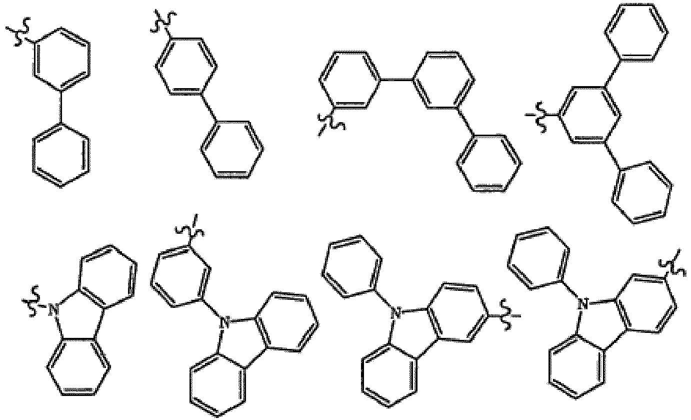

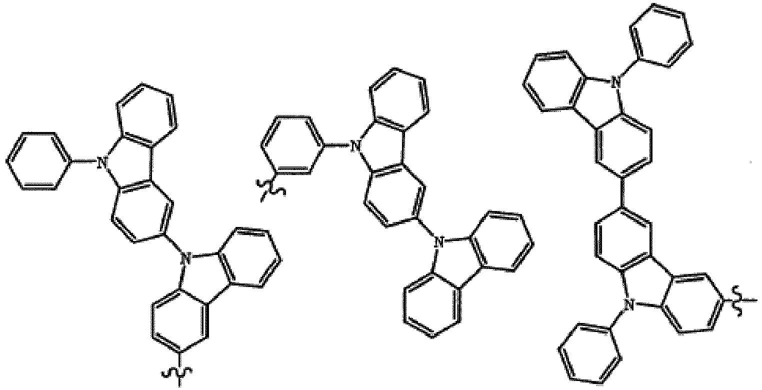

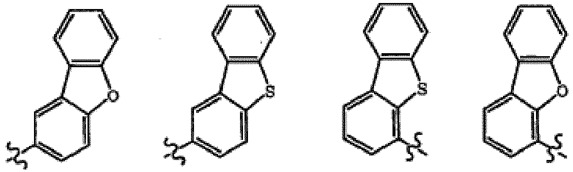

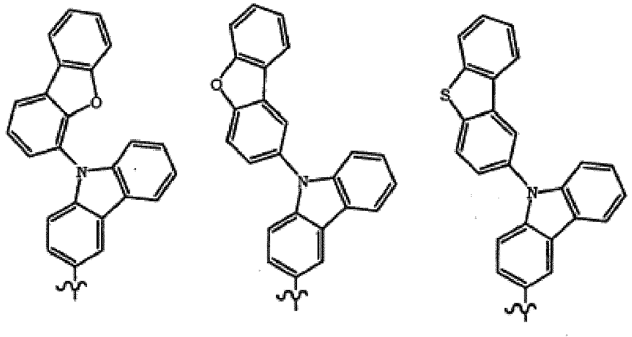

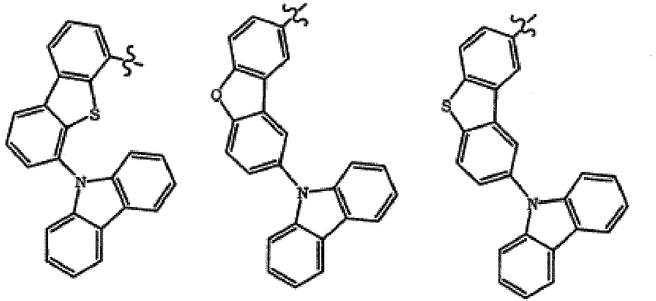

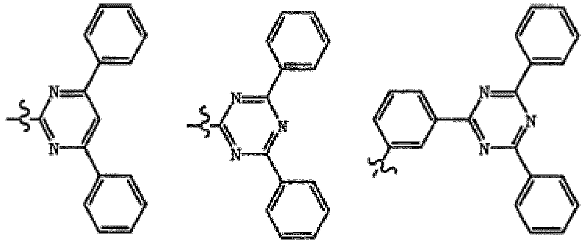

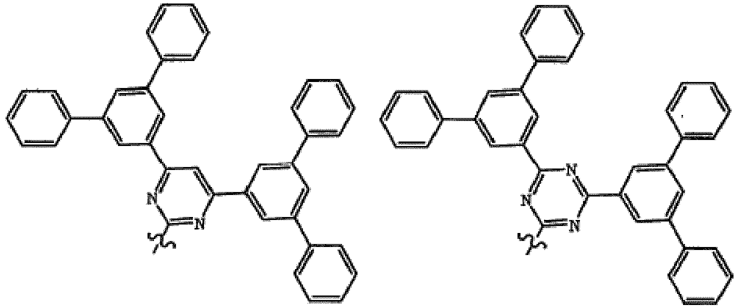

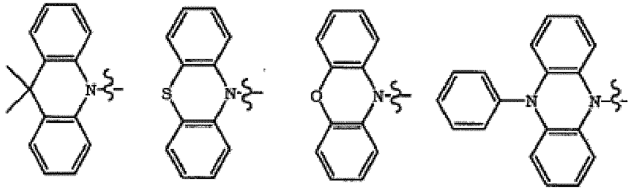

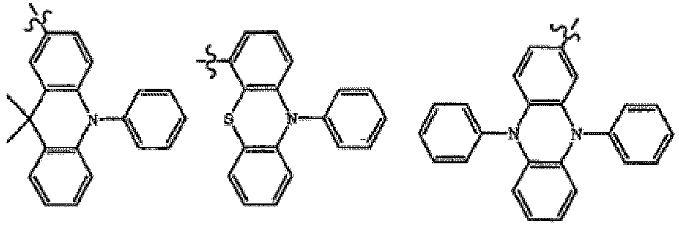

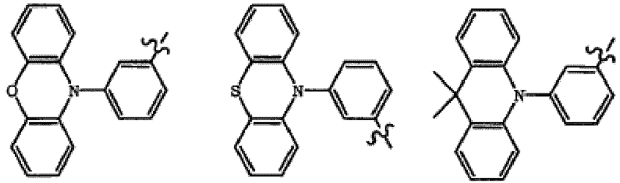

5. Verbindung gemäß Anspruch 1, wobei es sich bei der Verbindung mit der allgemeinen Formel (I) oder Formel (II) um folgende handelt:

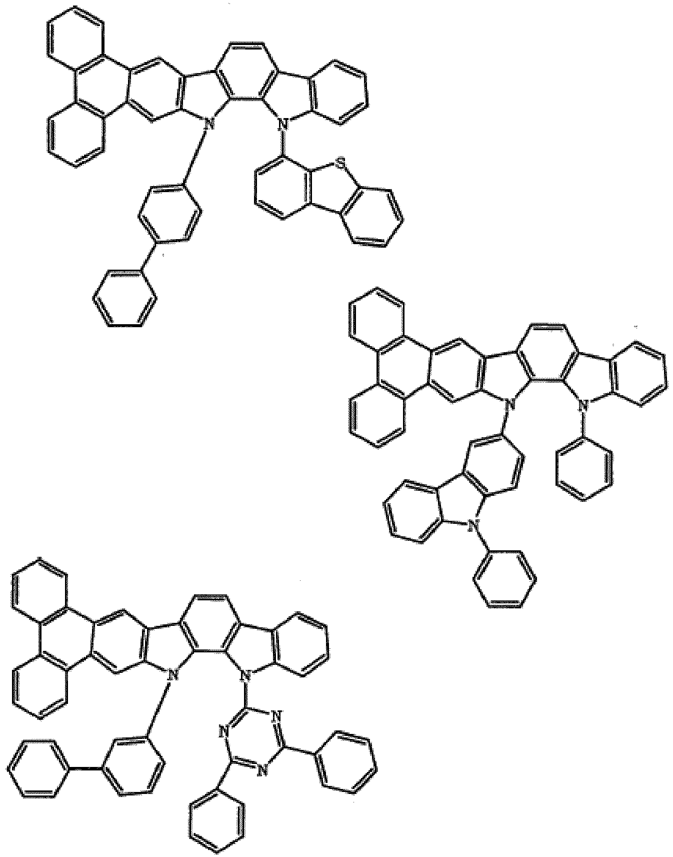

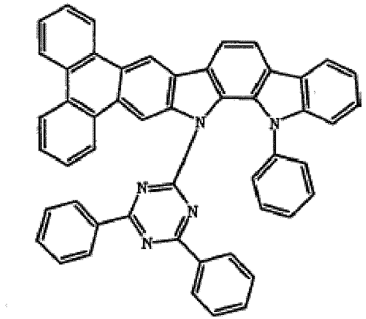

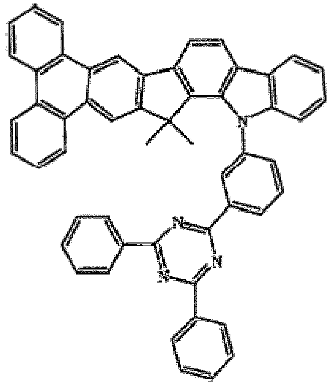

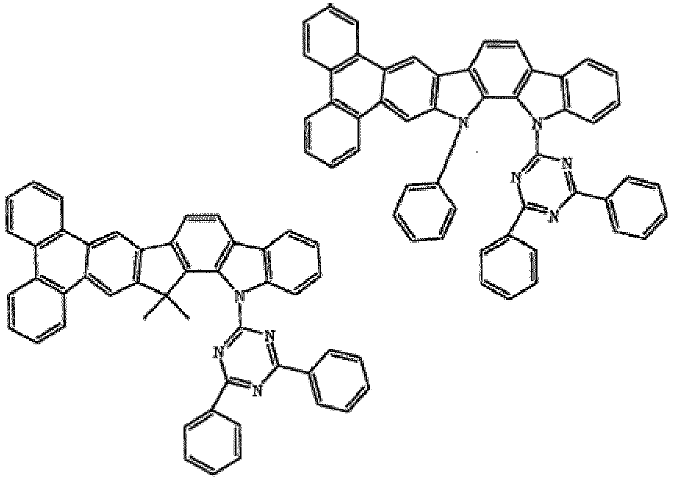

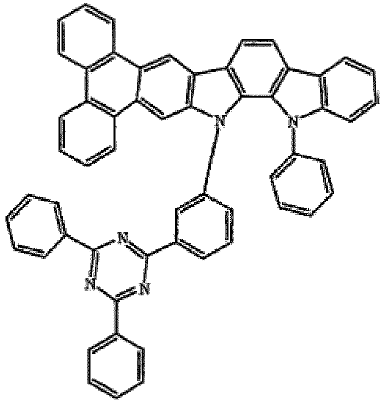

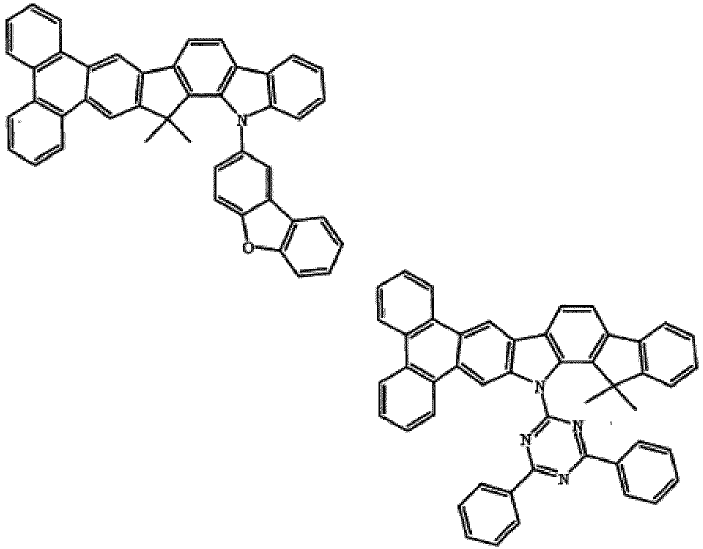

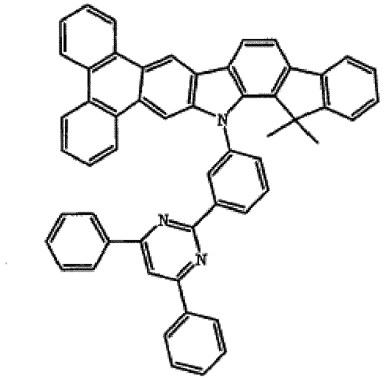

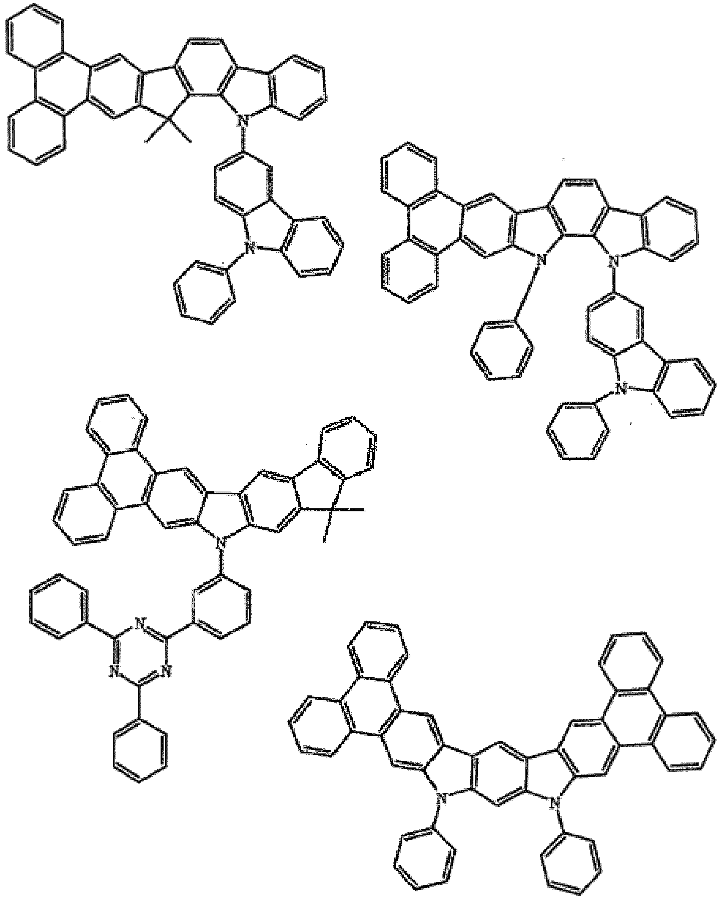

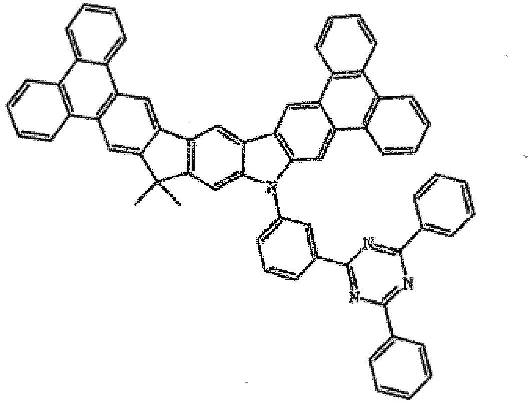

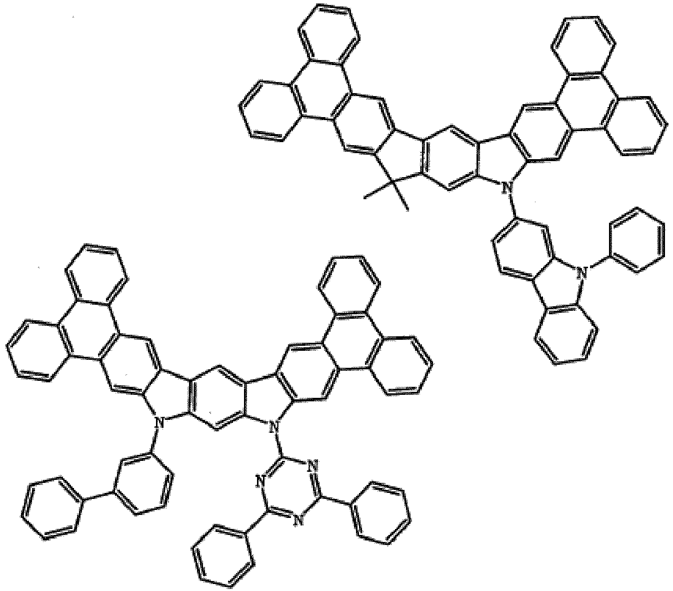

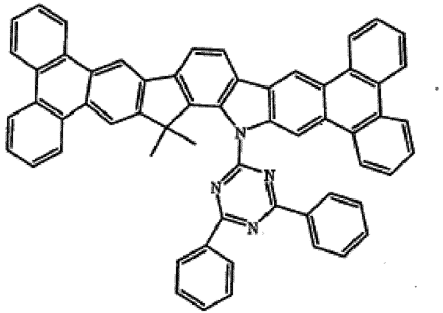

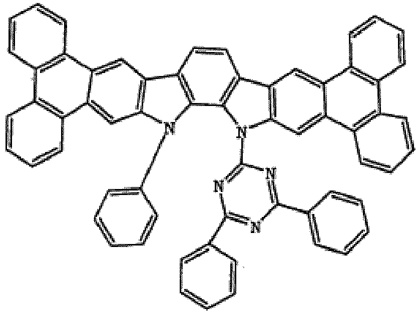

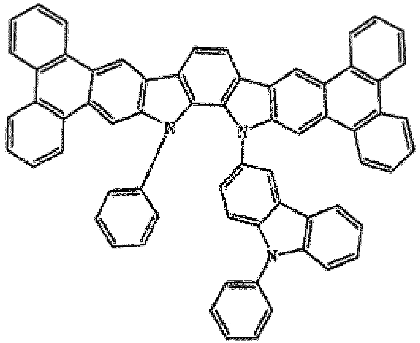

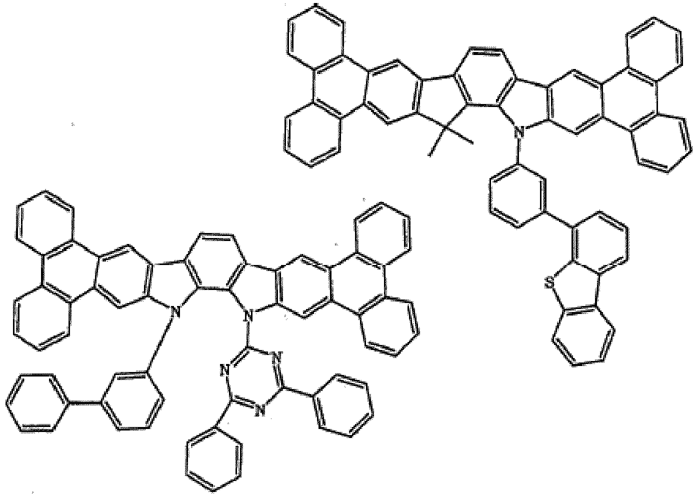

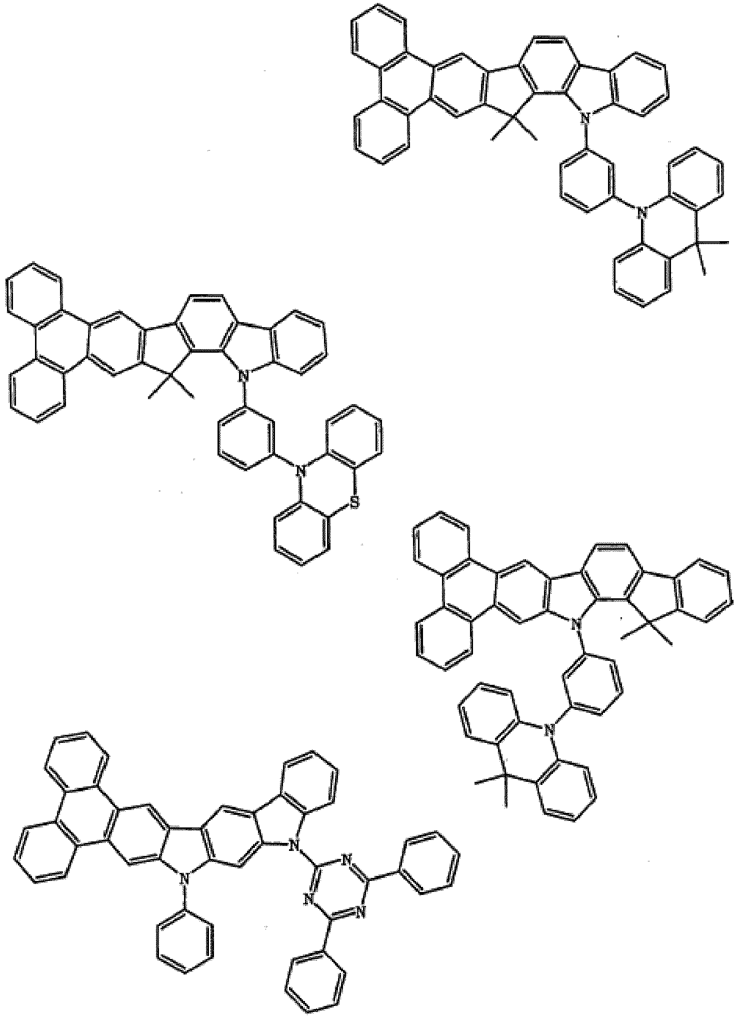

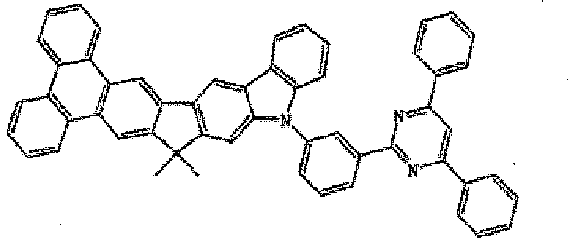

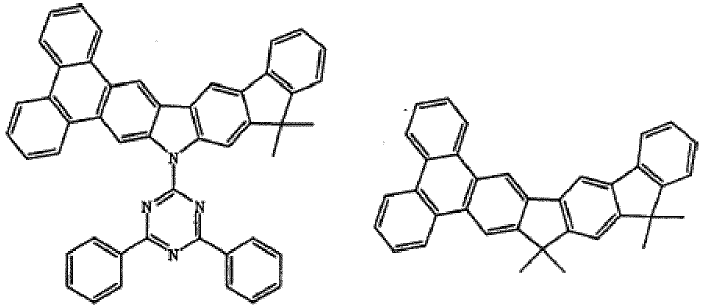

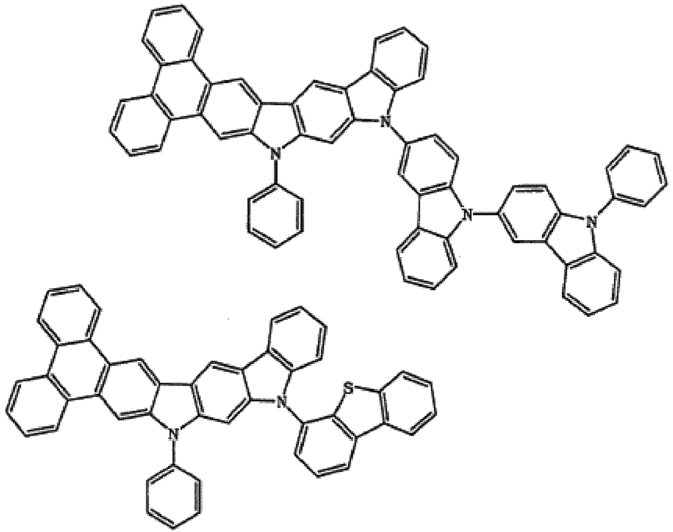

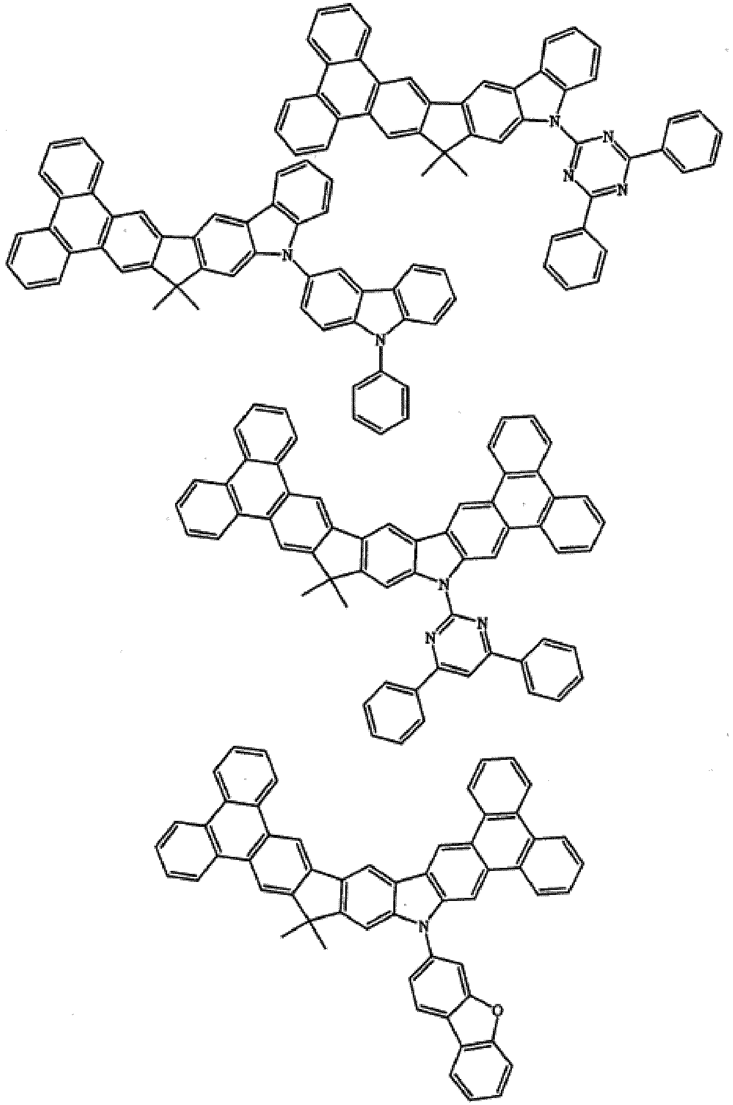

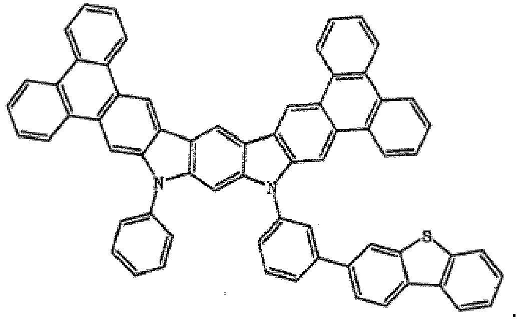

6. Organische Elektrolumineszenzvorrichtung, umfassend ein Paar Elektroden (6/13), das aus einer Kathode und einer Anode besteht, und zwischen dem Paar Elektroden umfassend wenigstens eine Schicht der Verbindung mit einer allgemeinen Formel (I) oder Formel (II) gemäß Anspruch 1.

7. Organische Elektrolumineszenzvorrichtung gemäß Anspruch 6, wobei die Schicht eine emittierende Schicht (9) ist, die die Verbindung mit einer allgemeinen Formel (I) oder Formel (II) umfasst.

8. Organische Elektrolumineszenzvorrichtung gemäß Anspruch 7, wobei die emittierende Schicht (9), die die Verbindung mit einer allgemeinen Formel (I) oder Formel (II) umfasst, ein phosphoreszierendes Wirtsmaterial oder ein thermisch aktiviertes verzögertes Fluoreszenzwirtsmaterial ist.

9. Organische Elektrolumineszenzvorrichtung gemäß Anspruch 7, wobei die emittierende Schicht (9) ein phosphoreszierendes Dotierungsmittel oder thermisch aktiviertes verzögertes Fluoreszenzdotierungsmittel umfasst.

10. Organische Elektrolumineszenzvorrichtung gemäß Anspruch 9, wobei es sich bei dem phosphoreszierenden Dotierungsmittel um Iridium(Ir)-Komplexe handelt.

11. Organische Elektrolumineszenzvorrichtung gemäß Anspruch 6, wobei die Schicht eine Lochblockierschicht (10) ist, die die Verbindung mit einer allgemeinen Formel (I) oder Formel (II) umfasst.

12. Organische Elektrolumineszenzvorrichtung gemäß Anspruch 6, wobei die Schicht eine lochblockierende Elektronentransportschicht (10') ist, die die Verbindung mit einer allgemeinen Formel (I) oder Formel (II) umfasst.

13. Organische Elektrolumineszenzvorrichtung gemäß Anspruch 6, wobei die Schicht eine emittierende Schicht (9) ist, die die folgende Verbindung umfasst:

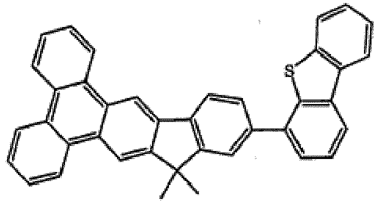

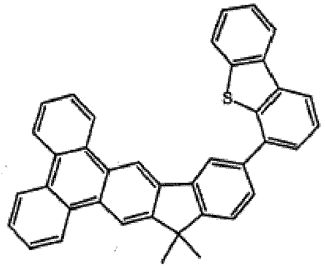

14. Organische Elektrolumineszenzvorrichtung gemäß Anspruch 6, wobei die Schicht eine Elektronentransportschicht (11) ist, die die folgende Verbindung umfasst:

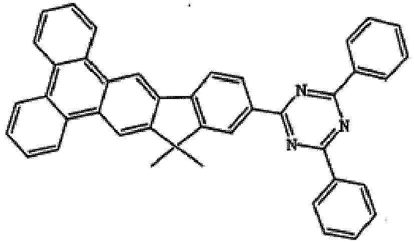

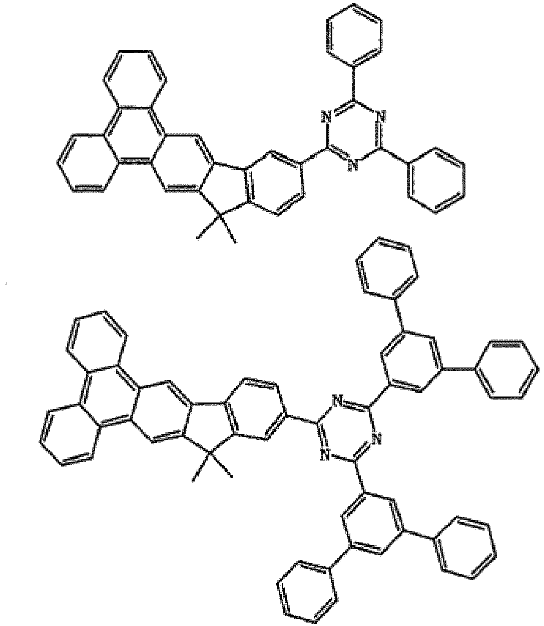

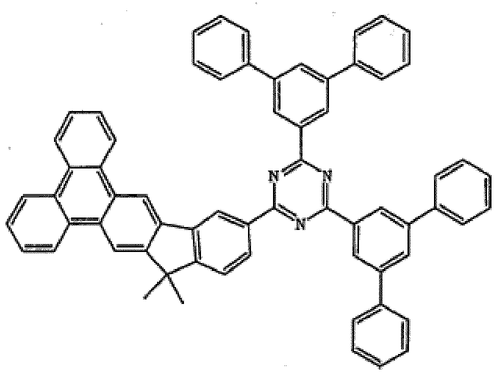

15. Organische Elektrolumineszenzvorrichtung gemäß Anspruch 14, wobei die Elektronentransportschicht (11) Lithium oder 8-Hydroxychinolatolithium umfasst.

## Revendications

1. Composé avec une formule (I) ou formule (II) générale comme suit : 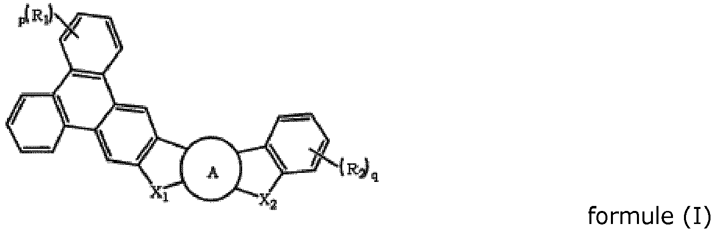 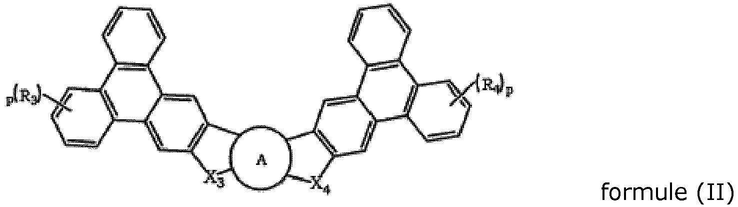 où A représente un groupe phényle substitué ou non substitué, un groupe naphtyle substitué ou non substitué, X₁ à X₄ représentent indépendamment un pont divalent choisi parmi l'atome ou le groupe consistant en O, S, C(R₅)(R₆), N(Ar), Si(R₇)(R₈), p représente un nombre entier de 0 à 10, q représente un nombre entier de 0 à 4, R₁ à R₈ et Ar sont indépendamment choisis dans le groupe consistant en un atome d'hydrogène, un groupe alkyle substitué ou non substitué ayant de 1 à 30 atomes de carbone, un groupe aryle substitué ou non substitué ayant de 6 à 50 atomes de carbone, un groupe aralkyle substitué ou non substitué ayant de 6 à 50 atomes de carbone, un groupe hétéroaryle substitué ou non substitué ayant de 3 à 50 atomes de carbone.

2. Composé selon la revendication 1, dans lequel le composé est représenté par la formule (I-1) à la formule (I-4) ou la formule (II-1) à la formule (II-4) suivantes : 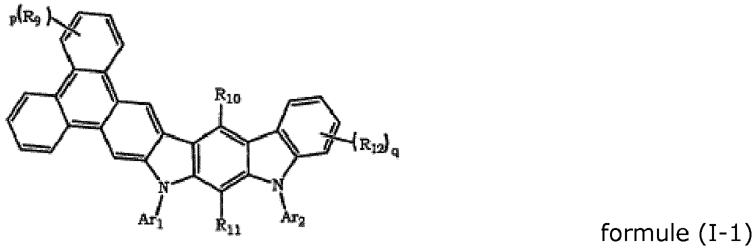 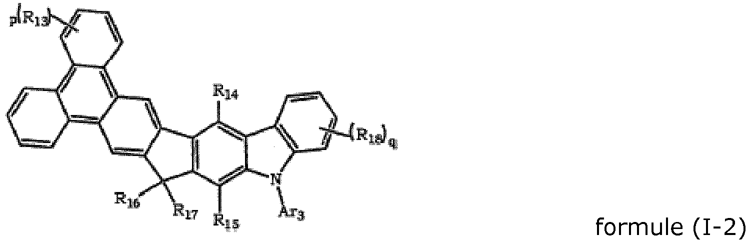 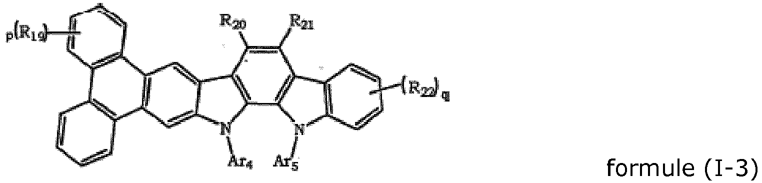 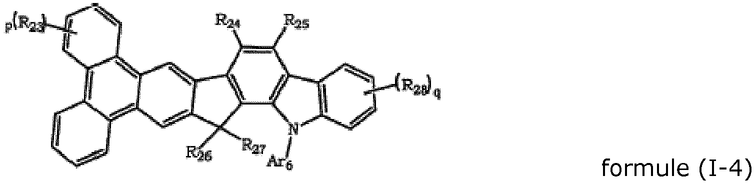 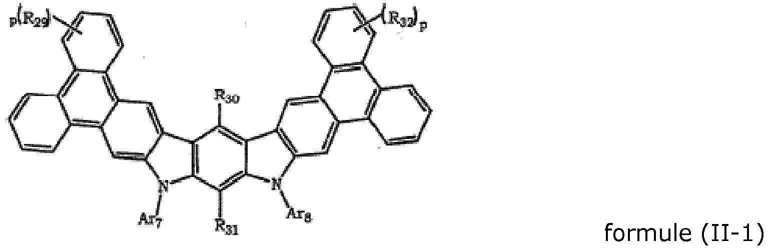 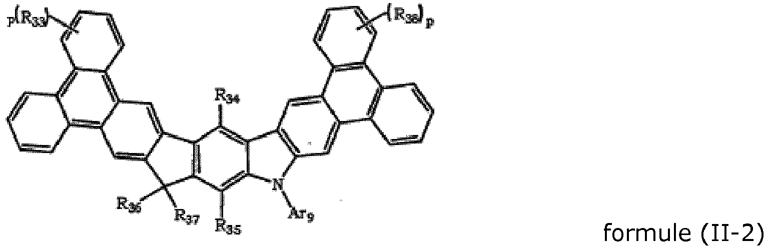 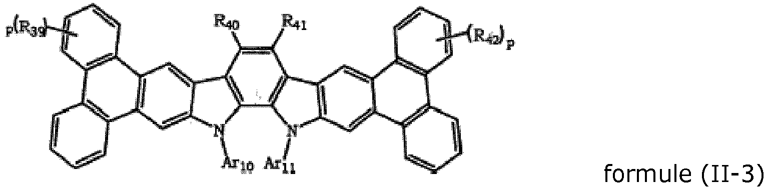 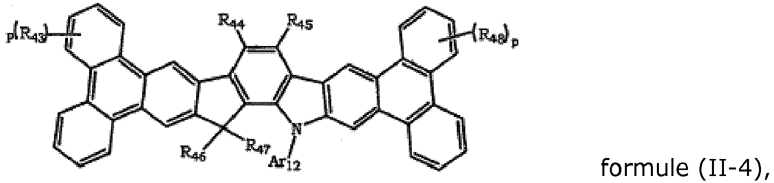 où R₉ à R₄₈ ont la même définition que R₁, et p et q ont la définition telle que décrite pour les formule (I) et formule (II) susmentionnées, Ar₁ à Ar₁₂ sont représentés par la formule (III) suivante : 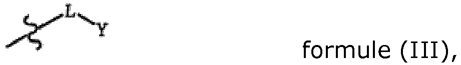 où L représente une liaison simple, un groupe arylène substitué ou non substitué ayant de 6 à 30 atomes de carbone, ou un groupe hétéroarylène substitué ou non substitué ayant de 3 à 30 atomes de carbone, Y représente un groupe phényle substitué ou non substitué, un groupe naphtyle substitué ou non substitué, un groupe biphényle substitué ou non substitué, un groupe carbazolyle substitué ou non substitué, un groupe biscarbazolyle substitué ou non substitué, un groupe dibenzofuranyle substitué ou non substitué, un groupe dibenzothiophényle substitué ou non substitué, un groupe triazinyle substitué ou non substitué, un groupe diazinyle substitué ou non substitué, un groupe phénanthronyle substitué ou non substitué, un groupe dihydroacridine substitué ou non substitué, un groupe phénothiazine substitué ou non substitué, un groupe phénoxazine substitué ou non substitué, un groupe dihydrophénazine substitué ou non substitué.

3. Composé selon la revendication 2, dans lequel L dans la formule (III) est choisi dans le groupe consistant en :

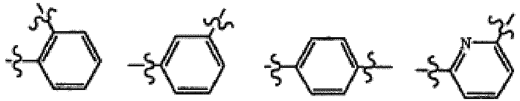

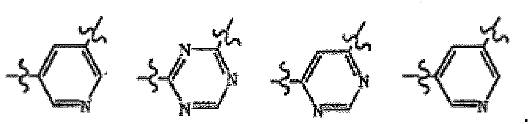

4. Composé selon la revendication 2, dans lequel Y dans la formule (III) est choisi dans le groupe consistant en :

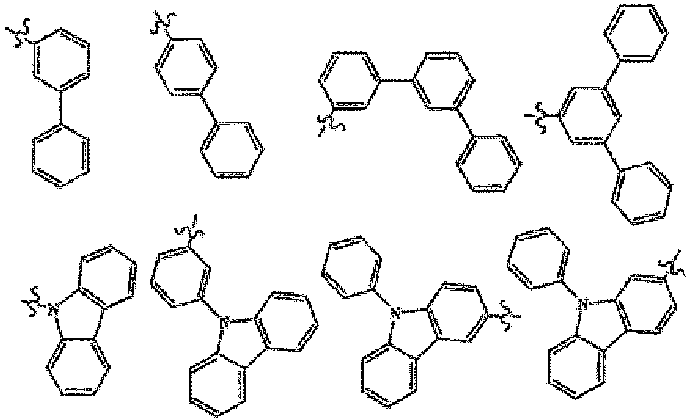

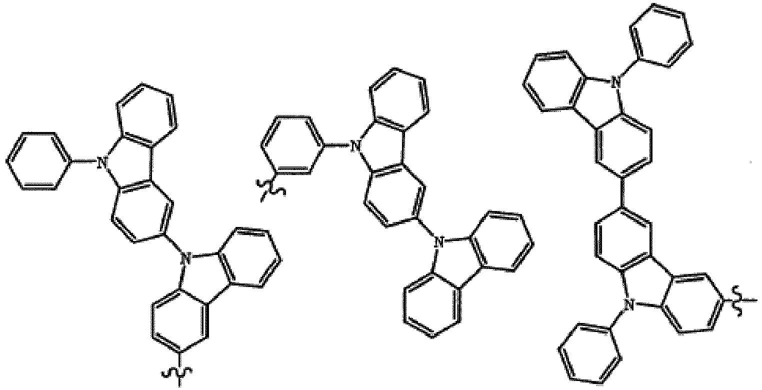

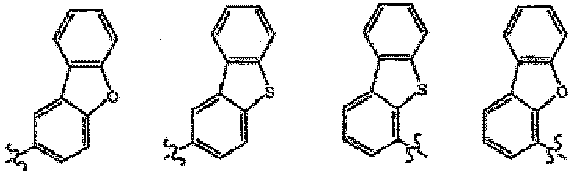

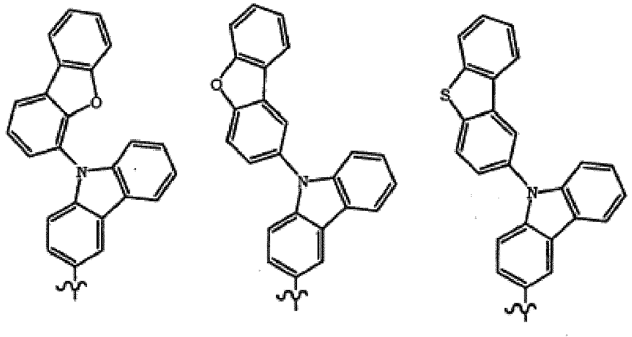

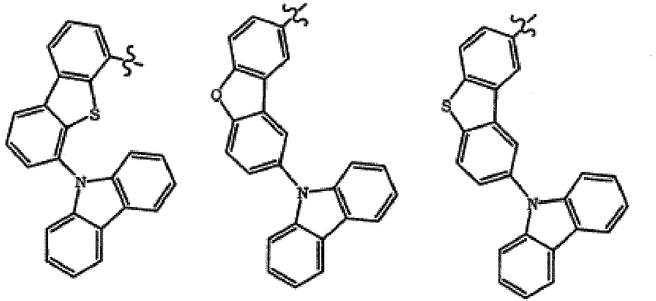

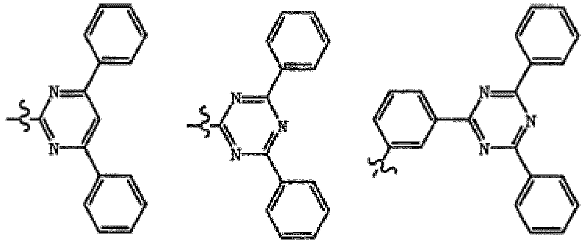

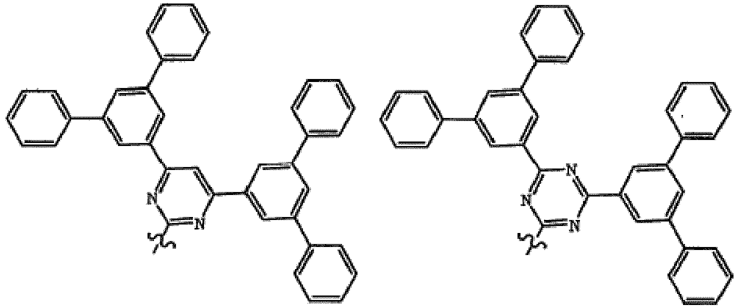

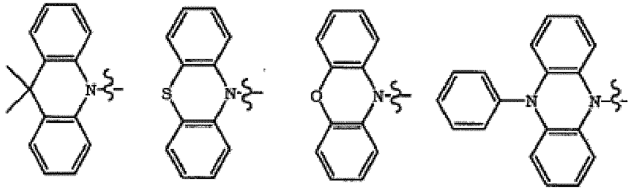

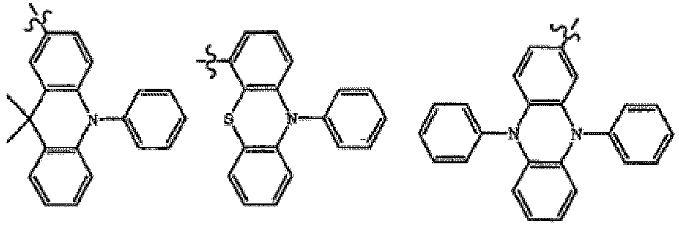

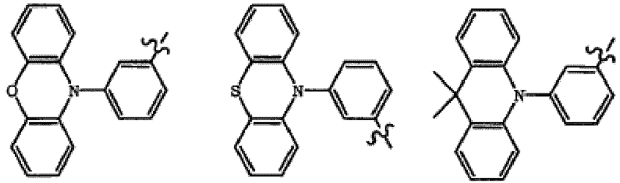

5. Composé selon la revendication 1, dans lequel le composé avec la formule (I) ou la formule (II) générale est :

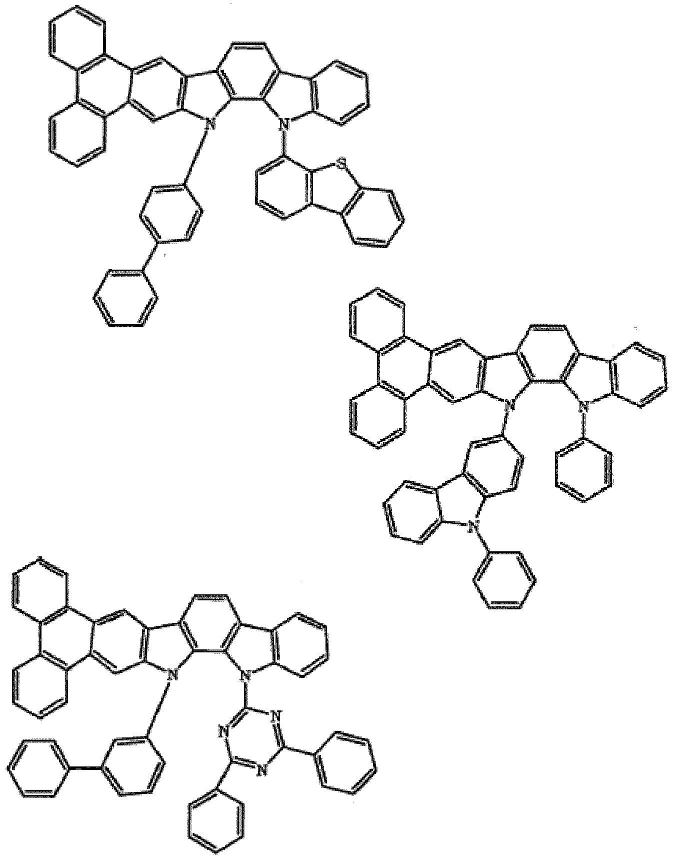

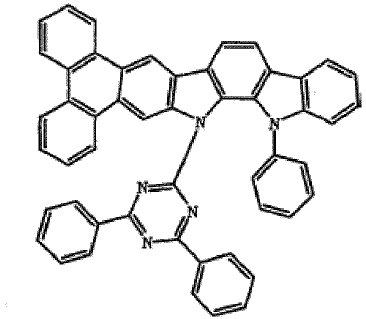

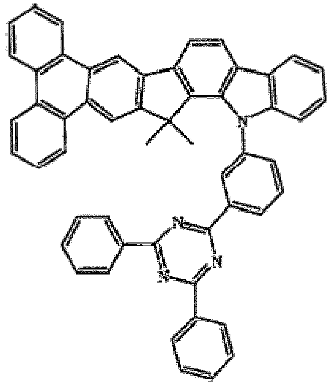

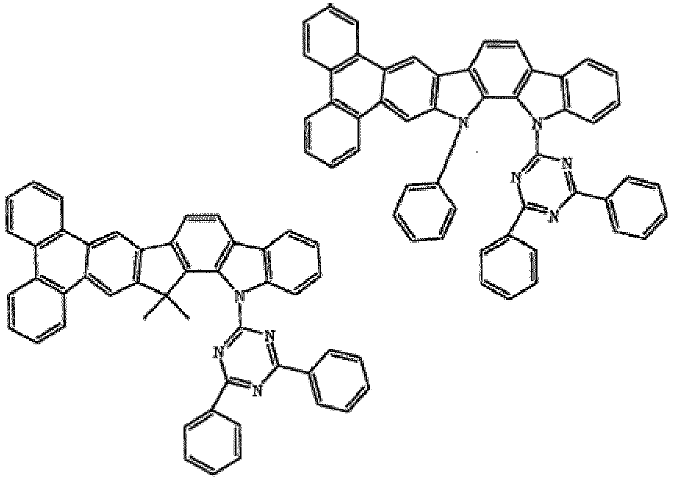

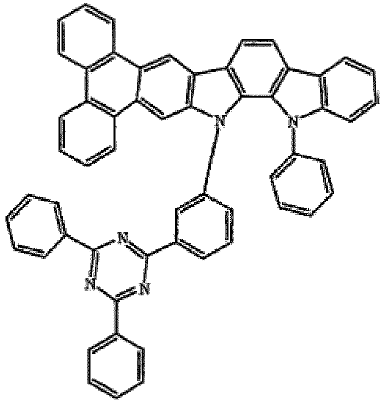

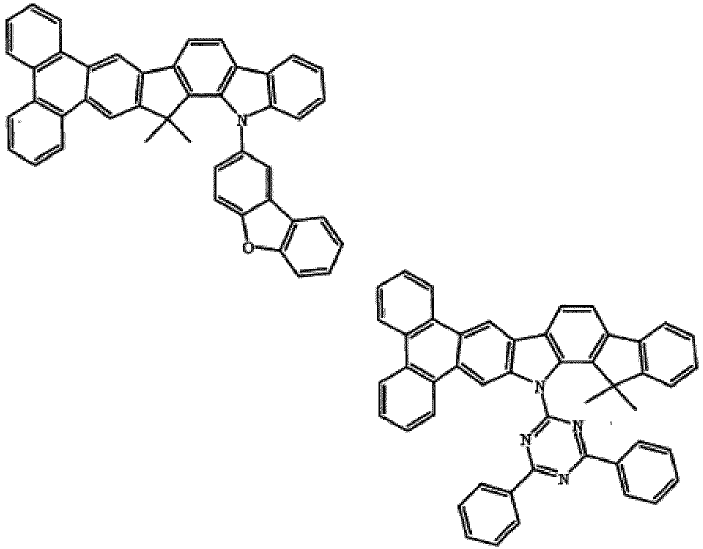

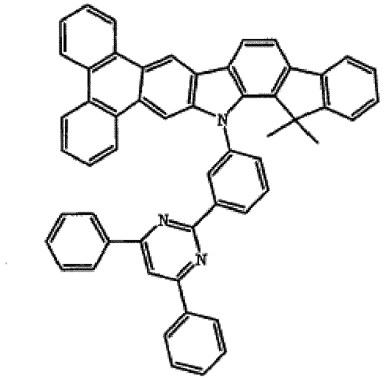

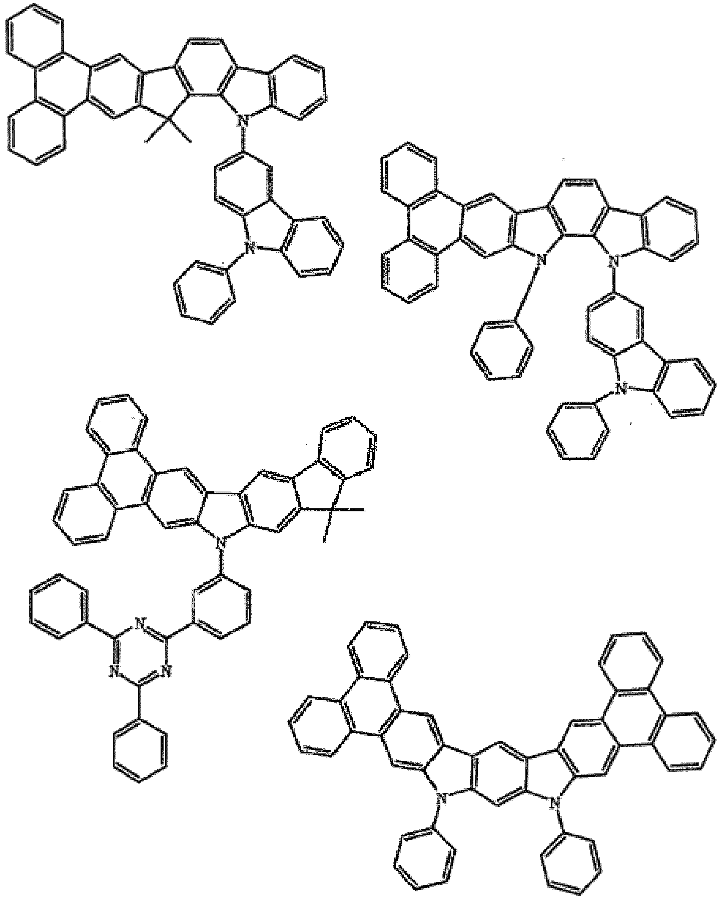

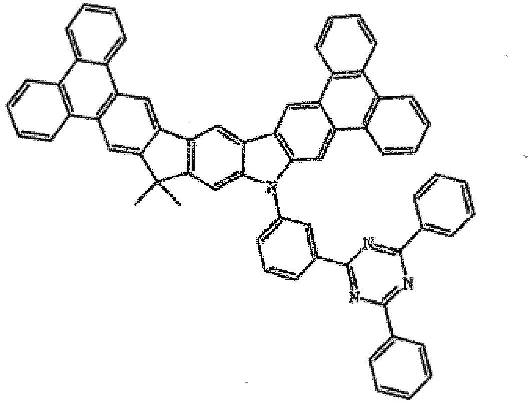

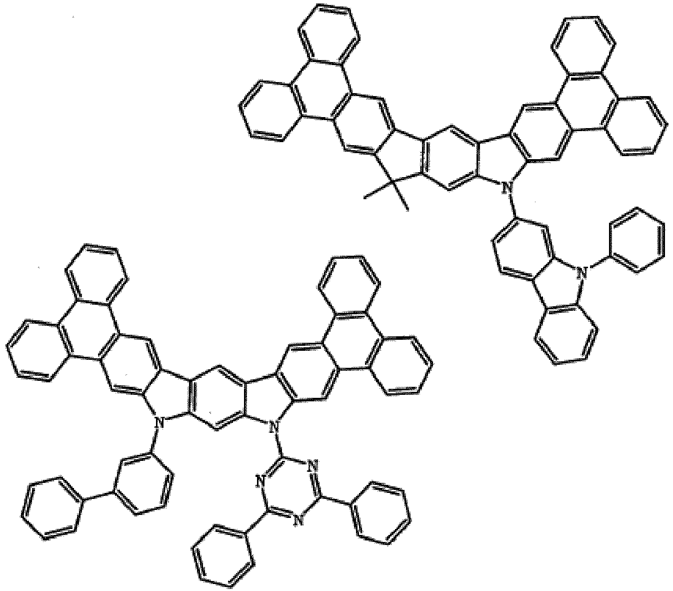

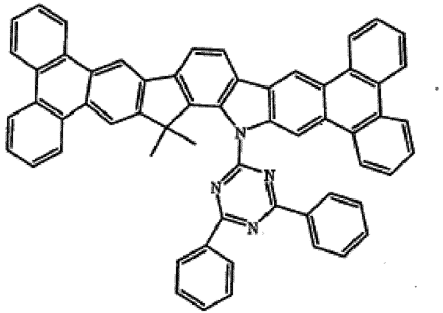

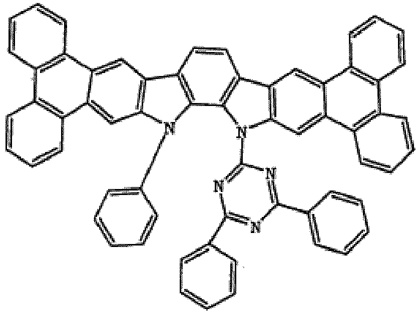

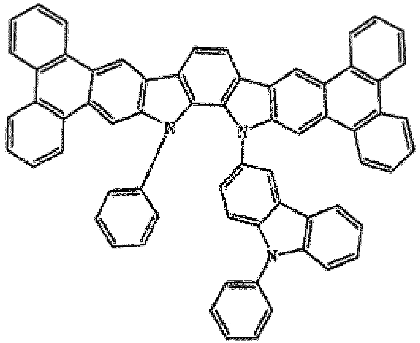

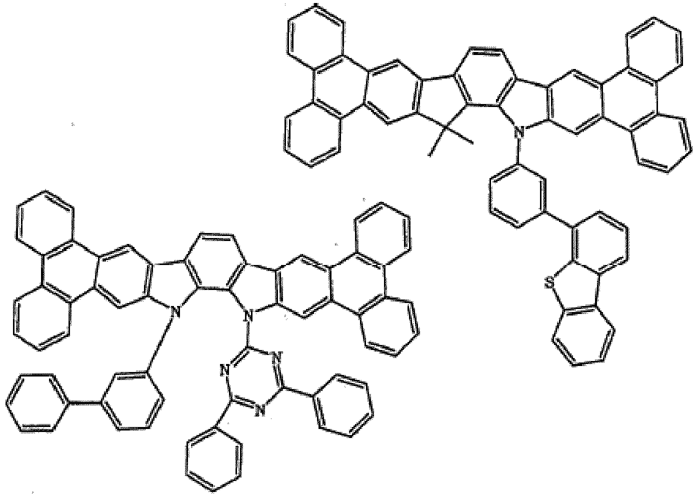

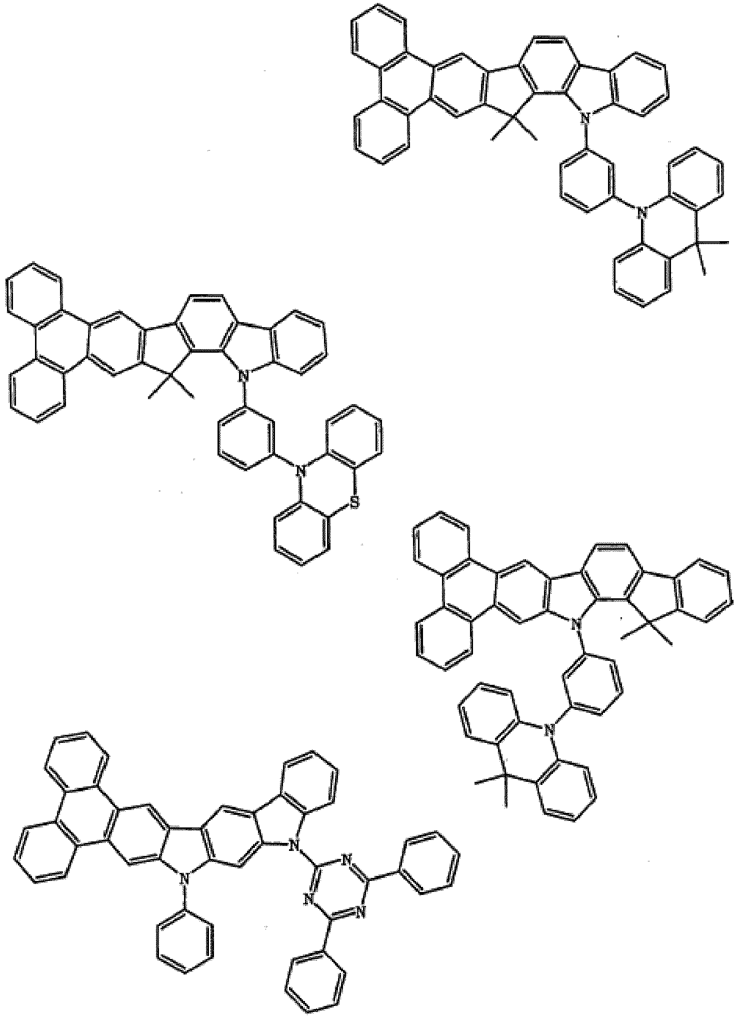

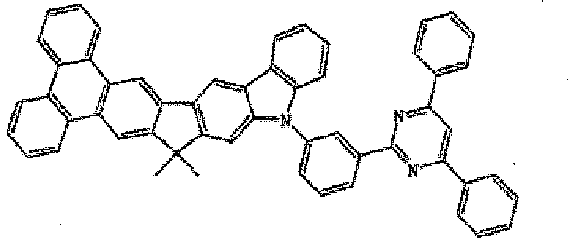

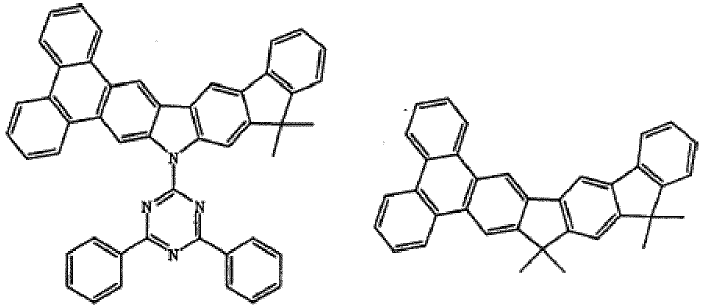

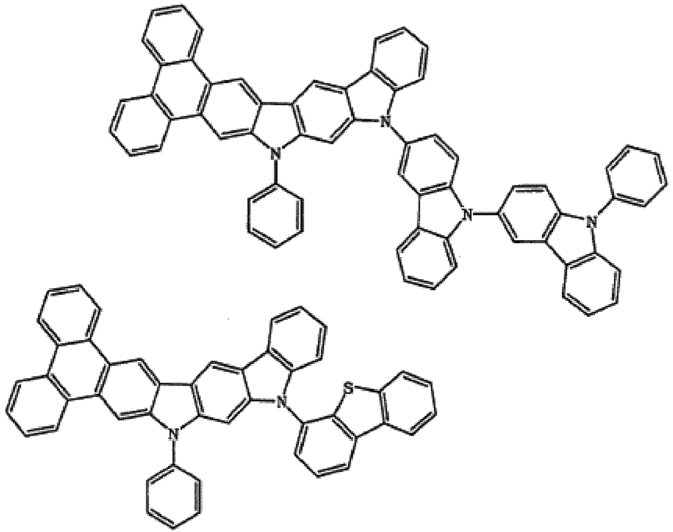

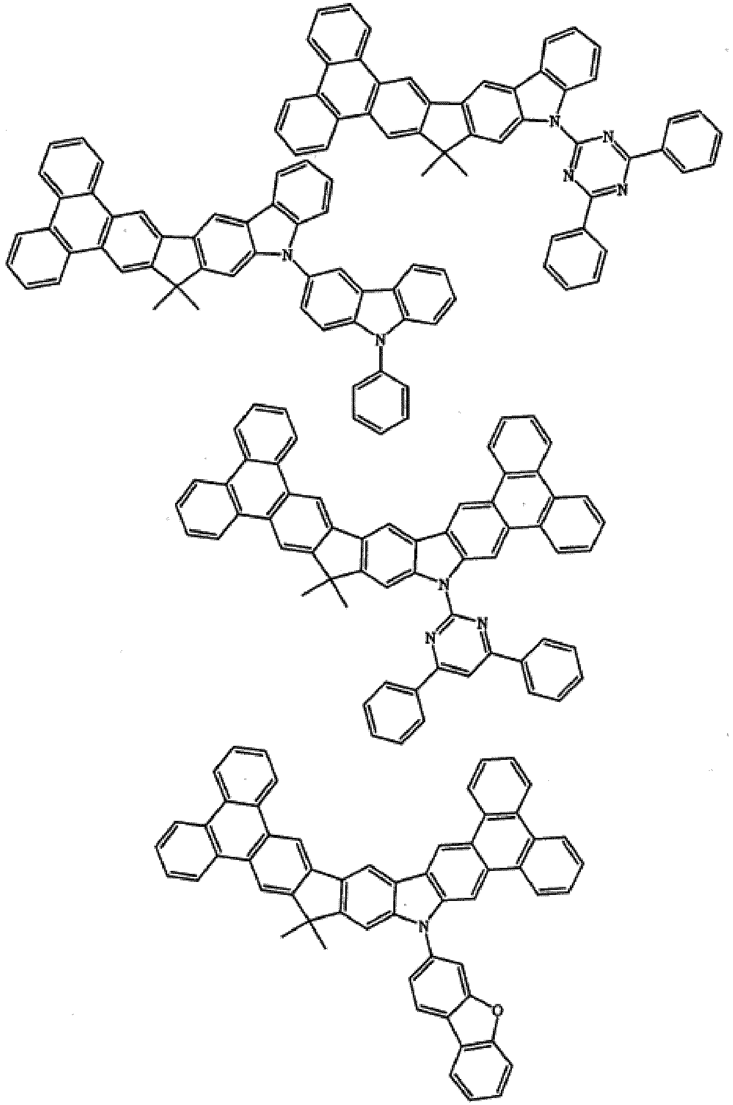

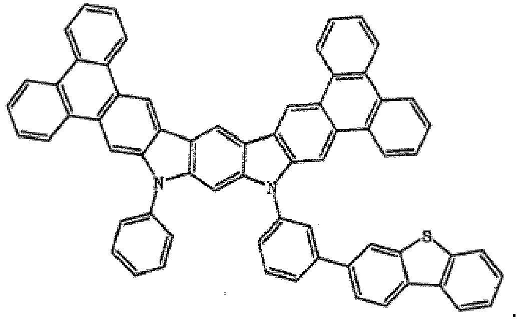

6. Dispositif électroluminescent organique comprenant une paire d'électrodes (6/13) consistant en une cathode et une anode et, entre la paire d'électrodes, comprenant au moins une couche du composé avec la formule (I) ou la formule (II) générale selon la revendication 1.

7. Dispositif électroluminescent organique selon la revendication 6, dans lequel la couche est une couche émettante (9) comprenant le composé avec la formule (I) ou la formule (II) générale.

8. Dispositif électroluminescent organique selon la revendication 7, dans lequel la couche émettante (9) comprenant le composé avec la formule (I) ou la formule (II) générale est un matériau hôte phosphorescent ou un matériau hôte de fluorescence retardée thermiquement activée.

9. Dispositif électroluminescent organique selon la revendication 7, dans lequel la couche émettante (9) comprend un dopant phosphorescent ou un dopant de fluorescence retardée thermiquement activée.

10. Dispositif électroluminescent organique selon la revendication 9, dans lequel le dopant phosphorescent est des complexes d'iridium (Ir).

11. Dispositif électroluminescent organique selon la revendication 6, dans lequel la couche est une couche de blocage de trous (10) comprenant le composé avec la formule (I) ou la formule (II) générale.

12. Dispositif électroluminescent organique selon la revendication 6, dans lequel la couche est une couche de transport d'électrons bloquante de trous (10') comprenant le composé avec la formule (I) ou la formule (II) générale.

13. Dispositif électroluminescent organique selon la revendication 6, dans lequel la couche est une couche émettante (9) comprenant le composé comme suit :

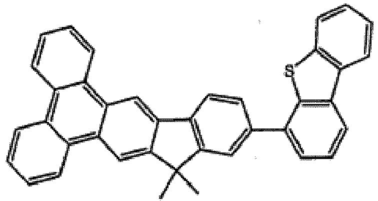

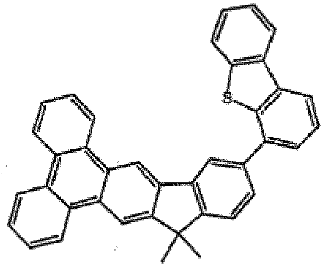

14. Dispositif électroluminescent organique selon la revendication 6, dans lequel la couche est une couche de transport d'électrons (11) comprenant des composés comme suit :

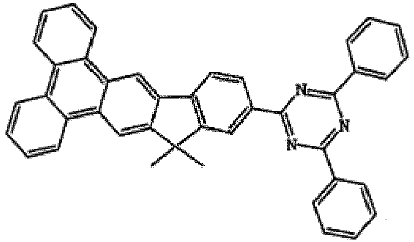

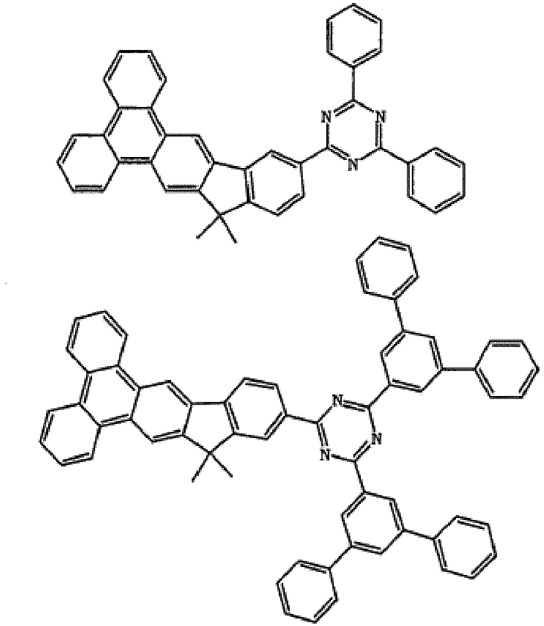

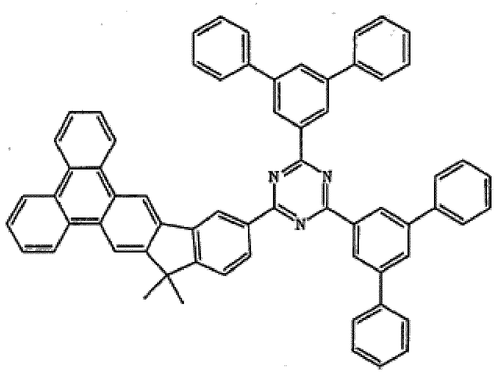

15. Dispositif électroluminescent organique selon la revendication 14, dans lequel la couche de transport d'électrons (11) comprend du lithium ou du 8-hydroxyquinolato lithium.
